# EUROPEAN PATENT APPLICATION

(11) **EP 4 654 774 A1**
(43) Date of publication of application: **26.11.2025**
(21) Application number: 25178532.5
(22) Date of filing: 23.05.2025
(51) Int. Cl.: H10B 12/00

(54) **SEMICONDUCTOR DEVICE AND METHOD FOR FABRICATING THE SAME**

(30) Priority: 23.05.2024 KR 20240067190; 07.05.2025 KR 20250058996
(71) Applicant: SK hynix Inc., Bubal-eub Icheon-si Gyeonggi-do 17336 (KR)
(72) Inventor: LEE, Ki Hong, 17336 Icheon-si, Gyeonggi-do (KR)
(74) Representative: Isarpatent

(57) **Abstract**

A semiconductor device includes vertical and horizontal arrangements of nano sheets including curved sheets, tapered sheets, and horizontal sheets extending in a first horizontal direction between the curved sheets and the tapered sheets; a vertical arrangement of first conductive lines surrounding the horizontal sheets of the nano sheets in the horizontal arrangement and extending in a second horizontal direction; a horizontal arrangement of second conductive lines which are coupled in common to the curved sheets of the nano sheets in the vertical arrangement, extend in a vertical direction, and are respectively coupled to the curved sheets of the nano sheets in the horizontal arrangement; data storage elements coupled to the tapered sheets of the nano sheets in the vertical and horizontal arrangements; and an inter-cell horizontal dielectric layer including horizontal segments disposed between the first conductive lines in the vertical arrangement and vertical segments disposed between the second conductive lines in the horizontal arrangement.

## Description

### BACKGROUND

### 1. Field

Various embodiments of the present disclosure relate to a semiconductor device, and more particularly, to a semiconductor device including three-dimensional (3D) memory cells, and a method for fabricating the semiconductor device.

### 2. Description of the Related Art

Recently, in order to cope with the large capacity and miniaturization of a memory device, a three-dimensional (3D) memory device in which a plurality of memory cells are stacked has been proposed.

### SUMMARY

Embodiments of the present disclosure are directed to a semiconductor device including high-integrated memory cells, and a method for fabricating the semiconductor device.

In accordance with an embodiment of the present disclosure, a semiconductor device may include a nano sheet including a first sheet region, a third sheet region, and a second sheet region extending horizontally between the first and third sheet regions, the first region having a curved profile; a first conductive line surrounding the second sheet region of the nano sheet; a second conductive line coupled to the first sheet region of the nano sheet; and a data storage element coupled to the third sheet region of the nano sheet.

In accordance with an embodiment of the present disclosure, a semiconductor device may include vertical and horizontal arrangements of nano sheets including curved sheets, tapered sheets, and horizontal sheets extending in a first horizontal direction between the curved sheets and the tapered sheets; a vertical arrangement of first conductive lines surrounding the horizontal sheets of the nano sheets in the horizontal arrangement and extending in a second horizontal direction; a horizontal arrangement of second conductive lines which are coupled in common to the curved sheets of the nano sheets in the vertical arrangement, extend in a vertical direction, and are respectively coupled to the curved sheets of the nano sheets in the horizontal arrangement; data storage elements coupled to the tapered sheets of the nano sheets in the vertical and horizontal arrangements; and an inter-cell horizontal dielectric layer including horizontal segments disposed between the first conductive lines in the vertical arrangement and vertical segments disposed between the second conductive lines in the horizontal arrangement.

In accordance with an embodiment of the present disclosure, a method for fabricating a semiconductor device may include forming a sheet stack including a body sheet, a horizontal sheet, which extends from the body sheet, and a curved sheet, which extends from the horizontal sheet, over a substrate; forming a nano sheet dielectric layer on the horizontal sheet and the curved sheet; forming a first spacer on the nano sheet dielectric layer; forming an inter-cell horizontal dielectric layer including horizontal segments and vertical segments on the first spacer; forming linear surrounding recesses by recessing the first spacer; forming first conductive lines that partially fill the linear surrounding recesses; forming a second spacer covering the horizontal segments and vertical segments of the inter-cell horizontal dielectric layer on side surfaces of the first conductive lines; and forming a second conductive line self-aligned with the second spacer and coupled to one side of the curved sheet.

In accordance with an embodiment of the present disclosure, a semiconductor device may include vertical and horizontal arrangements of nano sheets including curved sheets, horizontal sheets and tapered sheets, which are horizontally oriented; a vertical arrangement of first conductive lines surrounding the horizontal sheets of the nano sheets in the horizontal arrangement; a horizontal arrangement of second conductive lines coupled in common to the curved sheets of the nano sheets in the vertical arrangement and respectively coupled to the curved sheets of the nano sheets in the horizontal arrangement; data storage elements coupled to the tapered sheets of the nano sheets in the vertical and horizontal arrangements; an inter-cell horizontal dielectric layer including horizontal segments disposed between the first conductive lines in the vertical arrangement and vertical segments disposed between the second conductive lines in the horizontal arrangement; and an inter-cell dielectric layer having a frame structure, which provides a storage slot.

In accordance with an embodiment of the present disclosure, a semiconductor device may include vertical and horizontal arrangements of nano sheets, which include curved profiles and are oriented horizontally; a vertical arrangement of first conductive lines surrounding portions of the nano sheets in the horizontal arrangement; a horizontal arrangement of second conductive lines coupled in common to first edges of the nano sheets in the vertical arrangement and respectively coupled to first edges of the nano sheets in the horizontal arrangement; data storage elements coupled to second edges of the nano sheets of the vertical and horizontal arrangements; a first hybrid dielectric layer including horizontal segments disposed between the first conductive lines in the vertical arrangement and vertical segments disposed between the second conductive lines in the horizontal arrangement; and a second hybrid dielectric layer covering one side of the horizontal segments of the first hybrid dielectric layer and disposed between the vertical segments of the first hybrid dielectric layer and the second conductive lines.

In accordance with an embodiment of the present disclosure, a semiconductor device may include nano sheet transistors including nano sheets and word lines each having a gate-all-around structure of surrounding the nano sheets; a common vertical bit line coupled to first edges of the nano sheet transistors; and capacitors coupled to second edges of the nano sheet transistors, wherein the nano sheets include curved sheets including narrow side surfaces coupled to the common vertical bit line and curved side surfaces that are continuous from the narrow side surfaces; horizontal sheets extending horizontally from the curved sheets; and tapered sheets extending horizontally from the horizontal sheets and coupled to the capacitors.

In accordance with an embodiment of the present disclosure, a semiconductor device may include a nano sheet including a first sheet region having flat top and bottom surfaces and curved side surfaces, a third sheet region, and a second sheet region extending horizontally between the first sheet region and the third sheet region; a first conductive line surrounding the second sheet region of the nano sheet; a second conductive line coupled to the first sheet region of the nano sheet; and a data storage element coupled to the third sheet region of the nano sheet, wherein the second sheet region has a constant area cross-section, wherein the third sheet region has a variable area cross-section increasing gradually in a direction from an end of the second sheet region toward the data storage element, wherein the first sheet region has a narrow end side surface which is coupled to the second conductive line, and a wide end side integrally coupled to the second sheet region, and wherein the first, second, and third sheet regions form a single continuous integrated element.

### BRIEF DESCRIPTION OF THE DRAWINGS

FIG. 1A is a schematic perspective view illustrating a memory cell in accordance with an embodiment of the present disclosure.
FIG. 1B is a schematic cross-sectional view of the memory cell illustrated in FIG. 1A.
FIG. 1C is a schematic perspective view illustrating a nano sheet illustrated in FIG. 1A.
FIG. 2 is a schematic perspective view illustrating a semiconductor device in accordance with an embodiment of the present disclosure.
FIG. 3A is a schematic perspective view illustrating a semiconductor device in accordance with an embodiment of the present disclosure.
FIG. 3B is a plan view illustrating the semiconductor device illustrated in FIG. 3A.
FIG. 4A is a schematic cross-sectional view of the semiconductor device taken along line A-A' illustrated in FIG. 3B.
FIG. 4B is a schematic cross-sectional view of the semiconductor device taken along line B-B' illustrated in FIG. 3B.
FIG. 4C is a schematic cross-sectional view of the semiconductor device taken along line C-C' illustrated in FIG.3B.
FIG. 4D is a schematic cross-sectional view of the semiconductor device taken along line D-D' illustrated in FIG.3B.
FIG. 4E is a schematic cross-sectional view of the semiconductor device taken along line B1-B1' illustrated in FIG.3B.
FIGS. 5A to 28B illustrate various views of a semiconductor device formed utilizing a method for fabricating the semiconductor device in accordance with an embodiment of the present disclosure.
FIG. 29A is a schematic plan view illustrating a semiconductor device in accordance with an embodiment of the present disclosure.
FIG. 29B is a cross-sectional view of the semiconductor device taken along line A-A' illustrated in FIG. 29A.
FIG. 29C is a cross-sectional view of the semiconductor device taken along line B1-B1' illustrated in FIG. 29A.
FIG. 29D is a cross-sectional view of the semiconductor device taken along line D-D' illustrated in FIG. 29A.
FIGS. 30A to 33B illustrate various views of a semiconductor device formed utilizing a method for fabricating the semiconductor device in accordance with an embodiment of the present disclosure.
FIGS. 34A to 44B illustrate various plan views of a semiconductor device formed utilizing a method for fabricating the semiconductor device in accordance with an embodiment of the present disclosure.
FIG. 45A is a schematic plan view illustrating a semiconductor device in accordance with an embodiment of the present disclosure.
FIG. 45B is a cross-sectional view of the semiconductor device taken along line B1-B1' illustrated in FIG. 45A.
FIG. 45C is a cross-sectional view of the semiconductor device taken along line D-D' illustrated in FIG. 45A.
FIGS. 46 to 53 illustrate various plan views of a semiconductor device formed utilizing a method for fabricating the semiconductor device in accordance with embodiments of the present disclosure.
FIG. 54A is a schematic plan view illustrating a semiconductor device in accordance with an embodiment of the present disclosure.
FIG. 54B is a perspective view illustrating a first conductive line illustrated in FIG. 54A.
FIG. 54C is a cross-sectional view of a stack of first conductive lines illustrated in FIG. 54A.
FIG. 55A is a schematic plan view illustrating a semiconductor device in accordance with an embodiment of the present disclosure.
FIG. 55B is a detailed cross-sectional view of a curved sheet illustrated in FIG. 55A.
FIGS. 56A to 56C are various views illustrating a nano sheet in accordance with embodiments of the present disclosure.

### DETAILED DESCRIPTION

Various embodiments of the present disclosure described herein may be described with reference to cross-sectional views, plan views and block diagrams, which are ideal schematic views of a semiconductor device. It is noted that the structures of the drawings may be modified by fabricating techniques and/or tolerances. The embodiments of the present disclosure are not limited to the described embodiments and the specific structures illustrated in the drawings, but may include other embodiments, or modifications of the described embodiments including any changes in the structures that may be produced according to requirements of the fabricating process. Accordingly, the regions illustrated in the drawings have schematic attributes, and the shapes of the regions illustrated in the drawings are intended to illustrate specific structures of regions of the elements, and are not intended to limit the scope of this disclosure.

The following embodiment relates to three-dimensional memory cells, in which memory cells are vertically stacked to increase memory cell density and reduce parasitic capacitance.

The following embodiments disclose a three-dimensional nano sheet-based dynamic random access memory (DRAM).

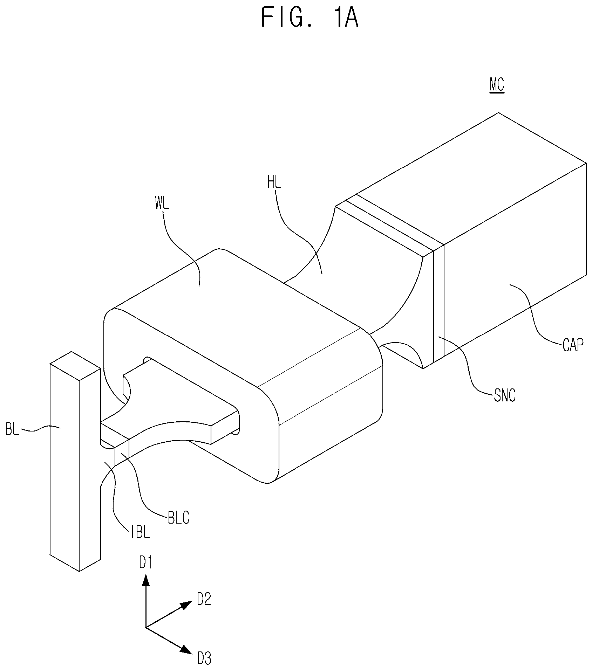

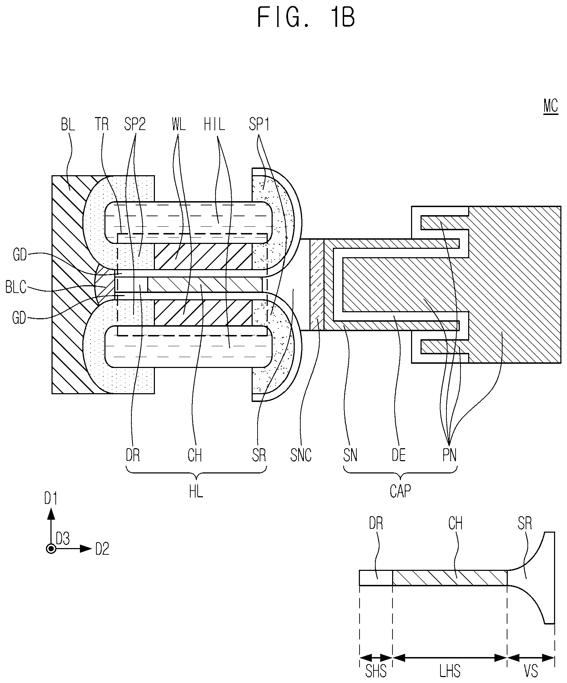

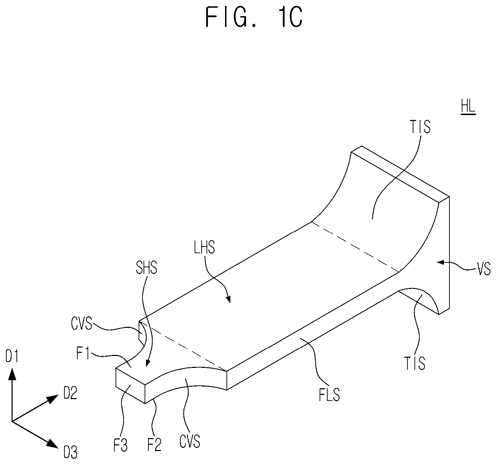

FIG. 1A is a schematic perspective view of a memory cell MC in accordance with an embodiment of the present disclosure. FIG. 1B is a schematic cross-sectional view of the memory cell MC illustrated in FIG. 1A. FIG. 1C is a schematic perspective view illustrating a nano sheet HL illustrated in FIG. 1A.

Referring to FIGS. 1A and 1B, the memory cell MC may include a switching element TR and a data storage element CAP.

The switching element TR has a function of controlling voltage or current supply to the data storage element CAP during a data write operation and/or a data read operation performed on the data storage element CAP. The switching element TR may include the nano sheet HL, a nano sheet dielectric layer GD, and a first conductive line WL. The first conductive line WL may include a horizontal conductive line or a horizontal word line. The nano sheet HL may include an active layer. The switching element TR may include a transistor, and in this case, the first conductive line WL may serve as a gate electrode. The switching element TR may also be referred to as a "nano sheet transistor", a "cell transistor", an "access element" or a "selection element". The first conductive line WL may be referred to as a "horizontal gate electrode" or a "horizontal word line".

The nano sheet HL may include a first doped region DR, a second doped region SR, and a channel CH disposed between the first doped region DR and the second doped region SR. The first doped region DR may be coupled to a second conductive line BL, for example, via a first contact node BLC. The second doped region SR may be coupled to the data storage element CAP, for example, via a second contact node SNC. The second conductive line BL may vertically extend in a first direction D1. The nano sheet HL may horizontally extend in a second direction D2 that intersects with the first direction D1. The first conductive line WL may horizontally extend in a third direction D3 that intersects with the first direction D1 and the second direction D2. The first direction D1 may be a vertical direction, the second direction D2 may be a first horizontal direction, and the third direction D3 may be a second horizontal direction. The first direction D1, the second direction D2, and the third direction D3 may be orthogonal to each other. The nano sheet HL may extend in the first horizontal direction, i.e., the second direction D2, and the first conductive line WL may extend in the second horizontal direction, i.e., the third direction D3. The nano sheet HL may be referred to as a "horizontal layer" or "nano ribbon".

The nano sheet HL may be horizontally oriented in the second direction D2 from the second conductive line BL. The first doped region DR, the channel CH and the second doped region SR may be horizontally formed in the second direction D2. A height of the second doped region SR in the first direction D1 may be greater than a height of the channel CH in the first direction D1. A length of the second doped region SR in the second direction D2 may be less than a length of the channel CH in the second direction D2. Lengths of the channel CH and the second doped region SR in the third direction D3 may be equal to each other. An average length of the first doped region DR in the third direction D3 may be less than the lengths of the channel CH and the second doped region SR in the third direction D3.

Referring to FIG. 1C, the nano sheet HL may include a first sheet region SHS, a second sheet region LHS, and a third sheet region VS, which are horizontally disposed in the second direction D2. The second sheet region LHS may be disposed between the first sheet region SHS and the third sheet region VS. The first sheet region SHS, the second sheet region LHS and the third sheet region VS may have an integral structure of being continuous in the second direction D2.

The third sheet region VS may have a thickness that gradually increases in the second direction D2 from the second sheet region LHS toward the data storage element CAP between the second sheet region LHS and the data storage element CAP. An average vertical height or thickness of the third sheet region VS in the first direction D1 may be greater than an average vertical height or thickness of the first sheet region SHS.

A horizontal length of the first sheet region SHS in the second direction D2 may be less than a horizontal length of the second sheet region LHS. An average horizontal length of the first sheet region SHS in the third direction D3 may be less than an average horizontal length of the second sheet region LHS. The first sheet region SHS may be referred to as a "short horizontal sheet", and the second sheet region LHS may be referred to as a "long horizontal sheet". Vertical heights of the first sheet region SHS and the second sheet region LHS in the first direction D1 may be equal to each other.

The first sheet region SHS may include a curved profile. The first sheet region SHS may include an upper surface F1 (also referred to as a top surface F1) and a lower surface F2 (also referred to as bottom surface F2), which face each other in the first direction D1 and extend in the second direction D2, a narrower side surface F3, which is disposed between the upper surface F1 and the lower surface F2 and is coupled to the second conductive line BL, and a pair of curved side surfaces CVS, which extend from the upper surface F1, the lower surface F2 and the narrower side surface F3 and face each other in the third direction D3. The pair of curved side surfaces CVS may be symmetrical to each other in the third direction D3. The curved side surfaces CVS may be referred to as "recessed side surfaces" or "rounded side surfaces". The first sheet region SHS may have a shape that protrudes from one side of the second sheet region LHS. The curved side surfaces CVS may have at least one curvature.

The curved side surfaces CVS may each have an upward curved slope that increases a horizontal length of the first sheet region SHS in the third direction D3 from the narrower side surface F3 toward the second sheet region LHS. The upper surface F1 and the lower surface F2 of the first sheet region SHS may have flat surfaces. A surface area of the narrower side surface F3 may be less than surface areas of the curved side surfaces CVS.

In some embodiments, the upper surface F1 and the lower surface F2 of the first sheet region SHS may each have a downward curved slope that decreases a vertical thickness of the first sheet region SHS in the first direction D1 from the narrower side surface F3 toward the second sheet region LHS.

The second sheet region LHS may include flat side surfaces FLS. The flat side surfaces FLS of the second sheet region LHS may be continuous from the curved side surfaces CVS of the first sheet region SHS. An upper surface of the second sheet region LHS may be parallel to a lower surface of the second sheet region LHS. For example, a cross section of the second sheet region LHS may have a flat-plate shape.

Upper and lower surfaces of the third sheet region VS may have tapered profiles. For example, a cross-section of the third sheet region VS may have a fan-like shape. The third sheet region VS may have a thickness that gradually increases in the second direction D2. The upper and lower surfaces of the third sheet region VS may have the tapered profiles that increase a vertical thickness of the third sheet region VS in the first direction D1 from the second sheet region LHS toward the data storage element CAP. The vertical thickness may increase gradually. At an interface between the second sheet region LHS and the third sheet region VS a thickness of the second sheet region in the first direction D1 may be the same as the thickness of the third sheet region VS in the first direction D1. Also, at an interface between the first sheet region SHS and the second sheet region LHS a thickness of the first region SHS in the first direction D1 may be the same as a thickness of the second region LHS in the first direction D1.

The first and second sheet regions SHS and LHS may be referred to as "horizontal sheets" that horizontally extend in the second direction D2. The third sheet region VS may be referred to as a "tapered sheet".

In some embodiments, the first and second sheet regions SHS and LHS may be referred to as "flat plate-shaped sheets", and the third sheet region VS may be referred to as a "fan-like shaped sheet". The upper and lower surfaces of the third sheet region VS may include tapered inside surfaces TIS. An outside surface of the third sheet region VS that contacts the data storage element CAP may have a flat side shape.

In some embodiments, the nano sheet HL may include a curved sheet, a horizontal sheet, and a tapered sheet. The horizontal sheet of the nano sheet HL may refer to the second sheet region LHS, the curved sheet of the nano sheet HL may refer to the first sheet region SHS, and the tapered sheet of the nano sheet HL may refer to the third sheet region VS. The horizontal sheet may include the flat side surfaces FLS. The curved sheet may include the curved side surfaces CVS.

In another embodiment, the nano sheet HL may include a horizontal sheet and a tapered sheet, and the horizontal sheet may include a short horizontal sheet and a long horizontal sheet. The horizontal sheet of the nano sheet HL may include the flat side surfaces FLS and the curved side surfaces CVS.

Referring to FIGS. 1B and 1C, the first doped region DR may be disposed in the first sheet region SHS, the channel CH may be disposed in the second sheet region LHS, and the second doped region SR may be disposed in the third sheet region VS. The channel CH may be referred to as a "narrow channel" or a "flat channel". In some embodiments, a portion of the second doped region SR may extend to be disposed in the second sheet region LHS. The second doped region SR may include a thick portion (also referred to as a thicker portion) disposed in the third sheet region VS and a thin portion (also referred to as a thinner portion) disposed in the second sheet region LHS.

The nano sheet HL may include a semiconductive material. For example, the nano sheet HL may include polysilicon, monocrystalline silicon, germanium, or silicon-germanium. In some embodiments, the nano sheet HL may include an oxide semiconductor material. For example, the oxide semiconductor material may include indium gallium zinc oxide (IGZO), indium tin zinc oxide (InSnZnO), zinc tin oxide (ZnSnO), or a combination thereof. In some embodiments, the nano sheet HL may include a conductive metal oxide. In some embodiments, the nano sheet HL may include a two-dimensional material, for example, molybdenum disulfide (MoS₂), tungsten disulfide (WS₂), or molybdenum selenide (MoSe₂).

When the nano sheet HL is formed of the oxide semiconductor material, the channel CH may also be formed of the oxide semiconductor material, and the first and second doped regions DR and SR may be omitted. The nano sheet HL may also be referred to as an "active layer" or a "thin body".

The channel CH may be undoped. The first and second doped regions DR and SR may be doped with the same conductivity type of an impurity. Each of the first and second doped regions DR and SR may be doped with an N-type conductive impurity or a P-type conductive impurity. Each of the first and second doped regions DR and SR may include at least one impurity selected from among arsenic (As), phosphorus (P), boron (B), indium (In), and combinations thereof. The first doped region DR may be coupled to the second conductive line BL, and the second doped region SR may be coupled to the data storage element CAP. One of the first and second doped regions DR and SR may be a drain region, and the other may be a source region.

The first conductive line WL may have a gate-all-around (GAA) structure. For example, the first conductive line WL may surround a portion of the nano sheet HL and extend in the third direction D3. The nano sheet dielectric layer GD may be formed between the nano sheet HL and the first conductive line WL. The nano sheet dielectric layer GD may surround all surfaces of the channel CH of the nano sheet HL. The first conductive line WL may surround the channel CH of the nano sheet HL on the nano sheet dielectric layer GD. That is, the nano sheet dielectric layer GD may be disposed between the nano sheet HL and the first conductive line WL.

The first conductive line WL may include a metal-based material, a semiconductive material, or a combination thereof. The first conductive line WL may include molybdenum, molybdenum nitride, ruthenium, titanium nitride, tungsten, polysilicon, or a combination thereof. For example, the first conductive line WL may include a TiN/W stack in which titanium nitride and tungsten are sequentially stacked. The first conductive line WL may include an N-type work function material or a P-type work function material. The N-type work function material may have a low work function of approximately 4.5 eV or less, and the P-type work function material may have a high work function of approximately 4.5 eV or greater. The first conductive line WL may include a stack of a low work function material and a high work function material.

The nano sheet dielectric layer GD may be disposed between the nano sheet HL and the first conductive line WL. The nano sheet dielectric layer GD may be referred to as a "gate dielectric layer" or a "channel-side dielectric layer". The nano sheet dielectric layer GD may include silicon oxide, silicon nitride, metal oxide, metal oxynitride, metal silicate, a high-k material, a ferroelectric material, an anti-ferroelectric material, or a combination thereof. The nano sheet dielectric layer GD may include SiO₂, Si₃N₄, HfO₂, Al₂O₃, ZrO₂, AlON, HfON, HfSiO, HfSiON, HfZrO, or a combination thereof. The nano sheet dielectric layer GD may be formed by thermal oxidation of the nano sheet HL. In some embodiments, forming the nano sheet dielectric layer GD may include depositing a nano sheet dielectric material on the nano sheet HL and oxidizing the surfaces of the nano sheet HL.

The second conductive line BL may be vertically oriented in the first direction D1. The second conductive line BL may include a bit line. The second conductive line BL may be referred to as a "vertical conductive line", a "vertically-oriented bit line", a "vertically-extending bit line", or a "pillar-shaped bit line". The second conductive line BL may include a conductive material. The second conductive line BL may include a silicon-based material, a metal-based material, or a combination thereof. The second conductive line BL may include polysilicon, metal, metal nitride, metal silicide, or a combination thereof. The second conductive line BL may include polysilicon, titanium nitride, tungsten, or a combination thereof. For example, the second conductive line BL may include a titanium nitride/tungsten (TiN/W) stack in which titanium nitride and tungsten are sequentially stacked. The second conductive line BL may be electrically coupled to the first doped region DR of the nano sheet HL.

The data storage element CAP may include a memory element such as a capacitor. The data storage element CAP may be horizontally disposed in the second direction D2 from the switching element TR. The data storage element CAP may be electrically coupled to the second doped region SR of the nano sheet HL. A second contact node SNC may be interposed between the capacitor CAP and the second doped region SR of the transistor element TR.

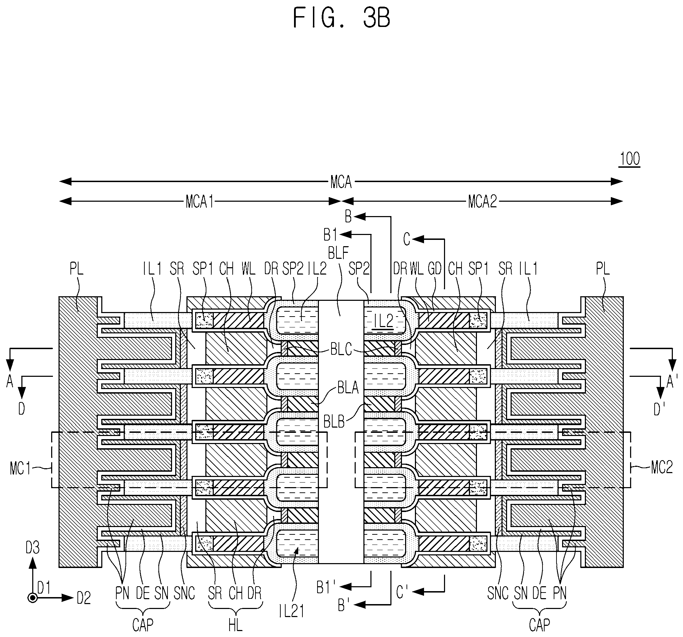

Referring to FIG. 3B, the data storage element CAP may include a first electrode SN, a second electrode PN over the first electrode SN, and a dielectric layer DE disposed between the first electrode SN and the second electrode PN. The first electrode SN may horizontally extend in the second direction D2 from the nano sheet HL. The first electrode SN, the dielectric layer DE and the second electrode PN may be horizontally disposed in the second direction D2. The first electrode SN may include an inner space and a plurality of outer surfaces, and the inner space of the first electrode SN may include a plurality of inner surfaces. The outer surfaces of the first electrode SN may include a vertical outer surface and a plurality of horizontal outer surfaces. The vertical outer surface of the first electrode SN may vertically extend in the first direction D1, and the horizontal outer surfaces of the first electrode SN may horizontally extend in the second direction D2 or the third direction D3. The inner space of the first electrode SN may be a three-dimensional space. The dielectric layer DE may conformally cover the inner surfaces of the first electrode SN. The second electrode PN may be disposed in the inner space of the first electrode SN on the dielectric layer DE. Some of the outer surfaces of the first electrode SN may be electrically coupled to the second doped region SR of the nano sheet HL. The second electrode PN of the data storage element CAP may be coupled to a common plate PL.

The data storage element CAP may have a three-dimensional structure. The first electrode SN may have a three-dimensional structure, which may have a horizontal three-dimensional structure that is oriented in the second direction D2. In an example of the three-dimensional structure, the first electrode SN may have a cylindrical shape. The cylindrical shape of the first electrode SN may include cylindrical inner surfaces and cylindrical outer surfaces. Some of the cylindrical outer surfaces of the first electrode SN may be electrically coupled to the second doped region SR of the nano sheet HL. The dielectric layer DE and the second electrode PN may be disposed on the cylindrical inner surfaces and cylindrical outer surfaces of the first electrode SN. The first electrode SN may include a metallic cylinder.

In some embodiments, the first electrode SN may have a pillar shape or a pylinder shape. The pylinder shape may refer to a structure in which a pillar shape and a cylindrical shape are merged.

The first electrode SN and the second electrode PN may include metal, noble metal, metal nitride, conductive metal oxide, conductive noble metal oxide, metal carbide, metal silicide, or a combination thereof. For example, the first electrode SN and the second electrode PN may each include titanium (Ti), titanium nitride (TiN), titanium silicon nitride (TiSiN), tantalum (Ta), tantalum nitride (TaN), tungsten (W), tungsten nitride (WN), ruthenium (Ru), ruthenium oxide (RuO₂), iridium (Ir), iridium oxide (IrO₂), platinum (Pt), molybdenum (Mo), molybdenum oxide (MoO), a titanium nitride/tungsten (TiN/W) stack, a tungsten nitride/tungsten (WN/W) stack, a titanium silicon nitride/titanium nitride (TiSiN/TiN) stack, a titanium silicon nitride/titanium nitride/tungsten (TiSiN/TiN/W) stack, or a combination thereof. The second electrode PN may also include a combination of a metal-based material and a silicon-based material.

The dielectric layer DE may be referred to as a "capacitor dielectric layer" or a "memory layer". The dielectric layer DE may include silicon oxide, silicon nitride, a high-k material, a perovskite material, or a combination thereof. The high-k material may include hafnium oxide (HfO₂), zirconium oxide (ZrO₂), aluminum oxide (Al₂O₃), lanthanum oxide (La₂O₃), titanium oxide (TiO₂), tantalum oxide (Ta₂O₅), niobium oxide (Nb₂O₅), strontium titanium oxide (SrTiO₃), or a combination thereof. In some embodiments, the dielectric layer DE may be formed of a composite layer including two or more layers of the above-described high-k material.

The dielectric layer DE may be formed of zirconium (Zr)-based oxide. The dielectric layer DE may have a stack structure containing zirconium oxide (ZrO₂). The dielectric layer DE may include a ZA (ZrO_{2/}Al₂O₃) stack or a ZAZ (ZrO₂/Al₂O₃/ZrO₂) stack. The ZA stack may have a structure in which aluminum oxide (Al₂O₃) is stacked on zirconium oxide (ZrO₂). The ZAZ stack may have a structure in which zirconium oxide (ZrO₂), aluminum oxide (Al₂O₃) and zirconium oxide (ZrO₂) are sequentially stacked. Each of the ZA stack and the ZAZ stack may be referred to as a "zirconium oxide (ZrO₂)-based layer". In some embodiments, the dielectric layer DE may be formed of hafnium (Hf)-based oxide.

The dielectric layer DE may have a stack structure containing hafnium oxide (HfO₂). The dielectric layer DE may include an HA (HfO₂/Al₂O₃) stack or an HAH (HfO₂/Al₂O₃/HfO₂) stack. The HA stack may have a structure in which aluminum oxide (Al₂O₃) is stacked on hafnium oxide (HfO₂). The HAH stack may have a structure in which hafnium oxide (HfO₂), aluminum oxide (Al₂O₃) and hafnium oxide (HfO₂) are sequentially stacked. Each of the HA stack and the HAH stack may be referred to as a "hafnium oxide (HfO₂)-based layer".

In the ZA stack, ZAZ stack, HA stack and HAH stack, aluminum oxide (Al₂O₃) may have a greater band gap energy than zirconium oxide (ZrO₂) and hafnium oxide (HfO₂). Aluminum oxide (Al₂O₃) may have a lower dielectric constant than zirconium oxide (ZrO₂) and hafnium oxide (HfO₂). Accordingly, the dielectric layer DE may include a stack of a high-k material and a high band gap material having a greater band gap energy than the high-k material. The dielectric layer DE may include silicon oxide (SiO₂) as a high band gap material other than aluminum oxide (Al₂O₃). Because the dielectric layer DE includes a high band gap material, leakage current may be suppressed. The high band gap material may be thinner than the high-k material.

In some embodiments, the dielectric layer DE may include a stack structure in which a high-k material and a high band gap material are alternately stacked. For example, the dielectric layer DE may include a ZAZA (ZrO₂/Al₂O₃/ZrO₂/Al₂O₃) stack, a ZAZAZ (ZrO₂/Al₂O₃/ZrO₂/Al₂O₃/ZrO₂) stack, an HAHA (HfO₂/Al₂O₃/HfO₂/Al₂O₃) stack, an HAHAH (HfO₂/Al₂O₃/HfO₂/Al₂O₃/HfO₂) stack, an HZAZH (HfO₂/ZrO₂/Al₂O₃/ZrO₂/HfO₂) stack, a ZHZAZHZ (ZrO₂/HfO₂/ZrO₂/Al₂O₃/ZrO₂/HfO₂/ZrO₂) stack, an HZHZ (HfO₂/ZrO₂/HfO₂/ZrO₂) stack, an AHZAZHA (Al₂O₃/HfO₂/ZrO₂/Al₂O₃/ZrO₂/HfO₂/Al₂O₃) stack, or a ZHZAZHZAT (ZrO₂/HfO₂/ZrO₂/Al₂O₃/ZrO₂/HfO₂/ZrO₂/Al₂O₃/TiO₂) stack. In the above-described stack structures, an aluminum oxide layer (Al₂O₃) may be thinner than each of a zirconium oxide (ZrO₂) and a hafnium oxide (HfO₂).

In some embodiments, the dielectric layer DE may include a high-k material and a high band gap material. The dielectric layer DE may have a laminated structure in which a plurality of high-k materials and a plurality of high band gap materials are stacked or an intermixed structure in which a high-k material and a high band gap material are intermixed.

In some embodiments, the dielectric layer DE may include a ferroelectric material, an anti-ferroelectric material, or a combination thereof. For example, the dielectric layer DE may include HfZrO.

In some embodiments, the dielectric layer DE may include a combination of a high-k material and a ferroelectric material, a combination of a high-k material and an anti-ferroelectric material, or a combination of a high-k material or a ferroelectric material and an anti-ferroelectric material.

In some embodiments, the data storage element CAP may further include a plurality of interface control layers to alleviate leakage current. The interface control layers may each include titanium oxide (TiO₂), tantalum oxide (Ta₂O₅), niobium oxide (Nb₂O₅), niobium nitride (NbN), niobium oxynitride (NbON), or a combination thereof. The data storage element CAP may include a first interface control layer, a second interface control layer, or a combination thereof. The first interface control layer and the second interface control layer may be conductive or dielectric. The first interface control layer may be formed between the first electrode SN and the dielectric layer DE, and the second interface control layer may be formed between the dielectric layer DE and the second electrode PN. The first interface control layer and the second interface control layer may be the same material or different materials. For example, a structure of the data storage element CAP in which the first interface control layer, the dielectric layer DE and the second interface control layer are sequentially stacked may include an NZHZAZHZATN (Nb₂O₅/ZrO₂/HfO₂/ZrO₂/Al₂O₃/ZrO₂/HfO₂/ZrO₂/Al₂O₃/TiO₂/Nb₂O₅) stack.

The data storage element CAP may include a three-dimensional capacitor. The data storage element CAP may include a Metal-Insulator-Metal (MIM) capacitor. The data storage element CAP may be replaced with another data storage material. For example, the data storage material may be a thyristor, a phase-change material, a Magnetic Tunnel Junction (MTJ), or a variable resistance material.

The memory cell MC may further include first and second contact nodes BLC and SNC. The first contact node BLC may be disposed between the first doped region DR of the nano sheet HL and the second conductive line BL. The first contact node BLC may include metal, a metal-based material, or a semiconductive material. For example, the first contact node BLC may include titanium, titanium nitride, tungsten, or a combination thereof. In addition, the first contact node BLC may include doped polysilicon, and the first doped region DR may include an impurity diffused from the first contact node BLC. The second contact node SNC may be disposed between the second doped region SR of the nano sheet HL and the first electrode SN of the data storage element CAP. The second contact node SNC may include a metal-based material or a semiconductive material. For example, the second contact node SNC may include titanium, titanium nitride, tungsten, or a combination thereof. In addition, the second contact node SNC may include doped polysilicon, and the second doped region SR may include an impurity diffused from the second contact node SNC. A height of the first contact node BLC in the first direction D1 may be less than a height of the second contact node SNC in the first direction D1. The height of the first contact node BLC in the first direction D1 may be greater than or equal to a height of the channel CH in the first direction D1.

In some embodiments, the first contact node BLC may be selectively grown from the first sheet region SHS of the nano sheet HL. The first contact node BLC may be formed by selective epitaxial growth (SEG). For example, the first contact node BLC may be a silicon epitaxial layer formed by the SEG. The first contact node BLC may be a doped silicon epitaxial layer. The second contact node SNC may be selectively grown from the third sheet region VS of the nano sheet HL. The second contact node SNC may be formed by the SEG. For example, the second contact node SNC may be a silicon epitaxial layer formed by the SEG. The second contact node SNC may be a doped silicon epitaxial layer.

The nano sheet HL may include a first edge and a second edge. The first edge may refer to a portion of the first doped region DR or a portion of the first sheet region SHS, which is electrically coupled to the second conductive line BL, and the second edge may refer to a portion of the second doped region SR or a portion of the third sheet region VS, which is electrically coupled to the first electrode SN of the data storage element CAP.

The memory cell MC may further include a barrier layer (not illustrated) between the first contact node BLC and the second conductive line BL. The barrier layer may include a metal nitride such as titanium nitride. In some embodiments, the memory cell MC may further include an ohmic contact layer between the barrier layer and the first contact node BLC. The ohmic contact layer may include metal silicide.

Referring to FIG. 1B, the first conductive line WL may be disposed between inter-cell horizontal dielectric layers HIL which extend in the third direction D3. These inter-cell horizontal dielectric layers HIL may each include, for example, silicon oxide, silicon nitride, or a combination thereof. A first spacer SP1 may be formed on the first side surfaces of the inter-cell horizontal dielectric layers HIL. A second spacer SP2 may be formed on the second side surfaces of the inter-cell horizontal dielectric layers HIL. The first spacer SP1 may be disposed between the first conductive line WL and the data storage element CAP, and the second spacer SP2 may be disposed between the first conductive line WL and the second conductive line BL. The first and second spacers SP1 and SP2 may each include a dielectric material. The first and second spacers SP1 and SP2 may each include, for example, silicon oxide, silicon nitride, or a combination thereof. The first spacer SP1 may be referred to as a "word line spacer", and the second spacer SP2 may be referred to as a "bit line spacer".

In another embodiment, the memory cell MC may have a 1T-1C structure, where 1T may refer to one switching element TR, and 1C may refer to one data storage element CAP. When the memory cell MC is a DRAM cell having the 1T-1C structure, 1T may refer to one cell transistor, and 1C may refer to one capacitor. Accordingly, a gate of the cell transistor may be a word line, a drain region of the cell transistor may be coupled to a bit line, and a source region of the cell transistor may be coupled to the capacitor. The bit line may correspond to the second conductive line BL of FIGS. 1A and 1B, the word line may correspond to the first conductive line WL of FIGS. 1A and 1B, and the capacitor may correspond to the data storage element CAP of FIGS. 1A and 1B. In addition, the drain region of the cell transistor may correspond to the first doped region DR of FIGS. 1A and 1B, and the source region of the cell transistor may correspond to the second doped region SR of FIGS. 1A and 1B.

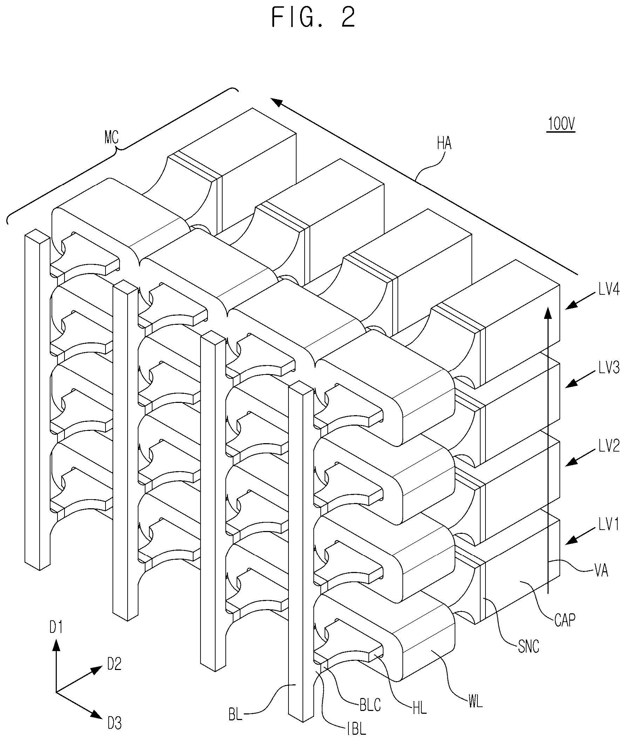

FIG. 2 is a schematic perspective view illustrating a semiconductor device 100V in accordance with an embodiment of the present disclosure.

Referring to FIG. 2, the semiconductor device 100V may include a three-dimensional array of memory cells MC described above with reference to FIG. 1A. Detailed descriptions of each of the memory cells MC are provided above with reference to FIGS. 1A to 1C.

Referring to FIGS. 1A, 1B, 1C and 2, the semiconductor device 100V may include a horizontal arrangement HA and vertical arrangement VA of the memory cells MC. The memory cells MC in the horizontal arrangement HA may be horizontally spaced apart in a third direction D3. The memory cells MC in the vertical arrangement VA may be vertically stacked in a first direction D1. The memory cells MC in the horizontal arrangement HA may be vertically stacked in the first direction D1. The vertical arrangement VA of the memory cells MC may include a structure in which the horizontal arrangements HA of the memory cells MC are vertically stacked in the first direction D1. The semiconductor device 100V may include a horizontal arrangement of vertical conductive lines in which the vertical conductive lines are arranged in the third direction D3. The horizontal arrangement of the vertical conductive lines may include the horizontal arrangement HA of second conductive lines BL. The semiconductor device 100V may include a vertical arrangement of horizontal conductive lines in which the horizontal conductive lines are arranged in the first direction D1. The vertical arrangement of the horizontal conductive lines may include the vertical arrangement VA of first conductive lines WL.

The memory cells MC in the horizontal arrangement HA may be coupled to different second conductive lines BL and share one first conductive line WL. The memory cells MC in the vertical arrangement VA may include different first conductive lines WL and be coupled to one second conductive line BL.

The vertical arrangement VA may constitute a plurality of tiers LV1, LV2, LV3, and LV4. For example, a first tier LV1, a second tier LV2, a third tier LV3 and a fourth tier LV4 may be sequentially and vertically stacked in the vertical arrangement VA of the semiconductor device 100V. Each of inter-cell horizontal dielectric layers (reference symbol "HIL" of FIG. 1B) may be formed between the memory cells MC in the vertical arrangement VA.

The semiconductor device 100V may include the horizontal arrangement HA and vertical arrangement VA of nano sheets HL. The semiconductor device 100V may include the horizontal arrangement HA and vertical arrangement VA of switching elements TR. The semiconductor device 100V may include the horizontal arrangement HA of the second conductive lines BL. The semiconductor device 100V may also include the vertical arrangement VA of the first conductive lines WL.

The semiconductor device 100V may further include a first spacer SP1 and a second spacer SP2, which are described above with reference to FIG. 1B.

In another embodiment, the semiconductor device 100V may include nano sheet transistors TR each including a nano sheet HL including a first doped region DR, a channel CH, and a second doped region SR and a word line WL having a gate-all-around (GAA) structure of surrounding the channel CH of the nano sheet HL, a common vertical bit line BL coupled to the first doped regions DR of the nano sheet transistors TR, and capacitors CAP coupled to the second doped regions SR of the nano sheet transistors TR. The nano sheets HL may include curved sheets SHS including narrower side surfaces F3 that are coupled to the common vertical bit line BL and curved side surfaces CVS that are continuous from the narrower side surfaces F3, horizontal sheets LHS that extend horizontally from the curved sheets SHS, and tapered sheets VS that extend horizontally from the horizontal sheets LHS and are coupled to the capacitors CAP.

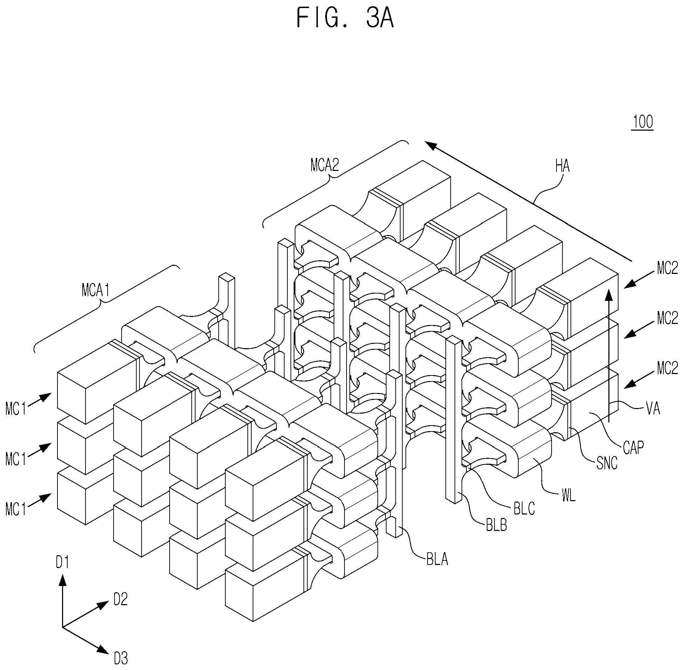

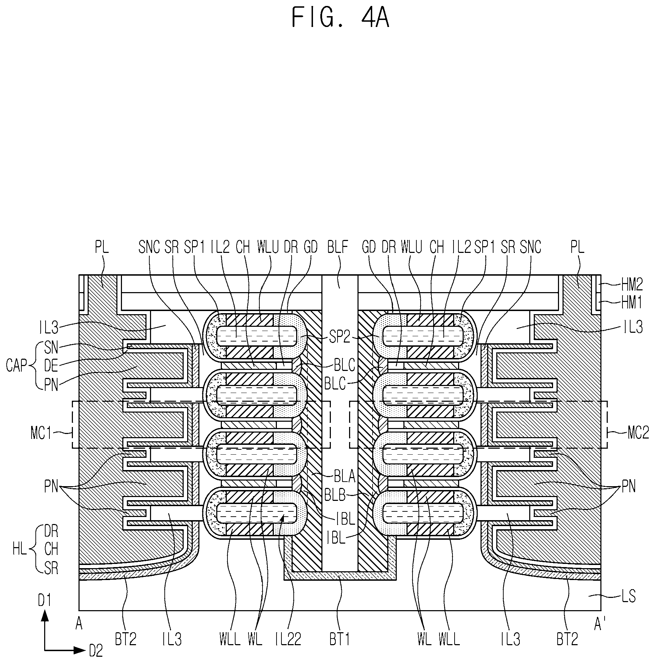

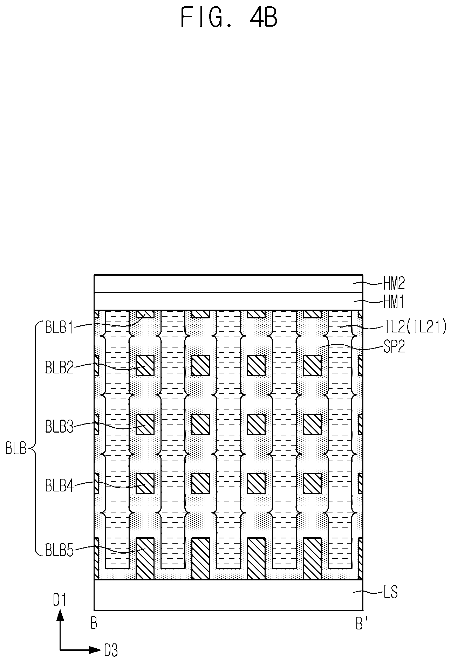

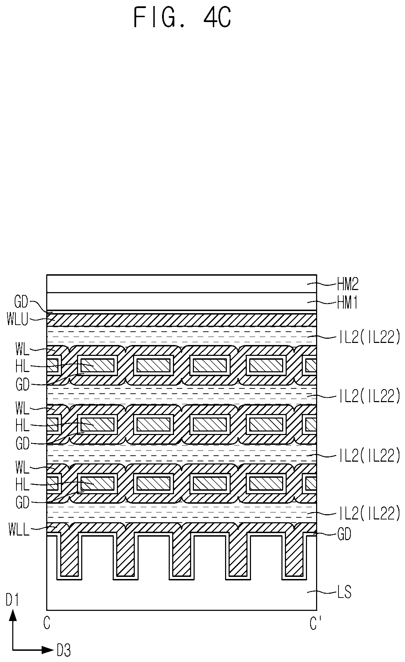

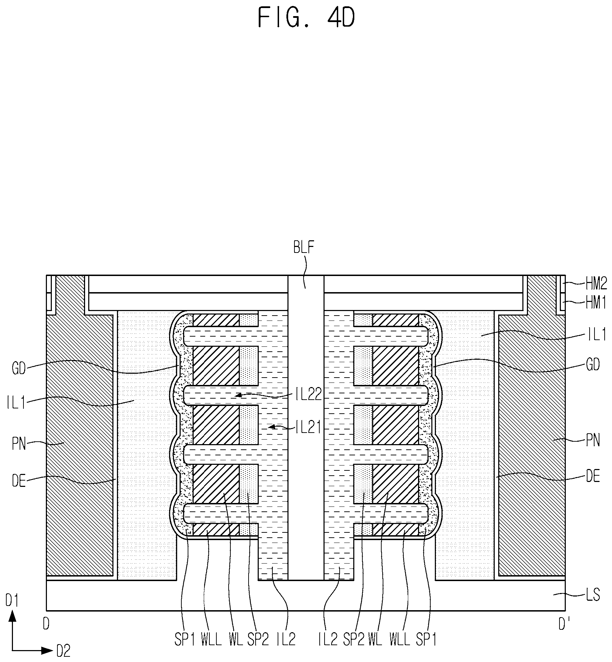

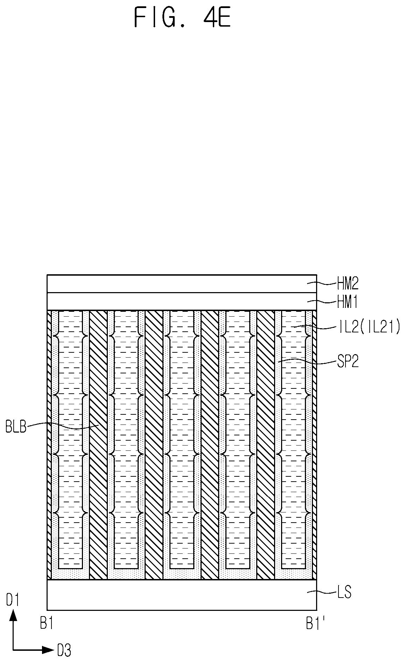

FIG. 3A is a schematic plan view of a semiconductor device 100 in accordance with an embodiment of the present disclosure. FIG. 3B is a plan view illustrating the semiconductor device 100 illustrated in FIG. 3A. FIG. 4A is a schematic cross-sectional view of the semiconductor device 100 taken along line A-A' illustrated in FIG. 3B. FIG. 4B is a schematic cross-sectional view of the semiconductor device 100 taken along line B-B' illustrated in FIG. 3B. FIG. 4C is a schematic cross-sectional view of the semiconductor device 100 taken along line C-C' illustrated in FIG.3B. FIG. 4D is a schematic cross-sectional view of the semiconductor device 100 taken along line D-D' illustrated in FIG.3B. FIG. 4E is a schematic cross-sectional view of the semiconductor device 100 taken along line B1-B1' illustrated in FIG.3B. Detailed descriptions of overlapping components are provided above with reference to FIGS. 1A to 2.

Referring to FIGS. 3A, 3B, 4A, 4B, 4C, 4D and 4E, the semiconductor device 100 may include a lower structure LS and a memory cell array MCA.

The lower structure LS may include a substrate. The lower structure LS may be any material that is appropriate or suitable for semiconductor processing. The lower structure LS may include a semiconductor substrate, a conductive material, a dielectric material, a semiconductive material, or a combination thereof. The lower structure LS may include silicon, monocrystalline silicon, polysilicon, amorphous silicon, silicon germanium, monocrystalline silicon germanium, polycrystalline silicon germanium, carbon-doped silicon, epitaxial silicon, a combination thereof, or multilayers thereof. The lower structure LS may also include another semiconductive material such as germanium. The lower structure LS may also include a III-V group semiconductor substrate, for example, a compound semiconductor substrate such as Gallium Arsenide (GaAs). In some embodiments, the lower structure LS may include a metal wiring structure, a dielectric structure, a conductive structure, a bonding pad structure, another memory, or a peripheral circuit portion. For example, the lower structure LS may include a structure in which the peripheral circuit portion, the metal wiring structure and the bonding pad structure are sequentially stacked. The memory cell array MCA and the peripheral circuit portion of the lower structure LS may be bonded, for example, by wafer bonding. The wafer bonding may include pad bonding, hybrid bonding, oxide-to-oxide bonding, metal-to-metal bonding, or a combination thereof.

The memory cell array MCA may include a plurality of memory cells MC1 and MC2 stacked vertically in a first direction D1. The memory cell array MCA may include a three-dimensional array of the memory cells MC1 and MC2, that is, horizontal and vertical arrangements of the memory cells MC1 and MC2. Each of the memory cells MC1 and MC2 may include a switching element TR and a data storage element CAP. The switching element TR may include a first conductive line WL, a nano sheet dielectric layer GD, and a nano sheet HL. The nano sheet HL may include a first doped region DR, a channel CH, and a second doped region SR. The first doped region DR of the nano sheet HL may be coupled to a second conductive line BLA and BLB. A first contact node BLC may be formed between the first doped region DR of the nano sheet HL and the second conductive line BLA and BLB. A second contact node SNC may be formed between the second doped region SR of the nano sheet HL and the data storage element CAP. The nano sheet HL may be surrounded by the nano sheet dielectric layer GD. The first conductive line WL may surround the channels CH of the nano sheets HL on the nano sheet dielectric layer GD and extend in a third direction D3.

The memory cells MC1 and MC2 may each have the same configuration as the memory cell MC described above with reference to FIGS. 1A to 1C. As described with reference to FIGS. 1A to 1C, each of the nano sheets HL may include a curved sheet, a horizontal sheet, and a tapered sheet. The curved sheet may include a first sheet region SHS, the horizontal sheet may include a second sheet region LHS, and the tapered sheet may include a third sheet region VS. The horizontal sheet of the nano sheet HL may include flat side surfaces FLS, and the curved sheet may include curved side surfaces CVS.

The first doped regions DR of the nano sheets HL may be formed in the curved sheets, the channels CH of the nano sheets HL may be formed in the horizontal sheets, and the second doped regions SR of the nano sheets HL may be formed in the tapered sheets.

The memory cell array MCA may have a mirror-type structure of sharing the second conductive line BLA and BLB. The second conductive line may include a first vertical conductive line BLA and a second vertical conductive line BLB. The memory cell array MCA may include a first sub-cell array MCA1 including a three-dimensional array of the first memory cells MC1 and a second sub-cell array MCA2 including a three-dimensional array of the second memory cells MC2. The first memory cells MC1 of the first sub-cell array MCA1 may share the first vertical conductive line BLA. The second memory cells MC2 of the second sub-cell array MCA2 may share the second vertical conductive line BLB. A bottom portion of the first vertical conductive line BLA and a bottom portion of the second vertical conductive line BLB may be electrically isolated from each other or merged with each other. The first and second vertical conductive lines BLA and BLB may include inner portions IBL. Upper and lower surfaces of the inner portions IBL of the first and second vertical conductive lines BLA and BLB may have curved profiles. The curved profiles of the inner portions IBL may each have a downward curved slope that decreases a vertical length of the inner portion IBL in the first direction D1 toward the first contact node BLC.

Each of the first memory cells MC1 of the first sub-cell array MCA1 may include the switching element TR and the data storage element CAP. The switching element TR may include the first conductive line WL and the nano sheet HL. The switching elements TR of the first memory cells MC1 may be nano sheet transistors. The first sub-cell array MCA1 may include horizontal and vertical arrangements of the nano sheet transistors. The first memory cells MC1 may be coupled to the first vertical conductive lines BLA. The first sub-cell array MCA1 may include a horizontal arrangement of the first vertical conductive lines BLA, a vertical arrangement of the first conductive lines WL, and horizontal and vertical arrangements of the data storage elements CAP.

Each of the second memory cells MC2 of the second sub-cell array MCA2 may include the switching element TR and the data storage element CAP. The switching element TR may include the first conductive line WL and the nano sheet HL. The switching elements TR of the second memory cells MC2 may be nano sheet transistors. The second sub-cell array MCA2 may include horizontal and vertical arrangements of the nano sheet transistors. The second memory cells MC2 may be coupled to the second vertical conductive lines BLB. The second sub-cell array MCA2 may include a horizontal arrangement of the second vertical conductive lines BLB, a vertical arrangement of the first conductive lines WL, and horizontal and vertical arrangements of the data storage elements CAP.

The nano sheets HL of the first and second memory cells MC1 and MC2 may include first edges and second edges. The first edges of the nano sheets HL may refer to portions of the first doped regions DR electrically coupled to the first and second vertical conductive lines BLA and BLB. The second edges of the nano sheets HL may refer to portions of the second doped regions SR electrically coupled to the first electrodes SN of the data storage elements CAP.

Each of the first and second memory cells MC1 and MC2 may further include the first contact nodes BLC and the second contact nodes SNC. The first contact nodes BLC may be disposed between the first and second vertical conductive lines BLA and BLB and the nano sheets HL. The second contact nodes SNC may be disposed between the first electrodes SN of the data storage elements CAP and the nano sheets HL. The first contact nodes BLC may be selectively grown from the first edges of the nano sheets HL. The second contact nodes SNC may be selectively grown from the second edges of the nano sheets HL. The first and second contact nodes BLC and SNC may be formed by selective epitaxial growth (SEG). For example, the first and second contact nodes BLC and SNC may be silicon epitaxial layers formed by the SEG. The first and second contact nodes BLC and SNC may be doped silicon epitaxial layers. Each of the first and second memory cells MC1 and MC2 may further include barrier layers between the first contact nodes BLC and the first and second vertical conductive lines BLA and BLB. The barrier layers may each include metal nitride, such as titanium nitride. In some embodiments, each of the first and second memory cells MC1 and MC2 may further include an ohmic contact layer between the barrier layers and the first contact nodes BLC. The first contact nodes BLC may contact inner portions IBL of the first and second vertical conductive lines BLA and BLB.

Each of the first and second memory cells MC1 and MC2 may further include a first spacer SP1 and a second spacer SP2. The first spacer SP1 may be disposed between the first conductive lines WL and the first electrodes SN of the data storage elements CAP. The second spacer SP2 may be disposed between the first conductive lines WL and the second conductive lines BL. The first and second spacers SP1 and SP2 may each include a dielectric material. The first and second spacers SP1 and SP2 may each include, for example, silicon oxide, silicon nitride, or a combination thereof.

The first spacer SP1 may surround the second doped regions SR of the nano sheets HL, that is, the third sheet regions VS, and the second spacer SP2 may surround the first doped regions DR of the nano sheets HL, that is, the first sheet regions SHS. The first and second spacers SP1 and SP2 may be disposed on both sidewalls of the first conductive line WL.

The first spacer SP1 may surround the second doped regions SR of the nano sheets HL in the horizontal and vertical arrangements, the first conductive lines WL may surround the channels CH of the nano sheets HL in the horizontal arrangement, and the second spacer SP2 may surround the first doped regions DR of the nano sheets HL in the horizontal and vertical arrangements.

Specifically, the first spacer SP1 may surround the second doped regions SR of the nano sheets HL in the horizontal and vertical arrangements and also extend in the first direction D1 and the third direction D3. The second spacer SP2 may surround the first doped regions DR of the nano sheets HL in the horizontal and vertical arrangements and also extend in the first direction D1 and the third direction D3.

More specifically, the first spacer SP1 may surround the second doped regions SR of the nano sheets HL in the horizontal arrangement and also extend in the third direction D3. In addition, the first spacer SP1 may surround the second doped regions SR of the nano sheets HL in the vertical arrangement and may also extend in the first direction D1. The second spacer SP2 may surround the first doped regions DR of the nano sheets HL in the horizontal arrangement and also extend in the third direction D3. In addition, the second spacer SP2 may surround the first doped regions DR of the nano sheets HL in the vertical arrangement and also extend in the first direction D1.

As described above, each of the first and second spacers SP1 and SP2 may have a frame structure. The frame structure of the first spacer SP1 may surround all second doped regions SR of the nano sheets HL in the horizontal and vertical arrangements. The frame structure of the second spacer SP2 may surround all first doped regions DR of the nano sheets HL in the horizontal and vertical arrangements.

The first conductive lines WL may surround the channels CH of the nano sheets HL in the horizontal arrangement and also extend in the third direction D3.

The first conductive lines WL, the first spacer SP1 and the second spacer SP2 may surround the nano sheets HL disposed at the same horizontal level.

The second spacer SP2 may surround the inner portions IBL of the first and second vertical conductive lines BLA and BLB and the first contact nodes BLC.

In some embodiments, the first conductive lines WL may extend to surround a portion or all of the surface of the curved sheet.

As described above, each of the first and second vertical conductive lines BLA and BLB may vertically extend in the first direction D1, the nano sheets HL may extend in the second direction D2, and the first conductive lines WL may horizontally extend in the third direction D3.

Each of first inter-cell dielectric layers IL1 may be disposed between the data storage elements CAP which are adjacent to each other in the third direction D3. Each of second inter-cell dielectric layers IL2 may be disposed between the first conductive lines WL which are vertically stacked in the first direction D1. Each of third inter-cell dielectric layers IL3 (see for example, FIG. 4A) may be disposed between the first electrodes SN of the data storage elements CAP which are vertically stacked in the first direction D1. The first to third inter-cell dielectric layers IL1, IL2 and IL3 may each include, for example, silicon oxide, silicon carbon oxide (SiCO), silicon nitride, or a combination thereof. The first inter-cell dielectric layers IL1 may be referred to as "inter-cell isolation layers". The second inter-cell dielectric layers IL2 may correspond to the inter-cell horizontal dielectric layer HIL illustrated in FIG. 1B. The third inter-cell dielectric layers IL3 may be inter-data storage element dielectric layers. A combination of the first inter-cell dielectric layers IL1 and the third inter-cell dielectric layers IL3 may define a slot in which the first electrodes SN of the data storage elements CAP are formed.

The memory cell array MCA may include a plurality of first conductive lines WL vertically stacked in the first direction D1. The memory cell array MCA may include a plurality of nano sheets HL vertically stacked in the first direction D1. The memory cell array MCA may include a plurality of data storage elements CAP vertically stacked in the first direction D1. The memory cell array MCA may include a plurality of second conductive lines BLA and BLB spaced apart in the third direction D3. The memory cell array MCA may include a dummy conductive line WLU disposed at a level higher than an uppermost first conductive line WL and a dummy conductive line WLL disposed at a level lower than a lowermost first conductive line WL. The dummy conductive lines WLU and WLL may each have a linear shape extending horizontally.

The memory cell array MCA may include a stack of a plurality of hard mask layers HM1 and HM2 disposed at a level higher than the uppermost first conductive line WL.

The memory cell array MCA may include a plurality of bottom dummy growth layers BT1. The bottom dummy growth layers BT1 may be formed on a surface of the lower structure LS.

An array isolation layer BLF may be disposed between the first vertical conductive line BLA and the second vertical conductive line BLB. The array isolation layer BLF may include a dielectric material.

The first conductive line WL extending in the third direction D3 may surround a plurality of nano sheets HL horizontally disposed in the third direction D3. The nano sheets HL of the switching elements TR horizontally disposed in the third direction D3 may be coupled to different second conductive lines BL. Switching elements TR stacked in the first direction D1 may share one second conductive line BL. Switching elements TR horizontally disposed in the third direction D3 may share one first conductive line WL.

Second electrodes PN of the data storage elements CAP may be coupled to a common plate PL.

Bottom portions of the first vertical conductive lines BLA of the first sub-cell array MCA1 may be coupled to the bottom dummy growth layer BT1, and bottom portions of the second vertical conductive lines BLB of the second sub-cell array MCA2 may be coupled to the bottom dummy growth layer BT1. The bottom portions of the first vertical conductive lines BLA of the first sub-cell array MCA1 and the bottom portions of the second vertical conductive lines BLB of the second sub-cell array MCA2 may share the bottom dummy growth layer BT1. In some embodiments, the bottom portions of the first vertical conductive lines BLA and the bottom portions of the second vertical conductive lines BLB may be merged with each other.

Each of the second inter-cell dielectric layers IL2 may include a horizontal segment IL22 and a vertical segment IL21, both composed of a dielectric material with an integral structure. The horizontal segment IL22 and the vertical segment IL21 of the second inter-cell dielectric layer IL2 may intersect each other. The horizontal segment IL22 may horizontally extend in the third direction D3, and the vertical segment IL21 may vertically extend in the first direction D1. One edge of the horizontal segment IL22 may include convex patterns and concave patterns positioned between the convex patterns. The vertical segment IL21 may partially fill the concave patterns and also extend in the first direction D1. Both sides of the vertical segment IL21 may directly contact the convex patterns. A spacer gap may be defined by the vertical segment IL21, the convex patterns and the concave patterns, and a portion of the second spacer SP2 may fill the spacer gap and also surround the convex patterns.

The horizontal segment IL22 of the second inter-cell dielectric layer IL2 may be disposed between the first conductive lines WL in the first direction D1, and the vertical segment IL21 of the second inter-cell dielectric layer IL2 may be disposed between the first vertical conductive lines BLA and between the second vertical conductive lines BLB in the third direction D3. The horizontal segment IL22 of the second inter-cell dielectric layer IL2 may be parallel to the first conductive lines WL, and the vertical segments IL21 of the second inter-cell dielectric layer IL2 may be parallel to the first and second vertical conductive lines BLA and BLB. The horizontal segment IL22 of the second inter-cell dielectric layer IL2 may be an isolation layer that isolates the first conductive lines WL adjacent to each other in the first direction D1, and the vertical segment IL21 of the second inter-cell dielectric layer IL2 may be an isolation layer that isolates the first vertical conductive lines BLA adjacent to each other in the third direction D3 and an isolation layer that isolates the second vertical conductive lines BLB adjacent to each other in the third direction D3.

The second spacer SP2 may include horizontal segments covering one side of the horizontal segments IL22 of the second inter-cell dielectric layer IL2 while contacting one side of the first conductive lines WL and vertical segments contacting outer walls of the first and second vertical conductive lines BLA and BLB while covering outer walls of the vertical segments IL21 of the second inter-cell dielectric layer IL2. The second inter-cell dielectric layers IL2 may be first hybrid dielectric layers having the horizontal segments IL22 and the vertical segments IL21, and the second spacer SP2 may be a second hybrid dielectric layer having the horizontal segments and the vertical segments. In some embodiments, the semiconductor device 100 may include vertical and horizontal arrangements of nano sheets HL whose one side has a curved structure and which are horizontally oriented, a vertical arrangement of first conductive lines WL surrounding portions of the nano sheets HL in the horizontal arrangement, a horizontal arrangement of second conductive lines BLA and BLB coupled in common to first edges of the nano sheets HL in the vertical arrangement and respectively coupled to the first edges of the nano sheets HL in the horizontal arrangement, data storage elements CAP coupled to second edges of the nano sheets HL in the vertical and horizontal arrangements, a first hybrid dielectric layer IL2 including horizontal segments IL21 disposed between the first conductive lines WL in the vertical arrangement and vertical segments IL22 disposed between the first and second vertical conductive lines BLA and BLB in the horizontal arrangement, and a second hybrid dielectric layer SP2 that covers one side of the horizontal segments IL21 of the first hybrid dielectric layer IL2 and is disposed between the vertical segments IL22 of the first hybrid dielectric layer IL2 and the first and second vertical conductive lines BLA and BLB.

Referring to FIGS. 4B and 4E, each of the second vertical conductive lines BLB, may include a plurality of protruding segments BLB1, BLB2, BLB3, BLB4 and BLB5. The protruding segments BLB1 to BLB5 may directly contact the first contact nodes BLC. The protruding segments BLB1 to BLB5 may be surrounded by the second spacer SP2, and each of the vertical segments IL21 of the second inter-cell dielectric layer IL2 may be disposed between the second spacers SP2.

The first and second vertical conductive lines BLA and BLB may be formed to be self-aligned with the second spacer SP2, and the second spacer SP2 may surround the segments of the first and second vertical conductive lines BLA and BLB. The second spacer SP2 may serve as a supporter for supporting the first and second vertical conductive lines BLA and BLB.

According to the above-described embodiment, the second inter-cell dielectric layer IL2 may include the horizontal segment IL22 and the vertical segment IL21, and the second conductive lines BLA and BLB may be formed to be self-aligned with the second spacer SP2. The first and second vertical conductive lines BLA and BLB may be referred to as "self-aligned bit lines (SABL)".

In an embodiment, because the second conductive lines BLA and BLB are formed to be self-aligned, it is possible to increase a stack number (or quantity) of the memory cells MC1 and MC2 (high stack height) and carry out a high-integration process of a three-dimensional memory cell with a small cell pitch.

In an embodiment, because of a frame structure in which the horizontal segment IL22 and the vertical segment IL21 intersect and are merged with each other, the second inter-cell dielectric layer IL2 may be prevented from bending.

In an embodiment, reliability of the semiconductor device 100 may be improved by preventing the bending of the nano sheets HL. As will be described later, the sacrificial sheet layers, which serve as spaces for forming the first and second vertical conductive lines (BLA and BLB), remain as continuous layers throughout the subsequent process. This continuity helps prevent the horizontal sheet from bending during later processing steps.

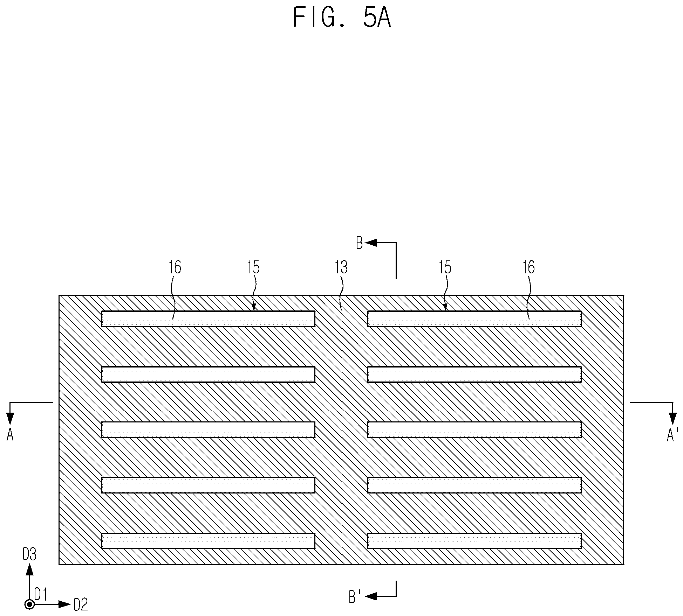

FIGS. 5A to 28B illustrate various views of a semiconductor device formed utilizing a method for fabricating the semiconductor device in accordance with an embodiment of the present disclosure.

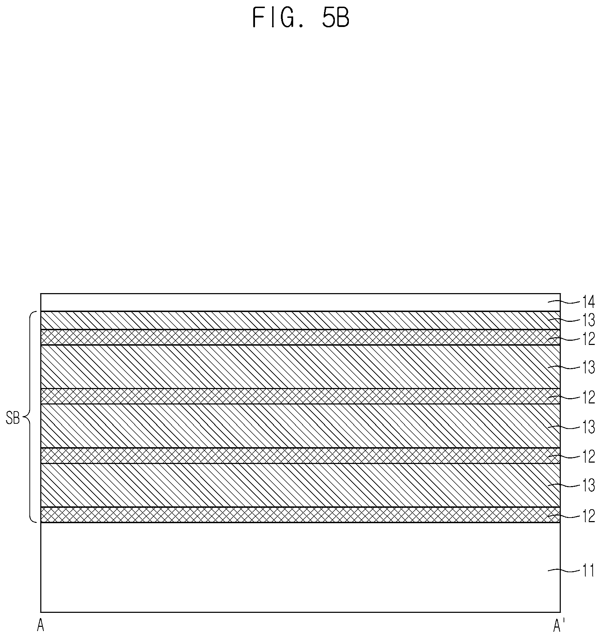

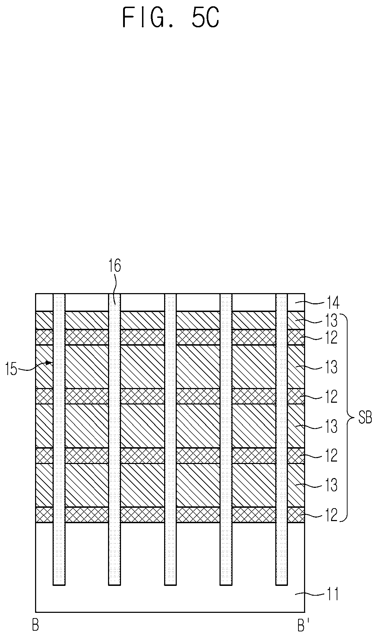

FIG. 5A is a plan view illustrating a structure at a mold layer level for describing a method of forming a mold stack SB. FIG. 5B is a cross-sectional view of the structure taken along line A-A' illustrated in FIG. 5A. FIG. 5C is a cross-sectional view of the structure taken along line B-B' illustrated in FIG. 5A.

Referring to FIGS. 5A to 5C, the mold stack SB may be formed on a substrate 11. The mold stack SB may include an alternating stack of sacrificial mold layers 12 and mold layers 13.

The substrate 11 may be any material that is appropriate or suitable for semiconductor processing. The substrate 11 may include a semiconductor substrate, a conductive material, a dielectric material, a semiconductive material, or a combination thereof. The substrate 11 may include silicon, monocrystalline silicon, polysilicon, amorphous silicon, silicon germanium, monocrystalline silicon germanium, polycrystalline silicon germanium, carbon-doped silicon, epitaxial silicon, a combination thereof, or multilayers thereof. The substrate 11 may also include another semiconductor material such as germanium. The substrate 11 may also include a III-V group semiconductor substrate, for example, a compound semiconductor substrate such as Gallium Arsenide (GaAs). The mold stack SB may include an alternating stack of the sacrificial mold layers 12 and the mold layers 13.

The mold stack SB may be formed by an epitaxial growth process. To form the mold stack SB, the sacrificial mold layers 12 may be alternately stacked with the mold layers 13, and the sacrificial mold layers 12 and the mold layers 13 may be epitaxially grown.

The sacrificial mold layers 12 and the mold layers 13 may be different semiconductive materials. For example, the sacrificial mold layers 12 may each include silicon germanium or monocrystalline silicon germanium. Also, as an example, the mold layers 13 may each include monocrystalline silicon. The sacrificial mold layers 12 and the mold layers 13 may be formed by the epitaxial growth process. A lowermost sacrificial mold layer 12 may serve as a seed layer during the epitaxial growth process. Each of the sacrificial mold layers 12 may be thinner than each of the mold layers 13. The sacrificial mold layers 12 may include first epitaxially grown layers, and the mold layers 13 may include second epitaxially grown layers.

In an embodiment, a plurality of monocrystalline silicon germanium layers may be alternately stacked with a plurality of monocrystalline silicon layers in the mold stack SB. For example, the sacrificial mold layers 12 may be the monocrystalline silicon germanium layers, and the mold layers 13 may be the monocrystalline silicon layers. A stack of a monocrystalline silicon germanium layer and a monocrystalline silicon layer (a SiGe/Si stack) may be stacked multiple times. The sacrificial mold layers 12 may be referred to as "sacrificial layers", and the mold layers 13 may be referred to as "nano sheet target layers".

The mold stack SB may be referred to as a "vertical stack". The mold stack SB may be formed by alternately stacking a plurality of sacrificial layers and a plurality of nano sheet target layers. The sacrificial layers may be monocrystalline silicon germanium layers, and the nano sheet target layers may be monocrystalline silicon layers.

A thickness ratio of the sacrificial mold layers 12 and a thickness ratio of the mold layers 13 in the mold stack SB may be variously modified. For example, the thickness of each of the sacrificial mold layers 12 may be 5 to 20 nm, and the thickness of each of the mold layers 13 may be 50 to 80 nm. Furthermore, a number (or quantity) of the sacrificial mold layers 12 and a number (or quantity) of the mold layers 13 in the mold stack SB may be variously modified.

Referring to FIG. 5B, a first hard mask layer 14 may be formed on the mold stack SB. The first hard mask layer 14 may have an etch selectivity with respect to the mold stack SB. The first hard mask layer 14 may include an oxide-based material, a nitride-based material, a carbon-based material, or a combination thereof. For example, the first hard mask layer 14 may include silicon oxide (SiO₂), silicon nitride (Si₃N₄) amorphous carbon, or a combination thereof.

Subsequently, as illustrated in FIG. 5C, a plurality of sacrificial isolation openings 15 may be formed by etching portions of the mold stack SB and using the first hard mask layer 14 as a barrier. The sacrificial isolation openings 15 may be initial openings for cell isolation. From the perspective of a top view, cross-sections of the sacrificial isolation openings 15 may each have a rectangular shape. In some embodiments, the cross-sections of the sacrificial isolation openings 15 may each have a circular shape or an oval shape. In some embodiments, the sacrificial isolation openings 15 may be referred to as "sacrificial isolation trenches". The sacrificial isolation openings 15 may vertically extend in a first direction D1 and extend lengthwise in a second direction D2. The sacrificial isolation openings 15 may be disposed at a predetermined interval in a third direction D3. Bottom surfaces of the sacrificial isolation openings 15 may extend inside of the substrate 11.

Continuously, sacrificial isolation layers 16 may be formed by filling the sacrificial isolation openings 15. The sacrificial isolation layers 16 may include the same material. The sacrificial isolation layers 16 may be formed of a dielectric material. The sacrificial isolation layers 16 may have an etch selectivity with respect to the mold stack SB. For example, the sacrificial isolation layers 16 may each include, for example, silicon oxide, silicon nitride, silicon carbon oxide, silicon carbon nitride, or a combination thereof. Forming the sacrificial isolation layers 16 may include forming sacrificial isolation materials on the first hard mask layer 14 to fill the sacrificial isolation openings 15 and planarizing the sacrificial isolation materials so that a surface of the first hard mask layer 14 is exposed.

The sacrificial isolation layers 16 may vertically extend in the first direction D1 and extend lengthwise in the second direction D2. The sacrificial isolation layers 16 may be disposed at a predetermined interval in the third direction D3. Each of the sacrificial isolation layers 16 may include a stack of a first sacrificial liner layer and a first sacrificial gap-fill layer (not shown). The first sacrificial liner layer may be silicon nitride, and the first sacrificial gap-fill layer may be silicon oxide. The sacrificial isolation layers 16 may penetrate the mold stack SB in the first direction D1 and extend into the substrate 11.

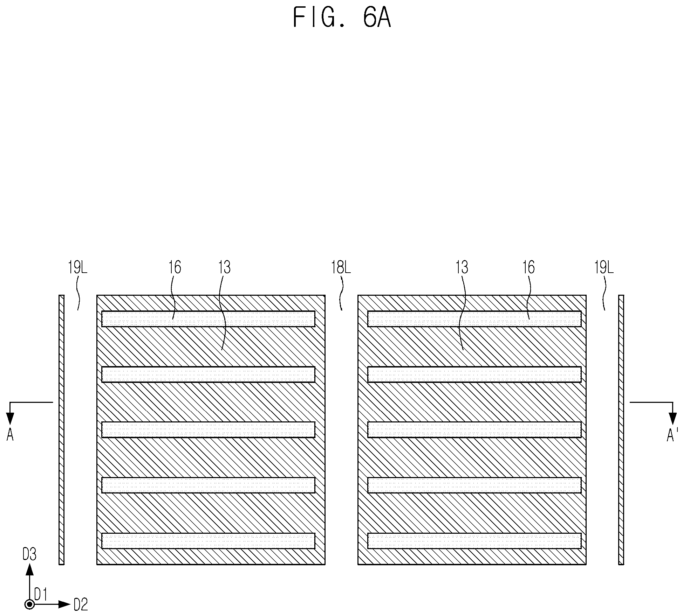

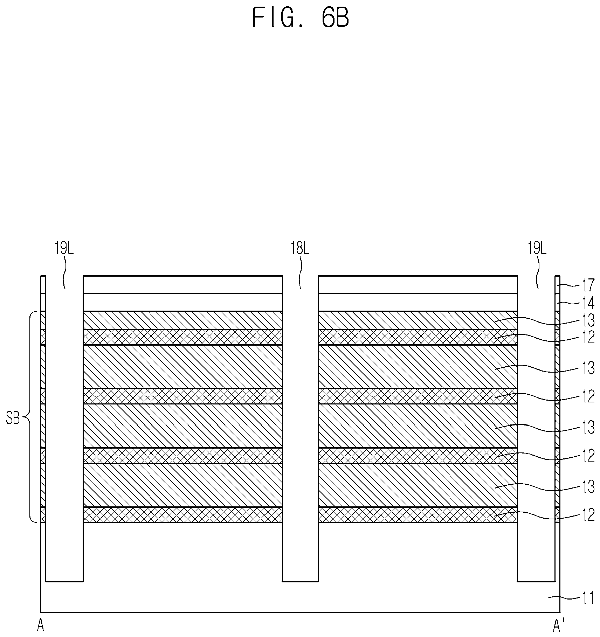

FIG. 6A is a plan view illustrating the structure at the mold layer level for describing a method of forming sacrificial linear openings 18L and 19L. FIG. 6B is a cross-sectional view of the structure taken along line A-A' illustrated in FIG. 6A.

Referring to FIGS. 6A and 6B, a second hard mask layer 17 may be formed on the mold stack SB and the sacrificial isolation layers 16. The second hard mask layer 17 may have an etch selectivity with respect to the mold stack SB and the sacrificial isolation layers 16. The second hard mask layer 17 may include an oxide-based material, a nitride-based material, a carbon-based material, or a combination thereof. For example, the second hard mask layer 17 may include SiO₂, Si₃N₄, amorphous carbon, or a combination thereof. The second hard mask layer 17 may be formed by etching a second hard mask material using a mask layer such as photoresist. The second hard mask layer 17 may have a plurality of line-shaped openings defined therein.

The mold stack SB may be etched using the first and second hard mask layers 14 and 17 as an etch barrier, and subsequently, a portion of the substrate 11 may be etched. Accordingly, a plurality of sacrificial linear openings 18L and 19L may be formed between the sacrificial isolation layers 16. The sacrificial linear openings may include a first sacrificial linear opening 18L and a second sacrificial linear opening 19L. From the perspective of a top view, the first sacrificial linear opening 18L and the second sacrificial linear opening 19L may be line-shaped openings extending in the third direction D3. The first sacrificial linear opening 18L and the second sacrificial linear opening 19L may vertically extend in the first direction D1. The sacrificial isolation layers 16 may be disposed between the first sacrificial linear opening 18L and the second sacrificial linear opening 19L in the second direction D2. From the perspective of a top view, cross sections of the first and second sacrificial linear openings 18L and 19L may each have a rectangular shape. In some embodiments, the cross sections of the first and second sacrificial linear openings 18L and 19L may each have a circular shape or an oval shape. The first and second sacrificial linear openings 18L and 19L may each have a width in the second direction D2 which is less than a width in the third direction D3. The first and second sacrificial linear openings 18L and 19L may be referred to as "sacrificial linear trenches". The sacrificial isolation layers 16 may not contact the first and second sacrificial linear openings 18L and 19L.

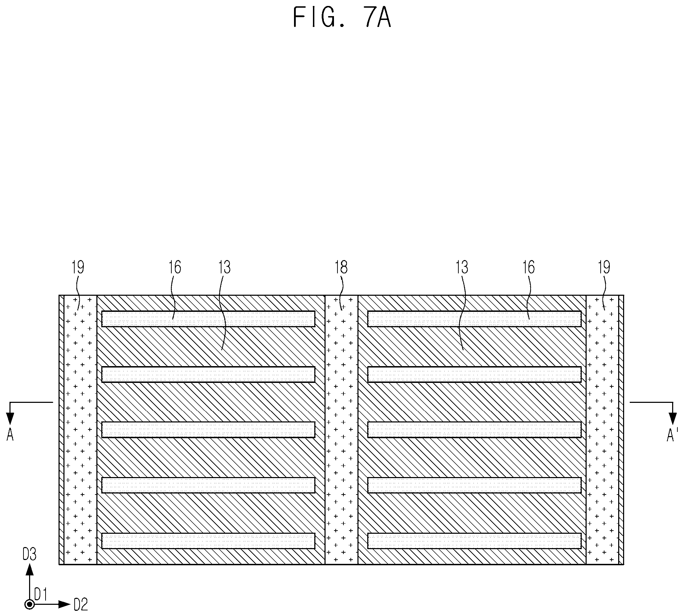

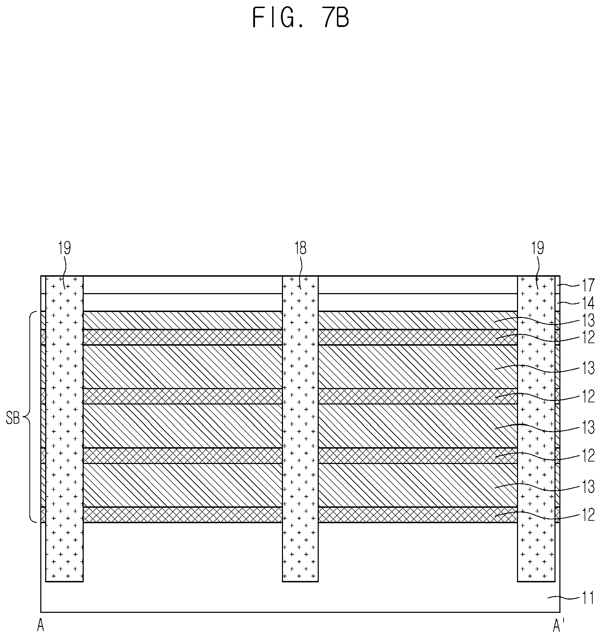

FIG. 7A is a plan view illustrating the structure at the mold layer level for describing a method of forming linear sacrificial layers 18 and 19. FIG. 7B is a cross-sectional view of the structure taken along line A-A' illustrated in FIG. 7A.

Referring to FIGS. 7A and 7B, the linear sacrificial layers 18 and 19 may be formed to fill the first and second sacrificial linear openings 18L and 19L, respectively. The linear sacrificial layers may include a first linear sacrificial layer 18 and a second linear sacrificial layer 19. From the perspective of a top view, the first linear sacrificial layer 18 and the second linear sacrificial layer 19 may have line shapes extending in the third direction D3. Each of the first linear sacrificial layer 18 and the second linear sacrificial layer 19 may vertically extend in the first direction D1. The sacrificial isolation layers 16 may be disposed between the first linear sacrificial layer 18 and the second linear sacrificial layer 19 in the second direction D2. From the perspective of a top view, cross sections of the first and second linear sacrificial layers 18 and 19 may each have a rectangular shape. In some embodiments, the cross-sections of the first and second linear sacrificial layers 18 and 19 may each have a circular shape or an oval shape. The first and second linear sacrificial layers 18 and 19 may include the same material. The first and second linear sacrificial layers 18 and 19 may each be formed of a dielectric material. For example, the first and second linear sacrificial layers 18 and 19 may each include, for example, silicon oxide, silicon nitride, silicon carbon oxide, silicon carbon nitride, silicon, or a combination thereof. The sacrificial isolation layers 16 may not contact the first and second linear sacrificial layers 18 and 19.

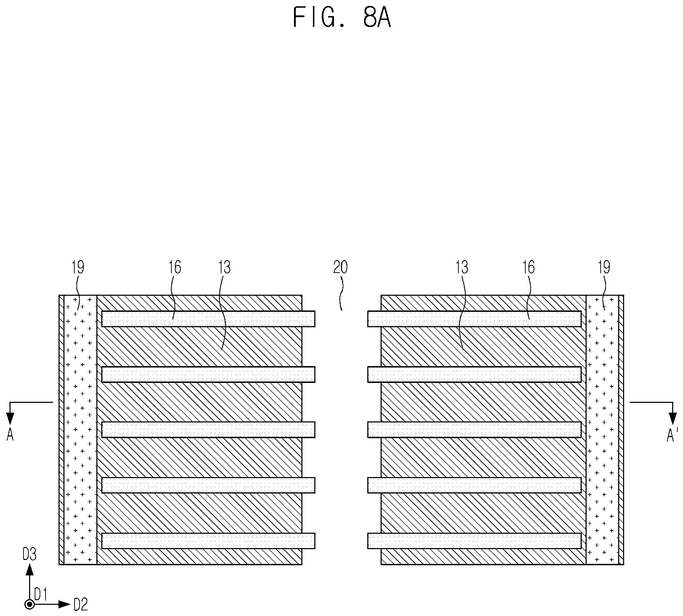

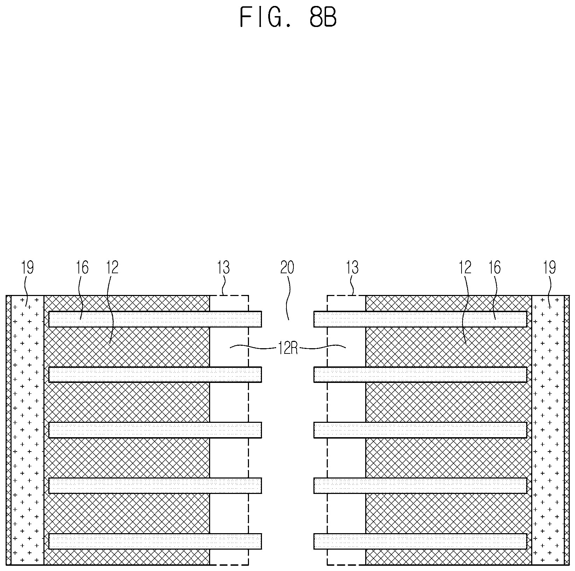

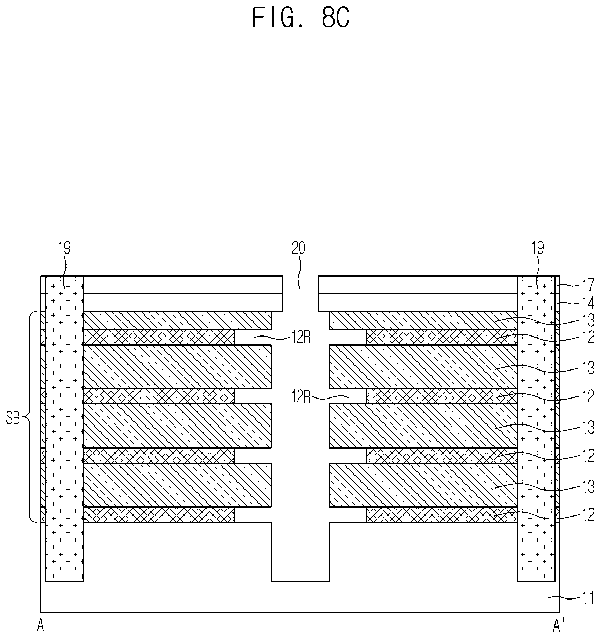

FIG. 8A is a plan view illustrating the structure at the mold layer level for describing the recessing of the sacrificial mold layers 12. FIG. 8B is a plan view illustrating the structure at the mold layer level for describing the recessing of the sacrificial mold layers 12. FIG. 8C is a cross-sectional view of the structure taken along line A-A' illustrated in FIGS. 8A and 8B.

Referring to FIGS. 8A to 8C, among the first linear sacrificial layer 18 and the second linear sacrificial layer 19, the first linear sacrificial layer 18 may be selectively removed. A third hard mask layer (not illustrated) may be used as an etch barrier to remove the first linear sacrificial layer 18. After the first linear sacrificial layer 18 is removed, the sacrificial mold layers 12 and the mold layers 13 may be partially trimmed to form first linear opening 20.

From the perspective of a top view, the first linear opening 20 may be disposed horizontally spaced apart from the second linear sacrificial layer 19 in the second direction D2. The first linear opening 20 may be disposed horizontally spaced apart between a pair of adjacent second linear sacrificial layers 19 in the second direction D2.

The first linear opening 20 may have the same size as or may be larger than the first sacrificial linear opening 18L which was described with reference to FIG. 6A. A bottom surface of the first linear opening 20 may be at the same level as a bottom surface of the first sacrificial linear opening 18L. The bottom surface of the first linear opening 20 may be at the same level as bottom surfaces of the sacrificial isolation layers 16.

The sacrificial mold layers 12 may be partially and horizontally recessed in the second direction D2 through the first linear opening 20. The partial recessing process for the sacrificial mold layers 12 may be referred to as a cutting process for the sacrificial mold layers 12.

Referring to FIGS. 8B and 8C, a difference in etch selectivity between the sacrificial mold layers 12 and the mold layers 13 may be used to selectively recess the sacrificial mold layers 12. The sacrificial mold layers 12 may be removed using a wet or dry etch process. For example, when the sacrificial mold layers 12 include silicon germanium layers, and the mold layers 13 include monocrystalline silicon layers, the silicon germanium layers may be etched using an etchant or etch gas having a selectivity with respect to the monocrystalline silicon layers. Cut slots, as indicated by reference numeral "12R", may be formed by the partial recessing of the sacrificial mold layers 12. The cut slots 12R may be referred to as "sacrificial mold layer level slots" or "side slots". The cut slots 12R may be defined by the mold layers 13 and the sacrificial isolation layers 16. For example, each of the sacrificial mold layer level slots 12R may be disposed between the mold layers 13 in the first direction D1 and may also be disposed between the sacrificial isolation layers 16 in the third direction D3.

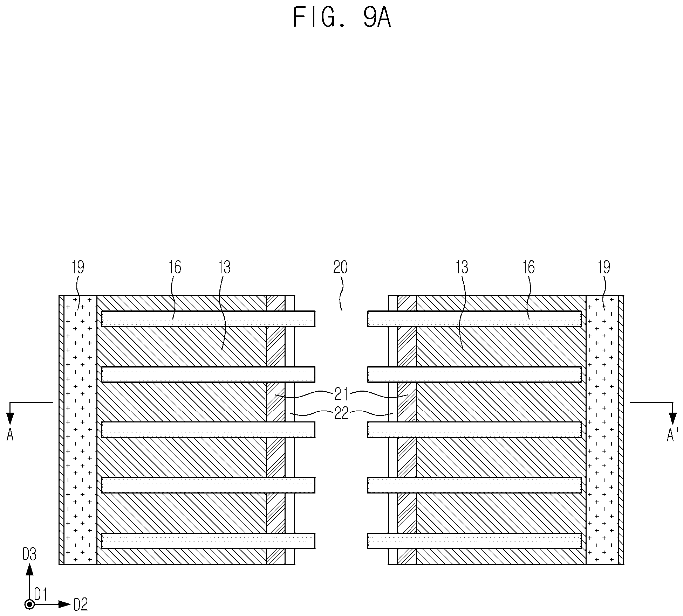

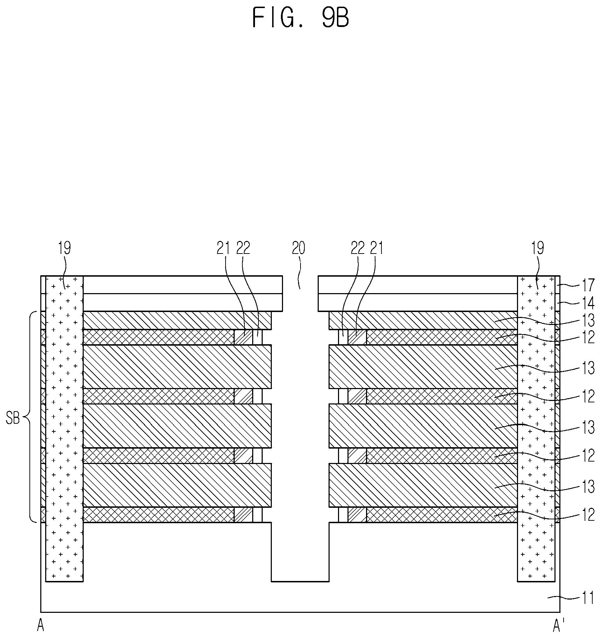

FIG. 9A is a plan view illustrating the structure at a sacrificial mold layer level for describing side fillers. FIG. 9B is a cross-sectional view of the structure taken along line A-A' illustrated in FIG. 9A.

Referring to FIGS. 9A and 9B, the side fillers may be formed to fill the cut slots 12R. Each of the side fillers may include a first side filler 21 and a second side filler 22. The first side filler 21 and the second side filler 22 may each include a dielectric material. The first side filler 21 and the second side filler 22 may include different materials. The first side filler 21 may include, for example, silicon nitride, and the second side filler 22 may include silicon oxide. Deposition and side cutting of silicon nitride may be performed to form the first side filler 21. Deposition and side cutting of silicon oxide may be performed to form the second side filler 22.

A stack of the first side filler 21 and the second side filler 22 may partially fill each of the cut slots 12R. The stack of the first side filler 21 and the second side filler 22 may be disposed between the mold layers 13 in the first direction D1 and may also be disposed between the sacrificial isolation layers 16 in the third direction D3.

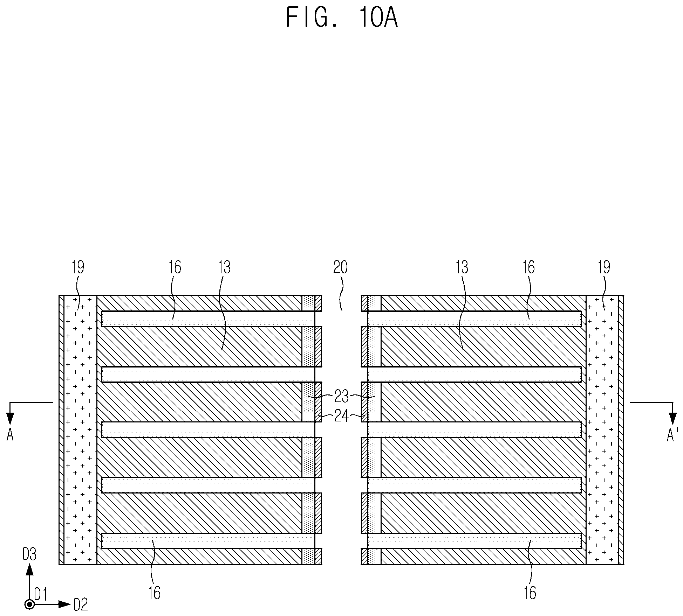

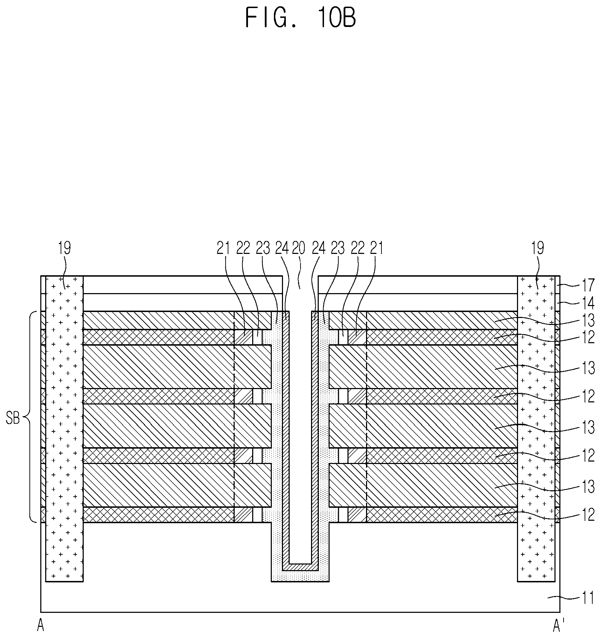

FIG. 10A is a plan view illustrating the structure at the mold layer level for describing a method of forming sacrificial sheet layers 23. FIG. 10B is a cross-sectional view of the structure taken along line A-A' illustrated in FIG. 10A.

Referring to FIGS. 10A and 10B, the sacrificial sheet layers 23 may be formed on the second side fillers 22. The sacrificial sheet layers 23 may each include a conductive material. Selective growth of the conductive material may be performed to form the sacrificial sheet layers 23. The sacrificial sheet layers 23 may include a silicon layer formed by epitaxial growth from the mold layers 13. The sacrificial sheet layers 23 may extend in a stack direction of the mold stack SB on the second side fillers 22 and the mold layers 13. The sacrificial sheet layers 23 and the mold layers 13 may be made of the same material. The sacrificial sheet layers 23 and the mold layers 13 may each include a monocrystalline silicon layer, i.e., an epitaxial silicon layer. The sacrificial sheet layers 23 may be selectively grown from the mold layers 13 and may also be selectively grown from the exposed surface of the substrate 11. The sacrificial sheet layers 23 may be doped epitaxial silicon layers or undoped epitaxial silicon layers.

The sacrificial sheet layers 23 may be isolated from one another by the sacrificial isolation layers 16 in the third direction D3. Bottom portions of the sacrificial sheet layers 23 may be coupled to one another, and thus a cross-section of the sacrificial sheet layers 23 may have a U-shape in the second direction D2. The sacrificial sheet layers 23 may directly contact the mold layers 13 and the second side fillers 22.

Additional sacrificial sheet layers 24 may be formed on the sacrificial sheet layers 23. For example, the additional sacrificial sheet layers 24 may be selectively grown from the sacrificial sheet layers 23. Selective growth of a conductive material may be performed to form the additional sacrificial sheet layers 24. The additional sacrificial sheet layers 24 may each include a silicon germanium layer formed by epitaxial growth. The additional sacrificial sheet layers 24 and the sacrificial sheet layers 23 may be different materials. The additional sacrificial sheet layers 24 may each include a monocrystalline silicon germanium layer, i.e., an epitaxial silicon germanium layer. The additional sacrificial sheet layers 24 may be selectively grown from the sacrificial sheet layers 23. The additional sacrificial sheet layers 24 and the sacrificial mold layers 12 may be made of the same material. The additional sacrificial sheet layers 24 may be silicon germanium layers having a high germanium concentration. For example, the additional sacrificial sheet layers 24 may be germanium-rich silicon germanium layers. The additional sacrificial sheet layers 24 may be thinner than the sacrificial sheet layers 23.

The sacrificial sheet layers 23 and the additional sacrificial sheet layers 24 may not be formed on the sacrificial isolation layers 16.

In some embodiments, the sacrificial sheet layers 23 may be polysilicon. The sacrificial sheet layers 23 may be formed by deposition and side recessing of polysilicon. In this case, some of side surfaces of the mold layers 13 may be removed simultaneously. Some of the sacrificial sheet layers 23 may be present between the mold layers 13 in the first direction D1.

In some embodiments, no additional sacrificial sheet layers 24 are formed. When the sacrificial sheet layers 23 are removed to secure space for forming second conductive lines, that is, vertical bit lines, during a subsequent process, the side surfaces of the mold layers 13 may be removed together with the sacrificial sheet layers 23.

As described above, the sacrificial sheet layers 23 may each have a pillar shape of extending vertically in the first direction D1, and portions of the sacrificial sheet layers 23 may extend to be disposed between the mold layers 13 in the first direction D1.

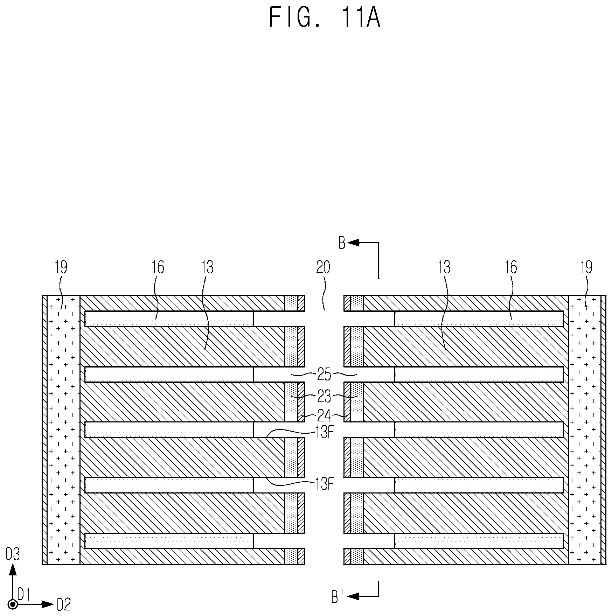

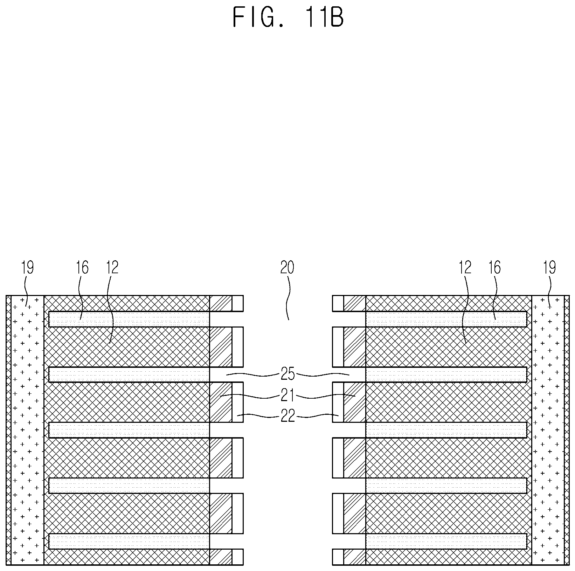

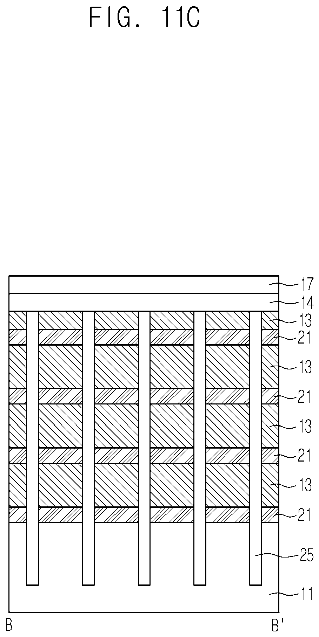

FIG. 11A is a plan view illustrating the structure at the mold layer level for describing the partial recessing of the sacrificial isolation layers 16. FIG. 11B is a plan view illustrating the structure at the sacrificial mold layer level for describing the partial recessing of the sacrificial isolation layers 16. FIG. 11C is a cross-sectional view of the structure taken along line B-B' illustrated in FIG. 11A.

Referring to FIGS. 11A to 11C, the sacrificial isolation layers 16 may be selectively recessed horizontally in the second direction D2 from the first linear opening 20. Accordingly, vertical recesses 25 extending vertically in the first direction D1 may be formed between the first side fillers 21. The vertical recesses 25 may be disposed between the sacrificial mold layers 12 and between the mold layers 13 in the third direction D3. In some embodiments, after recessing the sacrificial isolation layers 16, deposition and recessing of oxide (or nitride) may be additionally performed to gap-fill voids which are present in the sacrificial isolation layers 16.

Side surfaces 13F of the mold layers 13 may be partially exposed in the third direction D3 by the vertical recesses 25. In addition, side surfaces of the first and second side fillers 21 and 22 may all be exposed.

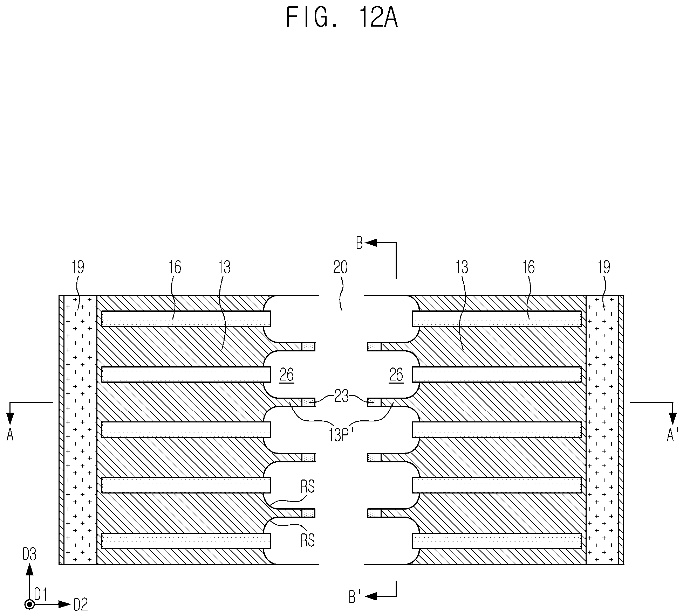

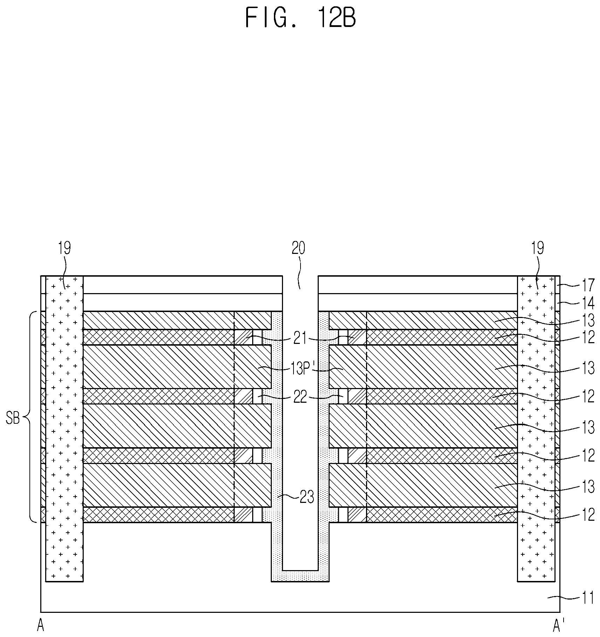

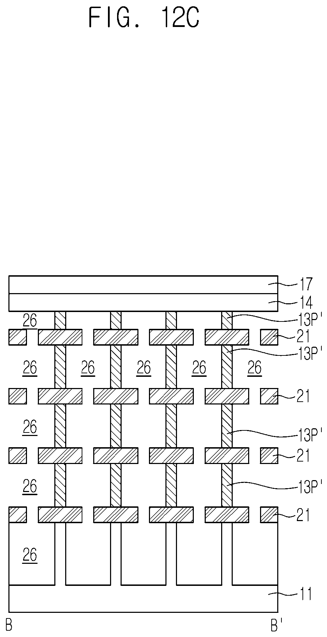

FIG. 12A is a plan view illustrating the structure at the mold layer level for describing the side recessing of the mold layers 13. FIG. 12B is a cross-sectional view of the structure taken along line A-A' illustrated in FIG. 12A. FIG. 12C is a cross-sectional view of the structure taken along line B-B' illustrated in FIG. 12A.

Referring to FIGS. 12A to 12C, side recessing may be performed on the side surfaces 13F of the mold layers 13 and the sacrificial sheet layers 23 in the third direction D3 through the vertical recesses 25 to form curved target sheets 13P' having curved profiles and extending vertical recesses 26. Each of the extending vertical recesses 26 may be disposed between the curved target sheets 13P' in the third direction D3. The extending vertical recesses 26 may have a structure in which the vertical recesses 25 extend in the third direction D3.

The curved target sheets 13P' may include curved side surfaces RS that are horizontally recessed in the third direction D3. A process for forming the curved target sheets 13P' may be referred to as a "first side recessing process". The first side recessing process may be performed in the third direction D3. The first side recessing process may include a wet or dry etch process for silicon layers. In some embodiments, the first side recessing process may include an oxidation process. For example, the side surfaces 13F of the mold layers 13 and the sacrificial sheet layers 23 may be oxidized in the third direction D3, and side profiles of the oxidized mold layers 13 may have curved profiles.

The sacrificial sheet layers 23 and the additional sacrificial sheet layers 24 may prevent bending of the curved target sheets 13P' and the mold layers 13 during the first side recessing process.

Subsequently, the additional sacrificial sheet layers 24 may be removed.

Referring to FIG. 12C, each of the first side fillers 21 may be disposed between the curved target sheets 13P' in the first direction D1.

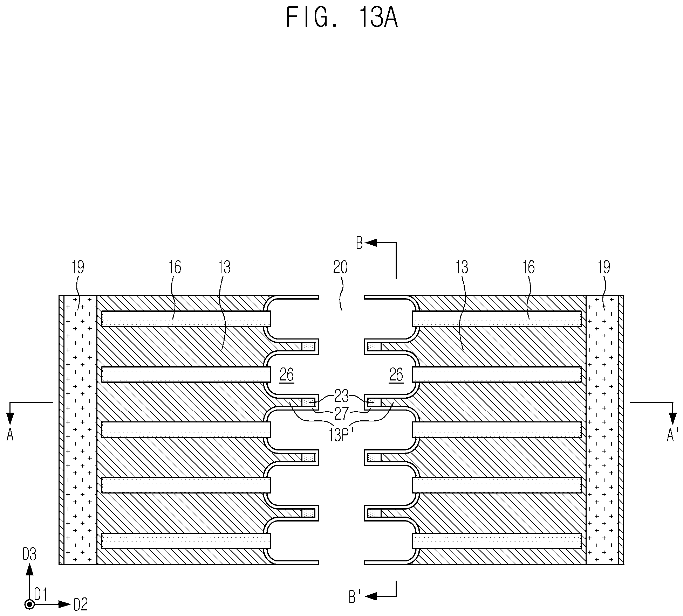

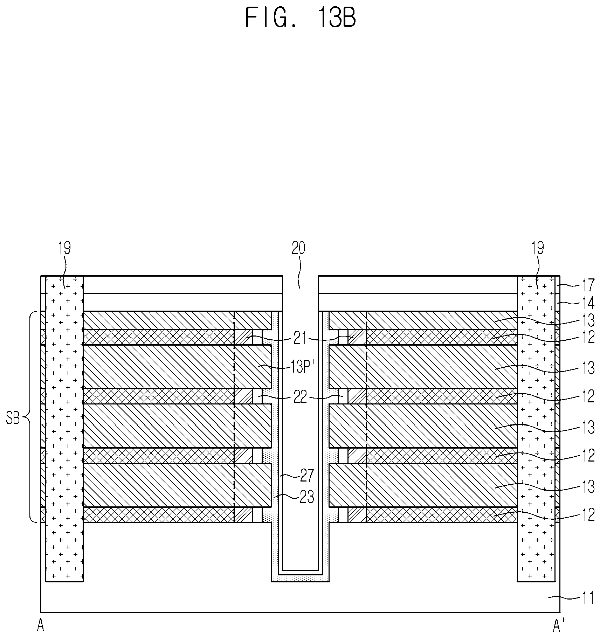

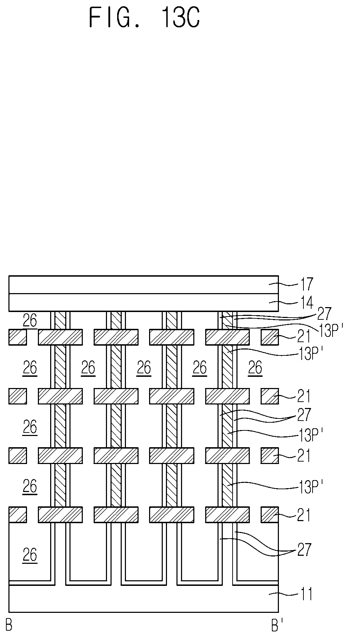

FIG. 13A is a plan view illustrating the structure at the mold layer level for describing a method of forming sacrificial sheet dielectric layers 27. FIG. 13B is a cross-sectional view of the structure taken along line A-A' illustrated in FIG. 13A. FIG. 13C is a cross-sectional view of the structure taken along line B-B' illustrated in FIG. 13A.

Referring to FIGS. 13A to 13C, the sacrificial sheet dielectric layers 27 may be formed on side surfaces of the curved target sheets 13P' and surfaces of the sacrificial sheet layers 23. The sacrificial sheet dielectric layers 27 may be formed by oxidizing the side surfaces of the curved target sheets 13P' and the surfaces of the sacrificial sheet layers 23. In some embodiments, the sacrificial sheet dielectric layers 27 may be formed by deposition and oxidation processes for silicon oxide. The sacrificial sheet dielectric layers 27 may each include, for example, silicon oxide. A combination of the sacrificial sheet dielectric layers 27 and the second side fillers 22 may form a structure surrounding outer walls of the sacrificial sheet layers 23.

When formation of the additional sacrificial sheet dielectric layer 24 is omitted, the processes illustrated in FIGS. 12A to 12C may be omitted. In this case, extending vertical recesses 26 may be formed simultaneously during a subsequent process in which the sacrificial sheet dielectric layers 27 are removed.

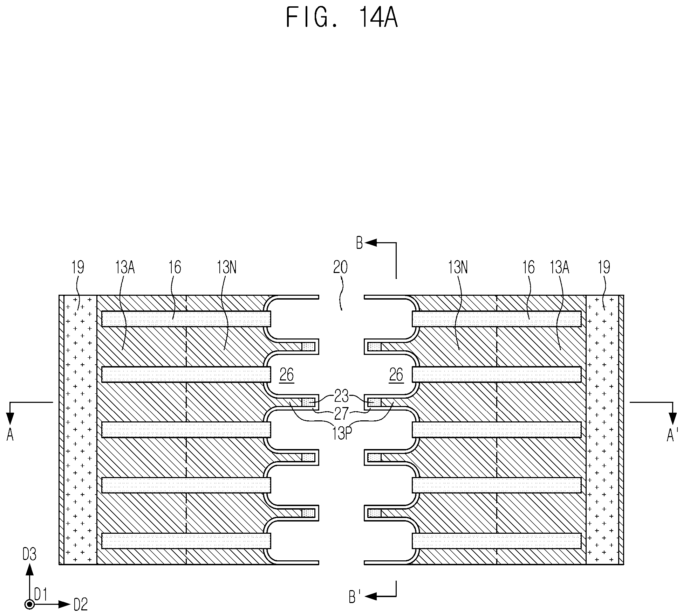

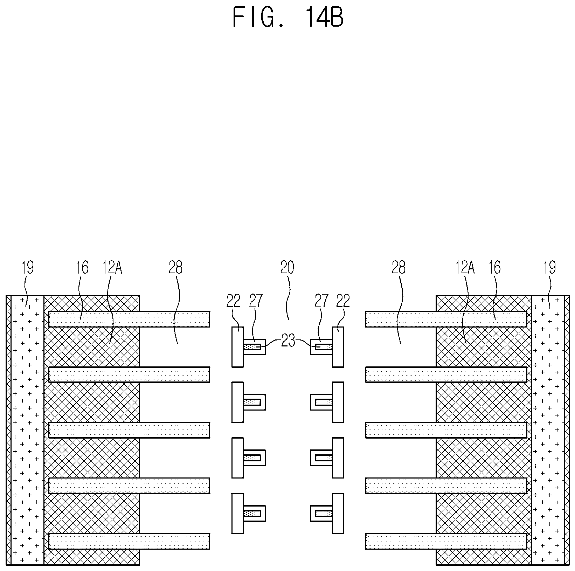

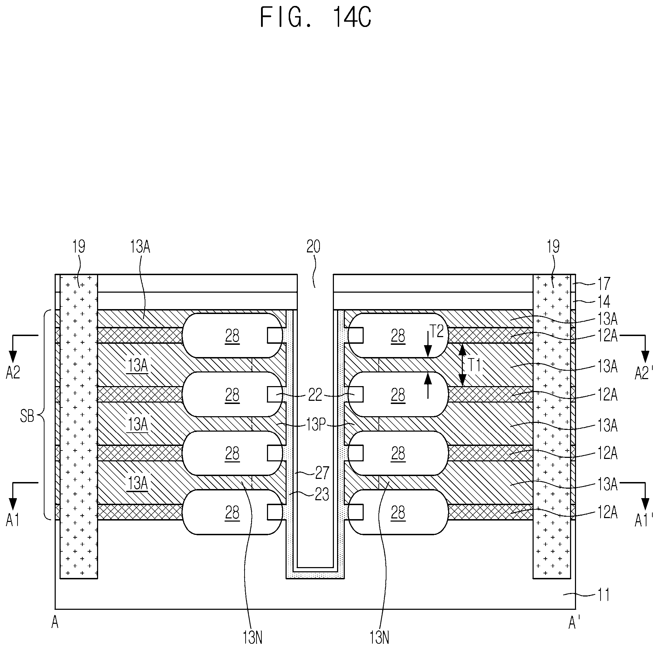

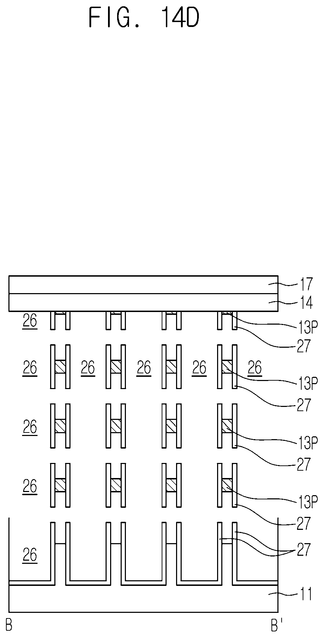

FIG. 14A is a plan view illustrating the structure at the mold layer level for describing a method of forming horizontal sheets 13N. FIG. 14B is a plan view illustrating the structure at the sacrificial mold layer level for describing the method of forming the horizontal sheets 13N. FIG. 14C is a cross-sectional view of the structure taken along line A-A' illustrated in FIG. 14A. FIG. 14D is a cross-sectional view of the structure taken along line B-B' illustrated in FIG. 14A. FIG. 14A may be a plan view illustrating the structure taken along line A1-A1' illustrated in FIG. 14C. FIG. 14B may be a plan view illustrating the structure taken along line A2-A2' illustrated in FIG. 14C.

Referring to FIGS. 14A to 14D, the first side fillers 21 may be removed through the extending vertical recesses 26, and then the upper and lower surfaces of the curved target sheets 13P' may be exposed.

Subsequently, a second side recessing process may be performed on the curved target sheets 13P', the sacrificial mold layers 12 and the mold layers 13. The second side recessing process may be performed in the first direction D1 and the second direction D2. The second side recessing process may include a wet or dry etch process for silicon layers and silicon germanium layers.

The body sheets 13A and the horizontal sheets 13N may be formed through the second side recessing process applied to the mold layers 13. Similarly, curved sheets 13P may be formed by the second side recessing process for the curved target sheets 13P'. The curved sheets 13P may be disposed on one side of the horizontal sheets 13N. The body sheets 13A, the horizontal sheets 13N and the curved sheets 13P may be integral, i.e., form a single continuous structure. The combination of the body sheet 13A, the horizontal sheet 13N and the curved sheet 13P may be referred to as a "sheet stack".

As described above, a portion of the mold stack SB may be exposed to a plurality of side recessing processes to form the sheet stack. The sheet stack may include the body sheets 13A, the horizontal sheets 13N extending from the body sheets 13A, and the curved sheets 13P extending from the horizontal sheets 13N.

The second side recessing process for the sacrificial mold layers 12 may be performed in the second direction D2. The second side recessing process for the mold layers 13 may be performed in the first direction D1. The second side recessing process for the curved target sheets 13P' may be performed in the first direction D1 and the second direction D2.

The second side recessing process for the mold layers 13 may use the wet etch process or the dry etch process. Each of the body sheets 13A may maintain an original thickness T1, and each of the horizontal sheets 13N may have a thickness T2 thinner than the original thickness T1. Horizontal lengths of the body sheets 13A in the second direction D2 may be the same as or different from horizontal lengths of the horizontal sheets 13N in the second direction D2. The horizontal sheets 13N may be referred to as "flat plate-shaped sheets".

The second side recessing process may be referred to as a "thinning process" or a "trimming process" for the mold layers 13. To form the horizontal sheets 13N, upper and lower surfaces of the mold layers 13 may be recessed. The horizontal sheets 13N may be referred to as "thin-body active layers". The horizontal sheets 13N may each include a monocrystalline silicon layer. The second side recessing process for forming the horizontal sheets 13N may use an etchant having an etch selectivity with respect to the sacrificial mold layer 12 and the sacrificial isolation layer 16.

The horizontal sheets 13N may be formed by the trimming process (or a partial recessing process) for the mold layers 13 as described above, and each of inter-nano sheet recesses 28 may be formed between the horizontal sheets 13N disposed vertically. Upper and lower surfaces of the horizontal sheets 13N may each include a flat surface. Boundary portions of the body sheets 13A and the horizontal sheets 13N may be vertical or have curvature. Each of sacrificial mold layers 12A may remain between the body sheets 13A stacked vertically.

During the second side recessing process, the second side fillers 22 and the sacrificial sheet dielectric layers 27 may not be removed. The second side fillers 22 and the sacrificial sheet dielectric layers 27 may prevent the sacrificial sheet layers 23 from being exposed to the second side recessing process. A vertical arrangement of the curved sheets 13P disposed in the first direction D1 may be coupled in common to the sacrificial sheet layers 23. The sacrificial sheet layers 23 may cover outer surfaces of the curved sheets 13P. The sacrificial sheet layers 23 may serve to support the curved sheets 13P in the first direction D1. Portions of the sacrificial sheet layers 23 may be disposed between the curved sheets 13P in the first direction D1.

As described above, a three-dimensional array of the horizontal sheets 13N and a three-dimensional array of the curved sheets 13P may be formed by the second side recessing process.

The three-dimensional array of the horizontal sheets 13N may include vertical and horizontal arrays of the horizontal sheets 13N. The vertical array of the horizontal sheets 13N may include the horizontal sheets 13N disposed vertically in the first direction D1. The horizontal array of the horizontal sheets 13N may include the horizontal sheets 13N disposed horizontally in the third direction D3.

The vertical and horizontal arrays of the horizontal sheets 13N may be formed by the second side recessing process. Similarly, the vertical and horizontal arrays of the curved sheets 13P may be formed by the second side recessing process. Additionally, inter-nano sheet recesses 28 may be formed by the second side recessing process to expose all of the horizontal sheets 13N within the horizontal array.

The curved sheets 13P may include curved side surfaces (refer to reference symbol "RS" of FIG. 12A) in the same manner as the curved target sheets 13P'. The horizontal sheets 13N may include flat side surfaces.

The sacrificial sheet layers 23 may prevent bending of the curved sheets 13P and bending of the horizontal sheets 13N during the second side recessing process.

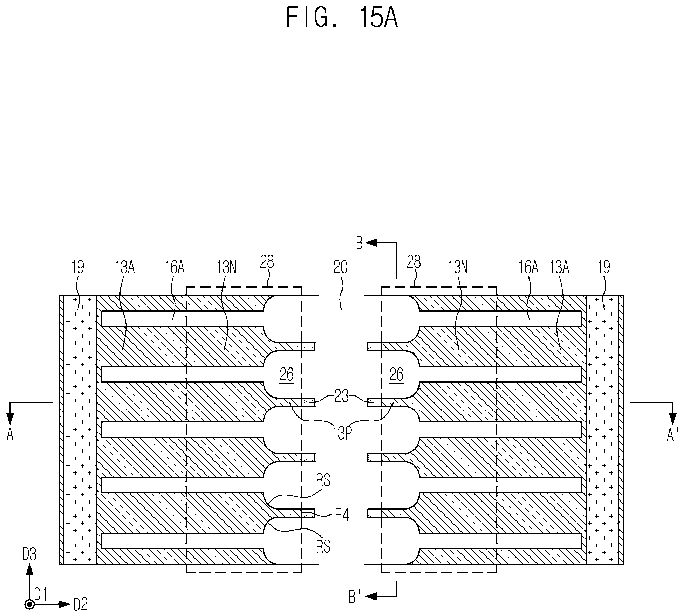

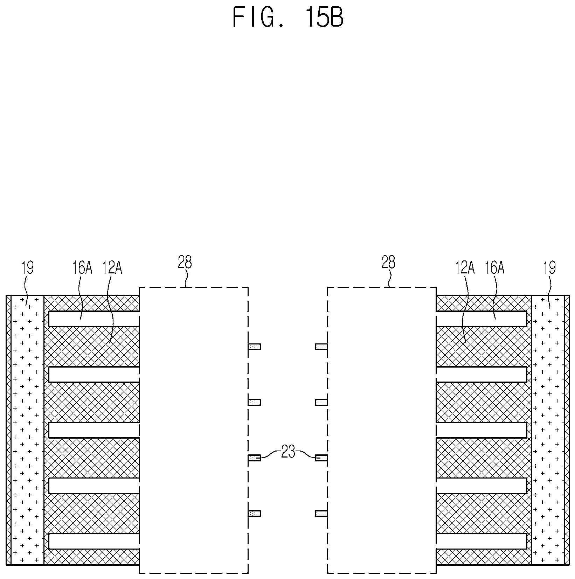

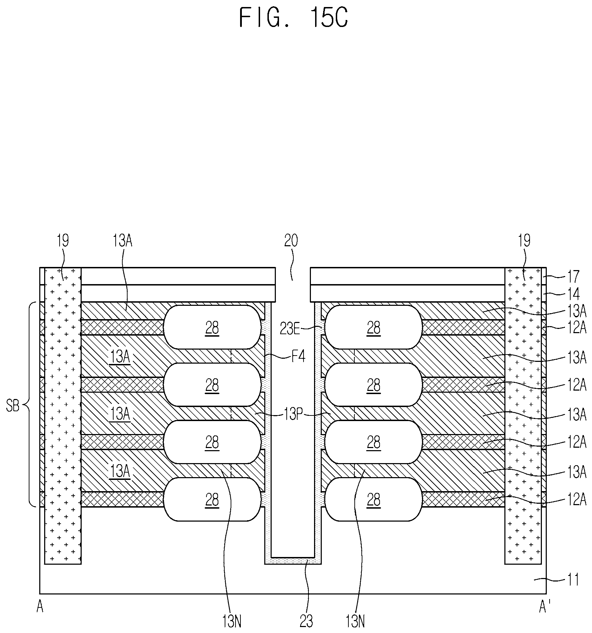

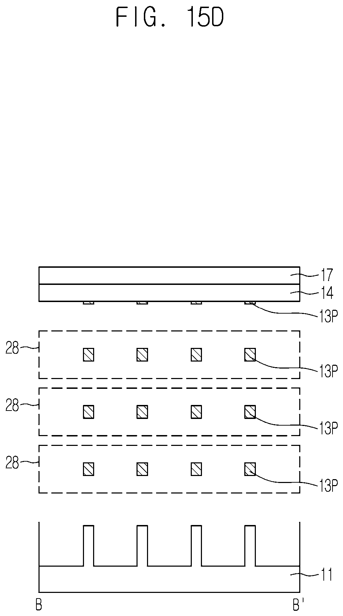

FIG. 15A is a plan view illustrating the structure at a horizontal sheet level for describing a method of forming sacrificial isolation layer-level openings 16A. FIG. 15B is a plan view illustrating the structure at the sacrificial mold layer level for describing the method of forming the sacrificial isolation layer-level openings 16A. FIG. 15C is a cross-sectional view of the structure taken along line A-A' illustrated in FIG. 15A. FIG. 15D is a cross-sectional view of the structure taken along line B-B' illustrated in FIG. 15A.

Referring to FIGS. 15A to 15D, the sacrificial isolation layers 16 may be selectively stripped through the extending vertical recesses 26 and the inter-nano sheet recesses 28. The sacrificial sheet dielectric layer 27 and the second side fillers 22 may be removed while or after the sacrificial isolation layers 16 are stripped. Accordingly, each of the sacrificial isolation layer-level openings 16A may be formed between the body sheets 13A in the third direction D3.

Side surfaces of the sacrificial mold layers 12A, side surfaces of the body sheets 13A and side surfaces of the horizontal sheets 13N may be exposed in the third direction D3 by the sacrificial isolation layer-level openings 16A.

The sacrificial sheet layers 23 may cover wide side surfaces F4 of the curved sheets 13P and extend vertically in the first direction D1. In addition, the sacrificial sheet layers 23 may include extension portions 23E disposed between the curved sheets 13P along the first direction D1. The curved side surfaces RS of the curved sheets 13P may be exposed through the extending vertical recesses 26 and the inter-nano sheet recesses 28.

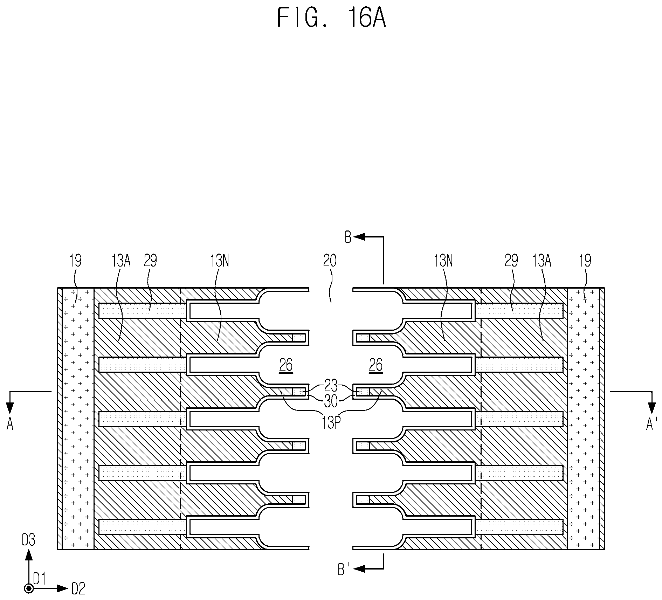

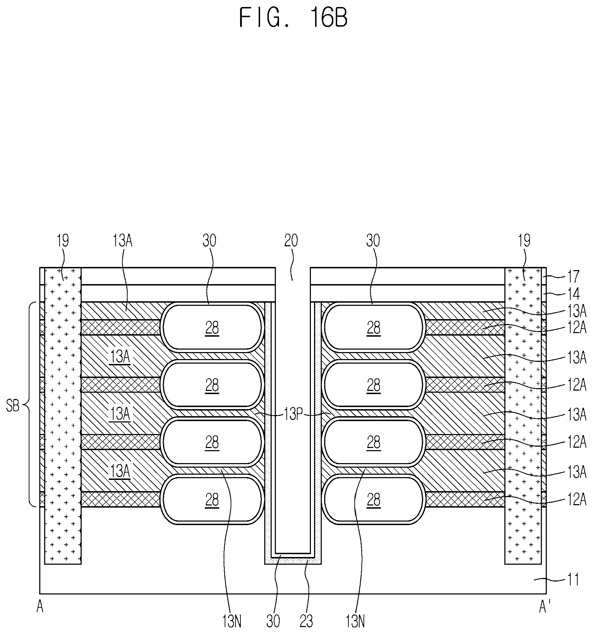

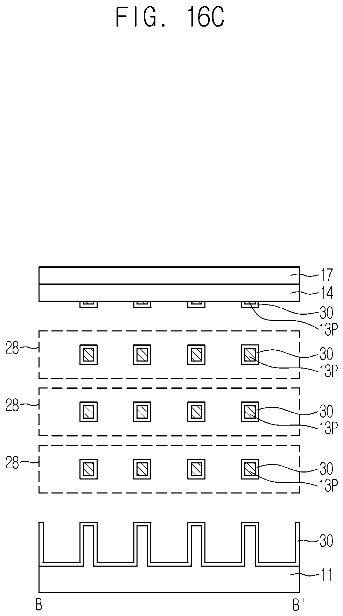

FIG. 16A is a plan view illustrating the structure at the horizontal sheet level for describing a method of forming a nano sheet dielectric layer 30. FIG. 16B is a cross-sectional view of the structure taken along line A-A' illustrated in FIG. 16A. FIG. 16C is a cross-sectional view of the structure taken along line B-B' illustrated in FIG. 16A.

Referring to FIGS. 16A to 16C, first inter-cell dielectric layers 29 may be formed in the sacrificial isolation layer-level openings 16A. The first inter-cell dielectric layers 29 may each include a dielectric material. The first inter-cell dielectric layers 29 may each include, for example, silicon oxide, silicon nitride, silicon carbon oxide, or a combination thereof. Forming the first inter-cell dielectric layers 29 may include forming a dielectric material that fills the sacrificial isolation layer-level openings 16A and performing an etch-back process on the dielectric material. In some embodiments, the first inter-cell dielectric layers 29 may be formed by the side recessing of the sacrificial isolation layer-level openings 16A.

The first inter-cell dielectric layers 29 may fill portions of the sacrificial isolation layer-level openings 16A. The side surfaces of the sacrificial mold layers 12A and the side surfaces of the body sheets 13A may be covered by the first inter-cell dielectric layers 29 in the third direction D3. The first inter-cell dielectric layers 29 may expose the side surfaces of the horizontal sheets 13N. The first inter-cell dielectric layers 29 may be referred to as "inter-cell isolation layers".

During the recessing process for forming the first inter-cell dielectric layers 29, the second side fillers 22 and the sacrificial sheet dielectric layer 27 may be removed.

Subsequently, the nano sheet dielectric layer 30 may be formed on exposed portions of the horizontal sheets 13N. The nano sheet dielectric layer 30 may be referred to as a "gate dielectric layer".

The nano sheet dielectric layer 30 may be formed by oxidizing the surfaces of the horizontal sheets 13N and the surfaces of the curved sheets 13P. In some embodiments, the nano sheet dielectric layer 30 may be formed by deposition and oxidation processes for silicon oxide. The nano sheet dielectric layer 30 may include silicon oxide, silicon nitride, metal oxide, metal oxynitride, metal silicate, a high-k material, a ferroelectric material, an anti-ferroelectric material, or a combination thereof. The nano sheet dielectric layer 30 may include silicon dioxide (SiO₂), silicon nitride (Si₃N₄), hafnium dioxide (HfO₂), aluminum oxide (Al₂O₃), zirconium dioxide (ZrO₂), aluminum oxynitride (AlON), hafnium oxynitride (HfON), hafnium silicate (HfSiO), hafnium silicon oxynitride (HfSiON), or a combination thereof. The nano sheet dielectric layer 30 may be formed on all surfaces of the horizontal sheets 13N.

While the nano sheet dielectric layer 30 is formed, portions of the sacrificial sheet layers 23 may be oxidized. For example, the nano sheet dielectric layer 30 may also be formed on the sacrificial sheet layers 23.

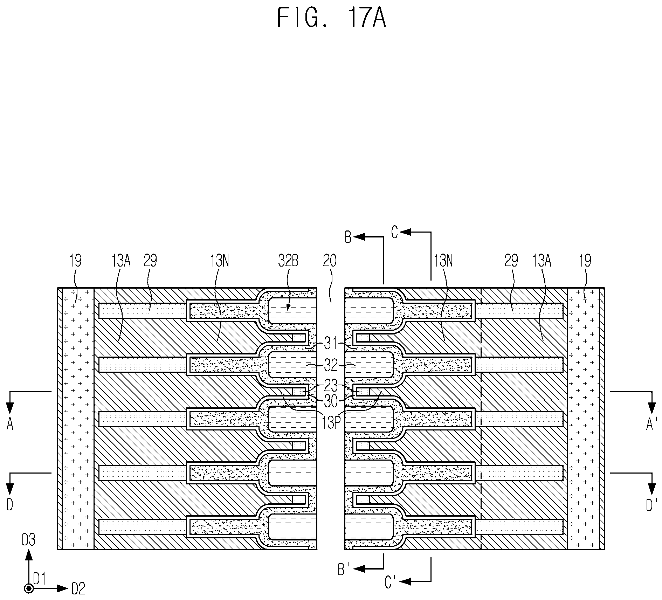

FIG. 17A is a plan view illustrating the structure at the horizontal sheet level for describing a method of forming a first spacer layer 31.

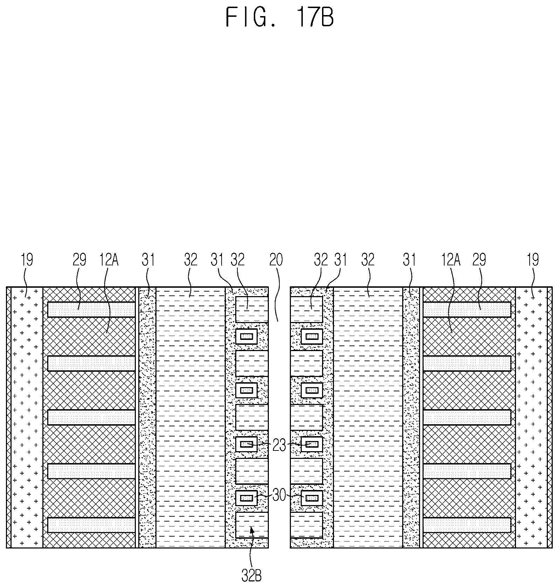

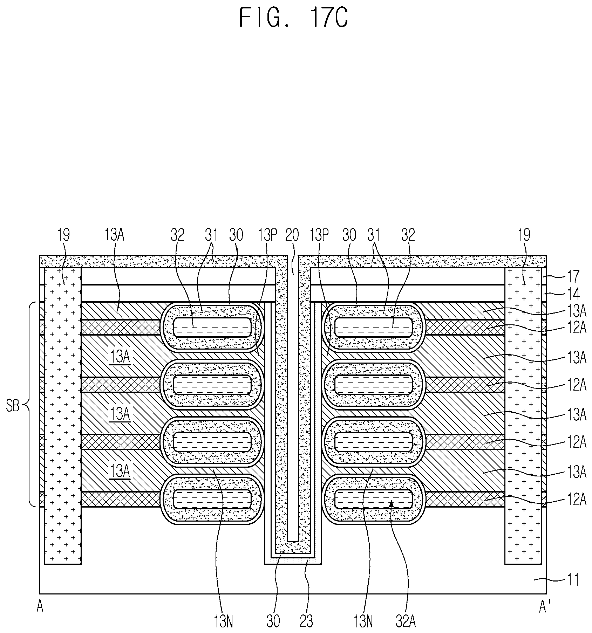

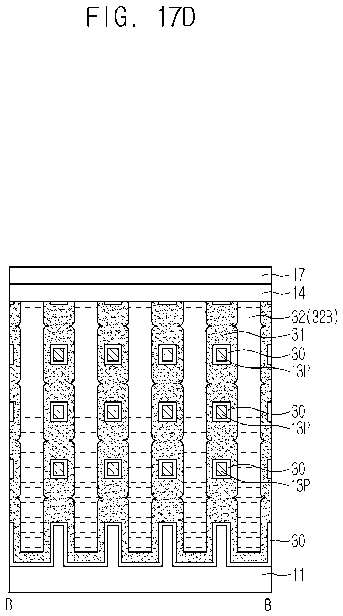

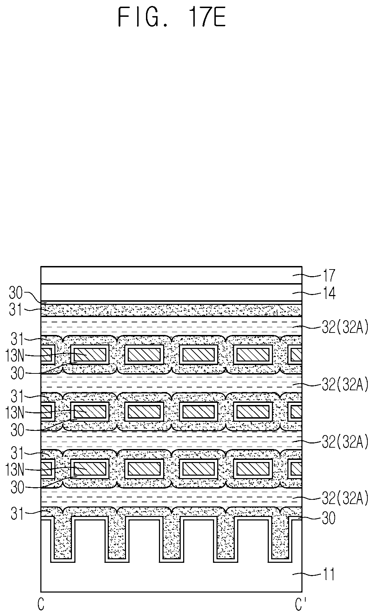

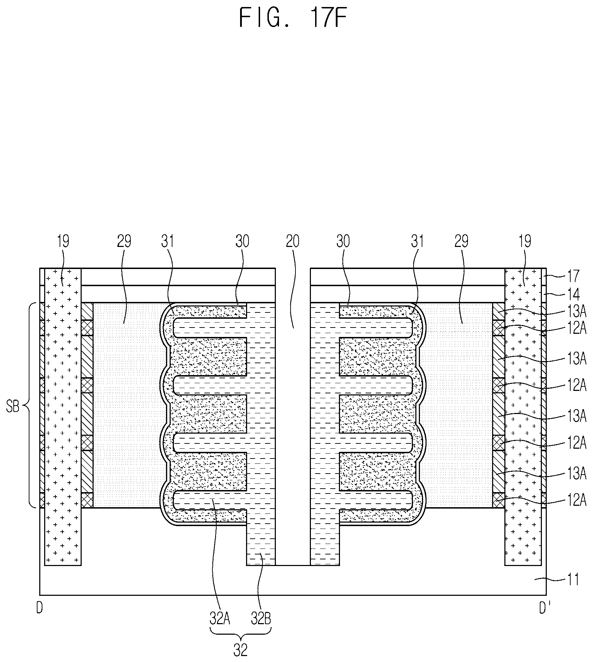

FIG. 17B is a plan view illustrating the structure at the sacrificial mold layer level for describing the method of forming the first spacer layer 31. FIG. 17C is a cross-sectional view of the structure taken along line A-A' illustrated in FIG. 17A. FIG. 17D is a cross-sectional view of the structure taken along line B-B' illustrated in FIG. 17A. FIG. 17E is a cross-sectional view of the structure taken along line C-C' illustrated in FIG. 17A. FIG. 17F is a cross-sectional view of the structure taken along line D-D' illustrated in FIG. 17A.

Referring to FIGS. 17A to 17F, the first spacer layer 31 may be formed on the nano sheet dielectric layer 30. The first spacer layer 31 may include, for example, silicon nitride. The first spacer layer 31 may surround and cover the horizontal sheets 13N on the nano sheet dielectric layer 30. The nano sheet dielectric layer 30 and the first spacer layer 31 may also be formed on the surface of the substrate 11.

The first spacer layer 31 may surround the horizontal sheets 13N in the first direction D1 and also surround portions of the curved sheets 13P and portions of the sacrificial sheet layers 13 in the second direction D2.

Second inter-cell dielectric layers 32 may be formed on the first spacer layer 31. The second inter-cell dielectric layers 32 may be referred to as "inter-cell horizontal dielectric layers". The second inter-cell dielectric layers 32 may each include, for example, silicon oxide. Each of the second inter-cell dielectric layers 32 may be disposed between the horizontal sheets 13N in the first direction D1. Each of the second inter-cell dielectric layers 32 may be disposed between the curved sheets 13P in the third direction D3. Each of the second inter-cell dielectric layers 32 may be disposed between the sacrificial sheet layers 23 in the third direction D3. Deposition and cutting of a dielectric material may be performed to form the second inter-cell dielectric layers 32. Each of the second inter-cell dielectric layers 32 may include a horizontal segment 32A (see FIG. 17C) and a vertical segment 32B (see FIG. 17B). The horizontal segment 32A and the vertical segment 32B may be dielectric materials having an integral structure. The horizontal segment 32A of the second inter-cell dielectric layer 32 may horizontally extend in the third direction D3, and the vertical segment 32B of the second inter-cell dielectric layer 32 may vertically extend in the first direction D1. The horizontal segment 32A of the second inter-cell dielectric layer 32 may be disposed between the horizontal sheets 13N in the first direction D1, and the vertical segment 32B of the second inter-cell dielectric layer 32 may be disposed between the curved sheets 13P and between the sacrificial sheet layers 23 in the third direction D3.

As described above, the horizontal segment 32A of the second inter-cell dielectric layer 32 may be disposed between the horizontal sheets 13N in the first direction D1, and the vertical segment 32B of the second inter-cell dielectric layer 32 may be disposed between the curved sheets 13P and between the sacrificial sheet layers 23 in the third direction D3.

In some embodiments, to form the first inter-cell dielectric layers 29, after the sacrificial isolation layers 16 are stripped, the nano sheet dielectric layer 30, the first spacer layer 31 and the second inter-cell dielectric layer 32 may be formed simultaneously without performing a separate process. For example, the first inter-cell dielectric layers 29 may each include a stack of the nano sheet dielectric layer 30 and the first spacer layer 31.

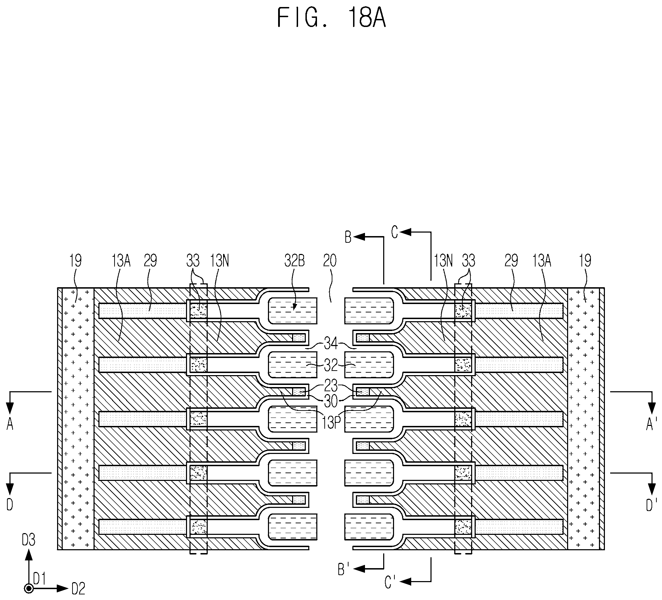

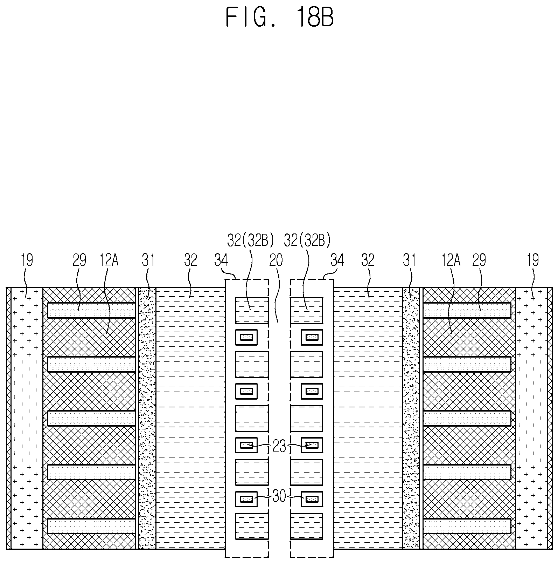

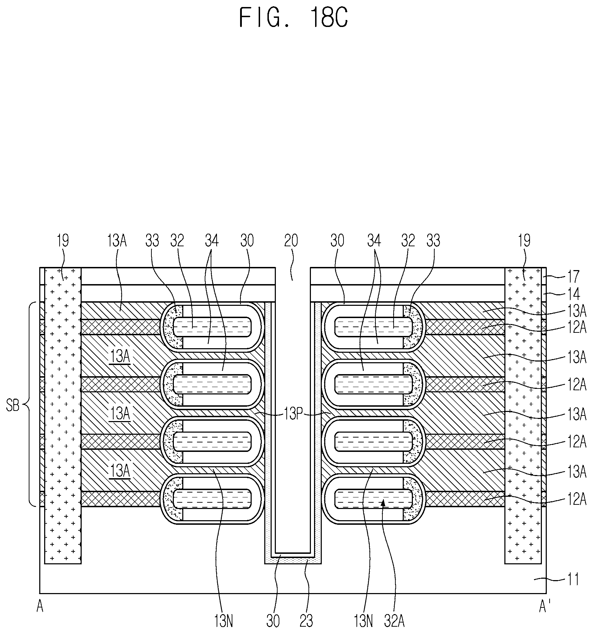

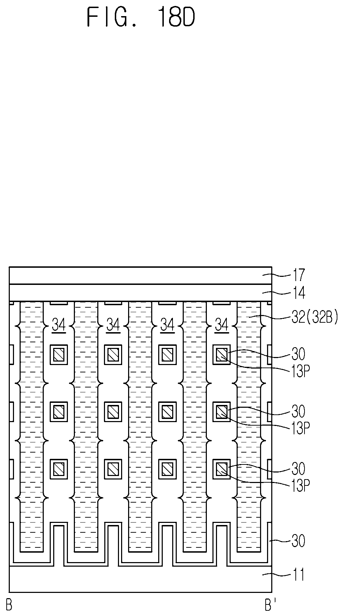

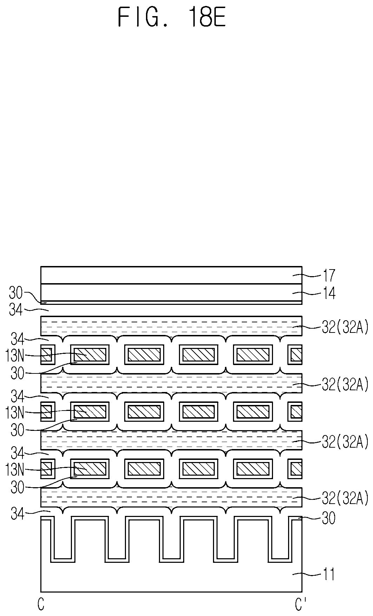

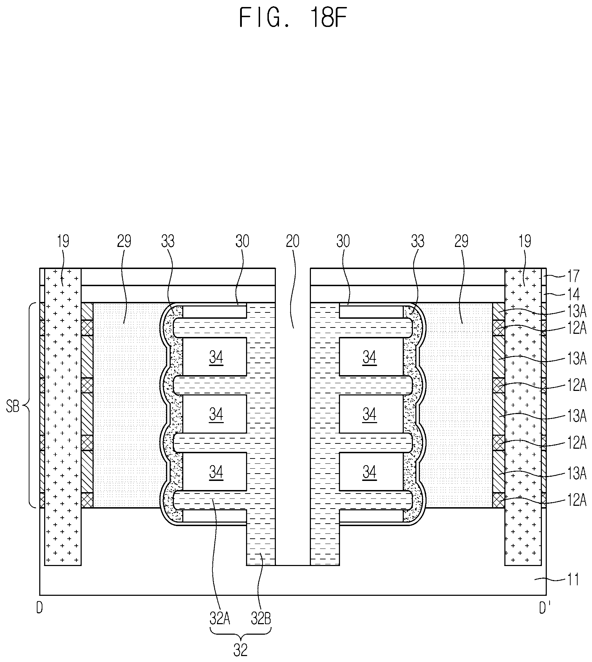

FIG. 18A is a plan view illustrating the structure at the horizontal sheet level for describing a method of forming a first spacer 33. FIG. 18B is a plan view illustrating the structure at the sacrificial mold layer level for describing a method of forming the first spacer 33. FIG. 18C is a cross-sectional view of the structure taken along line A-A' illustrated in FIG. 18A. FIG. 18D is a cross-sectional view of the structure taken along line B-B' illustrated in FIG. 18A. FIG. 18E is a cross-sectional view of the structure taken along line C-C' illustrated in FIG. 18A. FIG. 18F is a cross-sectional view of the structure taken along line D-D' illustrated in FIG. 18A.

Referring to FIGS. 18A to 18F, the first spacer layers 31 may be recessed in the second direction D2 through the first linear opening 20. The remaining first spacer layers may become the first spacer 33. The first spacer 33 may correspond to the first spacer SP1 as described above with reference to FIGS. 3B and 4A.

As the first spacer 33 is formed, linear surrounding recesses 34 surrounding the horizontal sheets 13N may be formed on the nano sheet dielectric layer 30. Each of the second inter-cell dielectric layers 32 may be disposed between the linear surrounding recesses 34 that are vertically disposed. The linear surrounding recesses 34 may extend in the third direction D3. A portion of the nano sheet dielectric layer 30 may be exposed by the linear surrounding recesses 34. All side surfaces of the vertical segments 32B of the second inter-cell dielectric layers 32 may be exposed by the linear surrounding recesses 34 (refer to FIG. 18B). Three side surfaces of the horizontal segments 32A of the second inter-cell dielectric layers 32 may be exposed by the linear surrounding recesses 34 (refer to FIG. 18C).

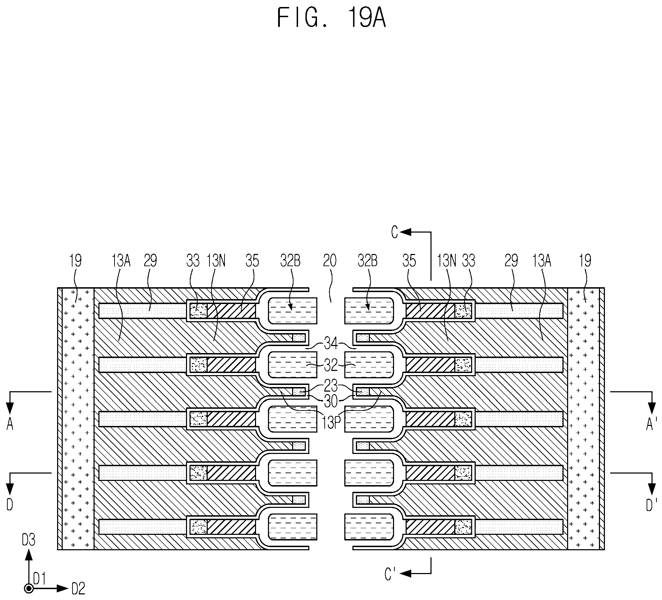

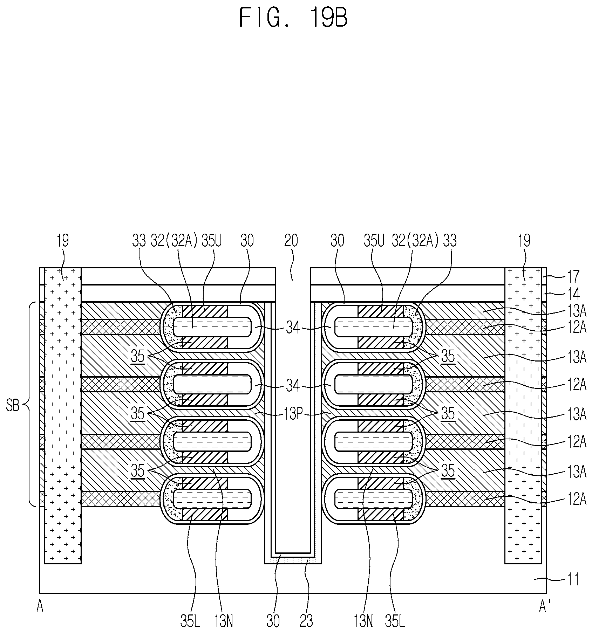

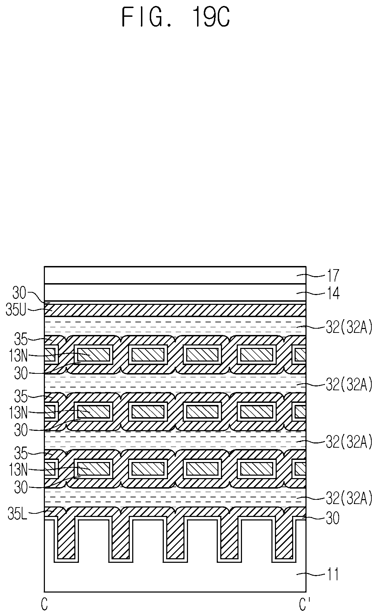

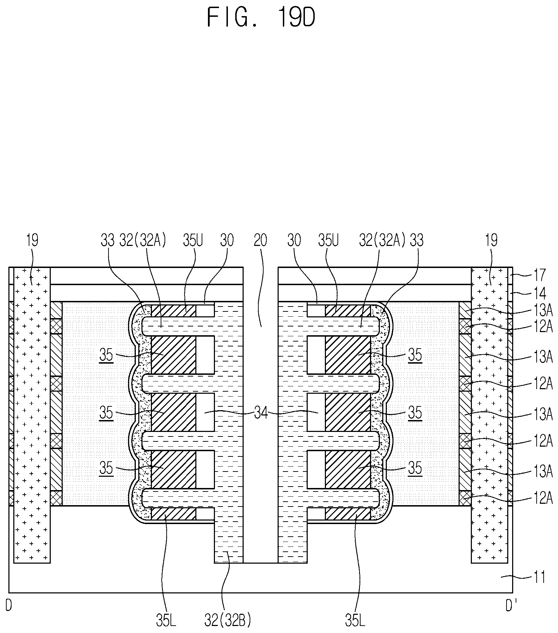

FIG. 19A is a plan view illustrating the structure at the horizontal sheet level for describing a method of forming first conductive lines 35. FIG. 19B is a cross-sectional view of the structure taken along line A-A' illustrated in FIG. 19A. FIG. 19C is a cross-sectional view of the structure taken along line C-C' illustrated in FIG. 19A. FIG. 19D is a cross-sectional view of the structure taken along line D-D' illustrated in FIG. 19A.

Referring to FIGS. 19A to 19D, the first conductive lines 35 may be formed to horizontally and partially fill the linear surrounding recesses 34. The first conductive lines 35 may horizontally extend in the third direction D3. The first conductive lines 35 may correspond to the first conductive lines WL as described above with reference to FIGS. 3A, 3B, 4A, 4C and 4D.

Forming the first conductive lines 35 may include depositing a conductive material that fills the linear surrounding recesses 34 on the nano sheet dielectric layer 30 and performing a horizontal etch-back process on the conductive material. Each of the first conductive lines 35 may simultaneously surround the horizontal sheets 13N at the same horizontal level in the third direction D3. The first conductive lines 35 may each include a metal-based material, a semiconductive material, or a combination thereof. The first conductive lines 35 may each include molybdenum, molybdenum nitride, ruthenium, titanium nitride, tungsten, polysilicon, or a combination thereof. For example, the first conductive lines 35 may each include a titanium nitride and tungsten (TiN/W) stack in which titanium nitride and tungsten are sequentially stacked. The first conductive lines 35 may each include an N-type work function material or a P-type work function material. The N-type work function material may have a low work function of approximately 4.5 eV or less, and the P-type work function material may have a high work function of approximately 4.5 eV or greater. The horizontal segments 32A of the second inter-cell dielectric layers 32 may be disposed between a plurality of first conductive lines 35 in the first direction D1. The first conductive lines 35 surrounding the horizontal sheets 13N may be referred to as "gate-all-around (GAA) electrodes". The horizontal sheets 13N may be referred to as "nano sheet channels", "nano wires", or "nano wire channels".

A lower-level dummy conductive line 35L may be formed on the surface of the substrate 11. An upper-level dummy conductive line 35U may be formed above an uppermost first conductive line 35. Each of the lower-level and upper-level dummy conductive lines 35L and 35U may have a non-surrounding shape.

As described above, the first conductive lines 35 may be formed to surround the horizontal sheets 13N in the vertical arrangement and be horizontally oriented. The horizontal segments 32A of the second inter-cell dielectric layers 32 may be disposed between the first conductive lines 35 in the first direction D1.

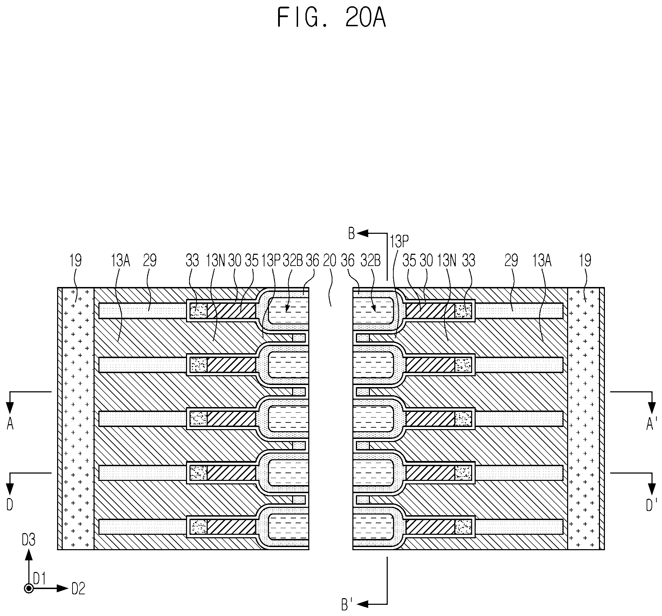

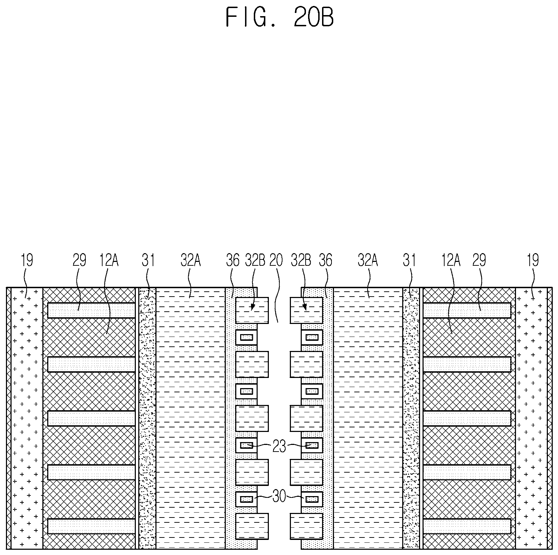

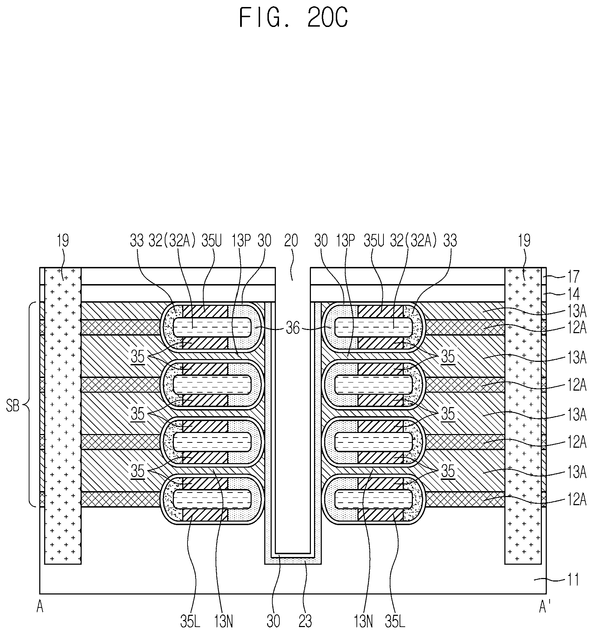

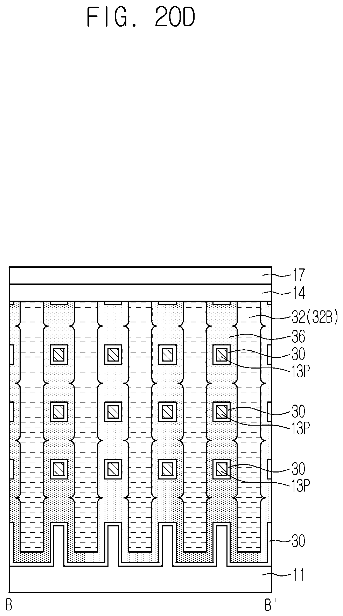

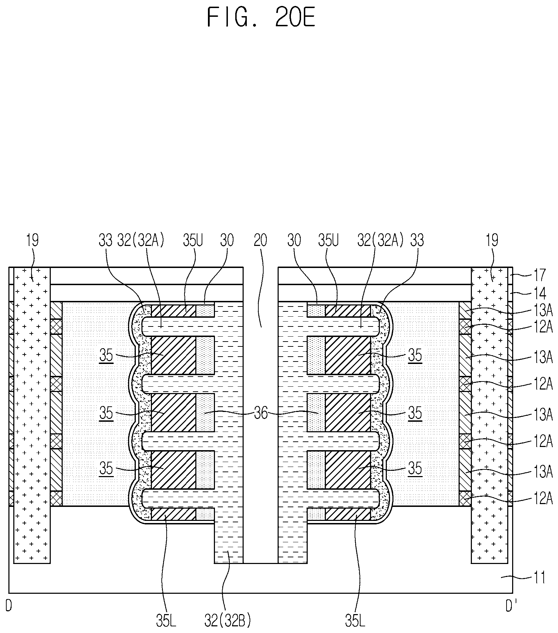

FIG. 20A is a plan view illustrating the structure at the horizontal sheet level for describing a method of forming a second spacer 36. FIG. 20B is a plan view illustrating the structure at the sacrificial mold layer level for describing the method of forming the second spacer 36. FIG. 20C is a cross-sectional view of the structure taken along line A-A' illustrated in FIG. 20A. FIG. 20D is a cross-sectional view of the structure taken along line B-B' illustrated in FIG. 20A. FIG. 20E is a cross-sectional view of the structure taken along line D-D' illustrated in FIG. 20A.

Referring to FIGS. 20A to 20E, the second spacer 36 may be formed on one side of each of the first conductive lines 35. The second spacer 36 may include silicon oxide, silicon nitride, silicon carbon oxide, an embedded air gap, or a combination thereof. A process for forming the second spacer 36 may include depositing a spacer material followed by an etch-back process applied on the spacer material. The second spacer 36 may include a stack of a silicon oxide liner and a silicon nitride liner, and a portion of the silicon nitride liner may protrude.

The second spacer 36 may be disposed on one side of each of the first conductive lines 35 and also extend in the third direction D3. The second spacer 36 may surround portions of the horizontal sheets 13N disposed at the same horizontal level in the third direction D3. The second spacer 36 may surround the curved sheets 13P disposed at the same horizontal level in the third direction D3. The second spacer 36 may surround the curved sheets 13P disposed in the first direction D1 (refer to FIG. 20D). The second spacer 36 may cover side surfaces of the horizontal segments 32A of the second inter-cell dielectric layers 32. In addition, the second spacer 36 may extend to cover side surfaces of the vertical segments 32B of the second inter-cell dielectric layers 32.

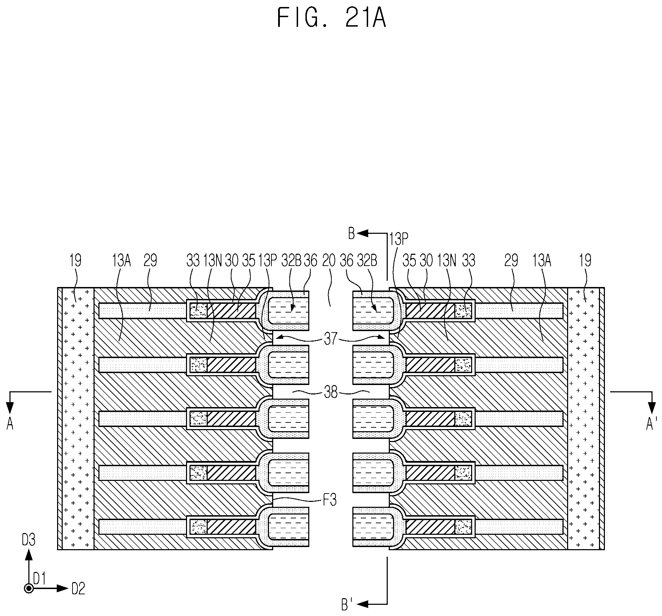

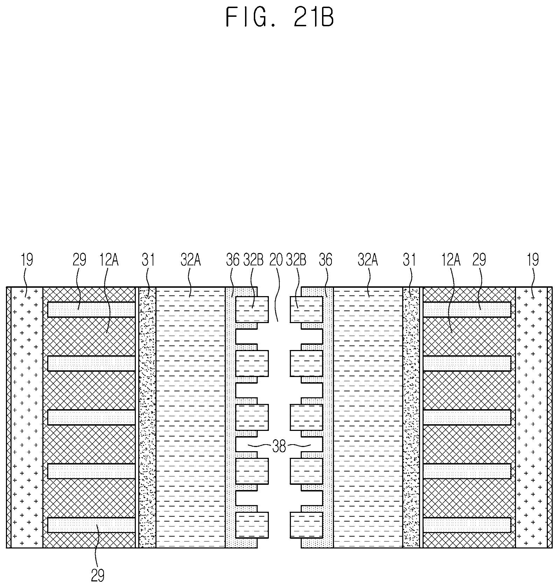

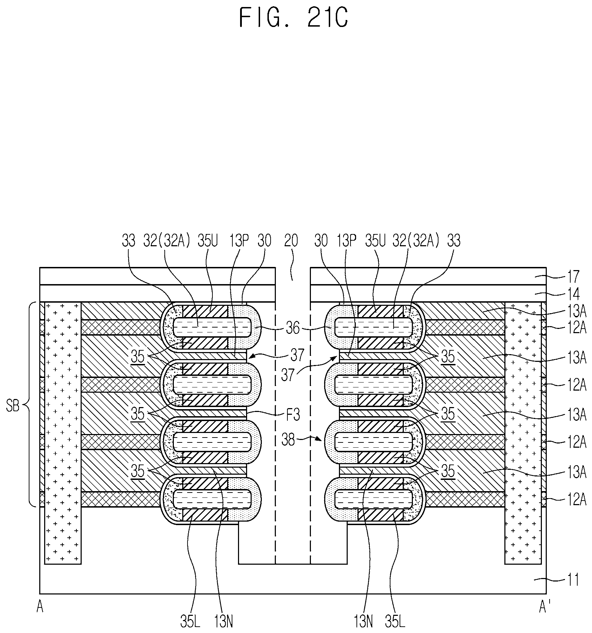

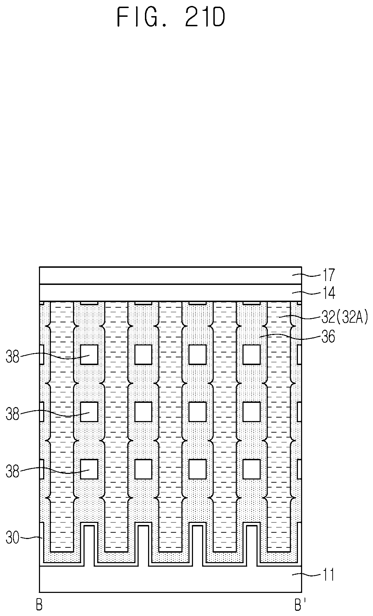

FIG. 21A is a plan view illustrating the structure at the horizontal sheet level for describing a method of forming contact level recesses 38. FIG. 21B is a plan view illustrating the structure at the sacrificial mold layer level for describing the method of forming the contact level recesses 38. FIG. 21C is a cross-sectional view of the structure taken along line A-A' illustrated in FIG. 21A. FIG. 21D is a cross-sectional view of the structure taken along line B-B' illustrated in FIG. 21A.

Referring to FIGS. 21A to 21D, one side of the curved sheets 13P may be recessed to form the contact level recesses 38. Forming the contact level recesses 38 may include cutting the nano sheet dielectric layer 30 from the first linear opening 20, removing the sacrificial sheet layers 23, and recessing one side of the curved sheets 13P. A series of processes for forming the contact level recesses 38 may be performed using the second spacer 36 and the vertical segment 32B of the second inter-cell dielectric layer 32 as barriers.

As the contact level recesses 38 are formed, horizontal lengths of the curved sheets 13P may be shortened, and the contact level recesses 38 may each include an inner side 37. For example, the wide side surfaces F4 of the curved sheets 13P may be recessed, and narrow side surfaces F3 may be formed. The narrow side surfaces F3 may also be referred to as narrow end side surfaces F3.

The inner sides 37 of the contact level recesses 38 may expose the narrow side surfaces F3 of the curved sheets 13P. The contact level recesses 38 may be formed to be self-aligned with the second spacer 36. The contact level recesses 38 may be referred to as "self-aligned contact openings".

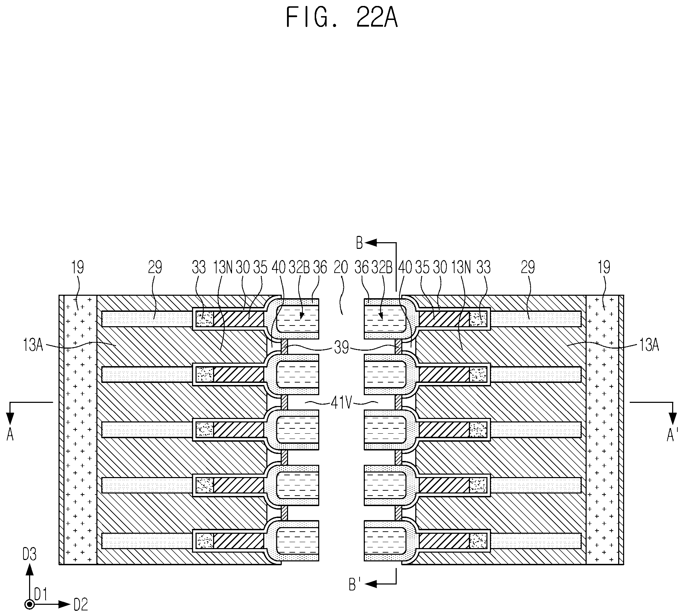

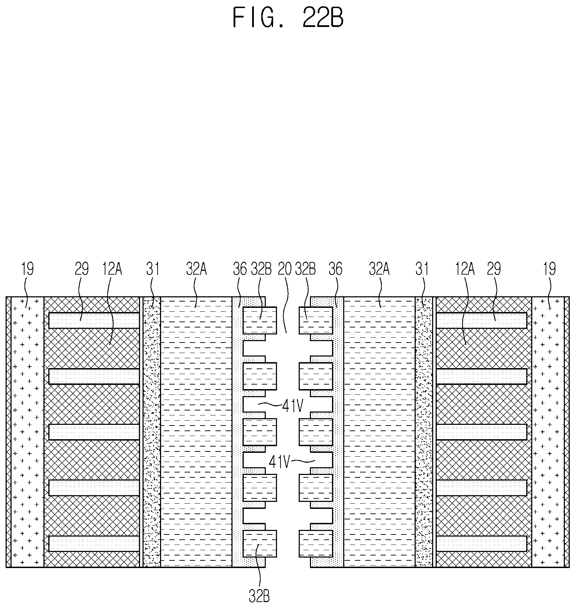

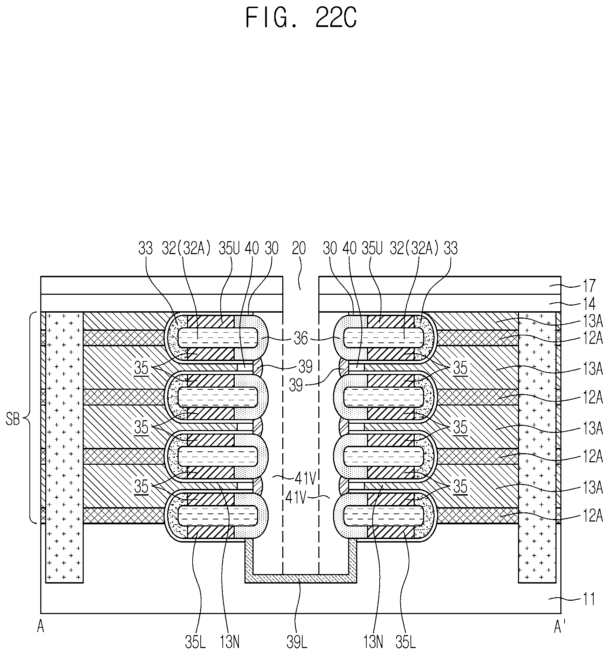

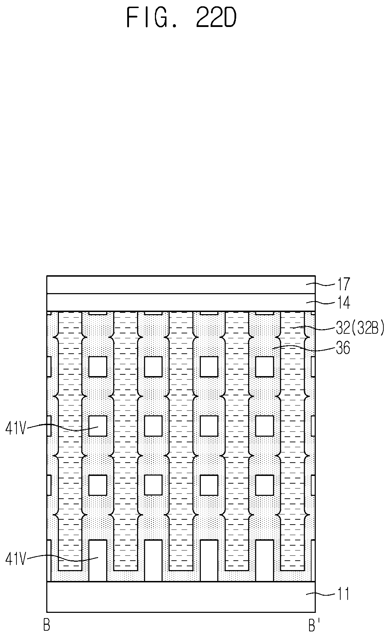

FIG. 22A is a plan view illustrating the structure at the horizontal sheet level for describing a method of forming first contact nodes 39. FIG. 22B is a plan view illustrating the structure at the sacrificial mold layer level for describing the method of forming the first contact nodes 39. FIG. 22C is a cross-sectional view of the structure taken along line A-A' illustrated in FIG. 22A. FIG. 22D is a cross-sectional view of the structure taken along line B-B' illustrated in FIG. 22A.

Referring to FIGS. 22A to 22D, the first contact nodes 39 may be formed on the inner sides 37 of the contact level recesses 38, for example, via selective epitaxial growth (SEG). For example, a semiconductive material may be grown from exposed surfaces of the curved sheets 13P through the SEG. The first contact nodes 39 may each include SEG Si. Because the curved sheets 13P include monocrystalline silicon, a silicon layer may be epitaxially grown along crystal surfaces of the exposed surfaces of the curved sheets 13P.

The first contact nodes 39 may include dopants. When a silicon layer is grown using the SEG, the dopants may be doped in situ. Accordingly, the first contact nodes 39 may be doped epitaxial layers. The first contact nodes 39 may each include an N-type dopant. The N-type dopant may include phosphorus, arsenic, antimony, or a combination thereof. The first contact nodes 39 may each include a phosphorus-doped silicon epitaxial layer formed by the SEG, i.e., doped SEG SiP.

First doped regions 40 may be formed in curved sheets 13P. A heat treatment process may be performed to form the first doped regions 40 for diffusing the dopants from the first contact nodes 39. In another method of forming the first doped regions 40, a gas phase doping method may be applied.

While the first contact nodes 39 are formed, dummy contact nodes 39L may be formed on the surface of the substrate 11. The first contact nodes 39 and the dummy contact nodes 39L may be made of the same material. For example, the dummy contact nodes 39L may each include a doped epitaxial layer formed by the SEG. While the first doped regions 40 are formed, a dummy doped region (not illustrated) may be formed in the substrate 11, and the dummy doped region may include impurities diffused from the dummy contact nodes 39L.

After the first contact nodes 39 are formed, vertical openings 41V exposing the first contact nodes 39 may be defined in the second spacer 36. The vertical openings 41V may be referred to as "continuous self-aligned openings" in the first direction D1.

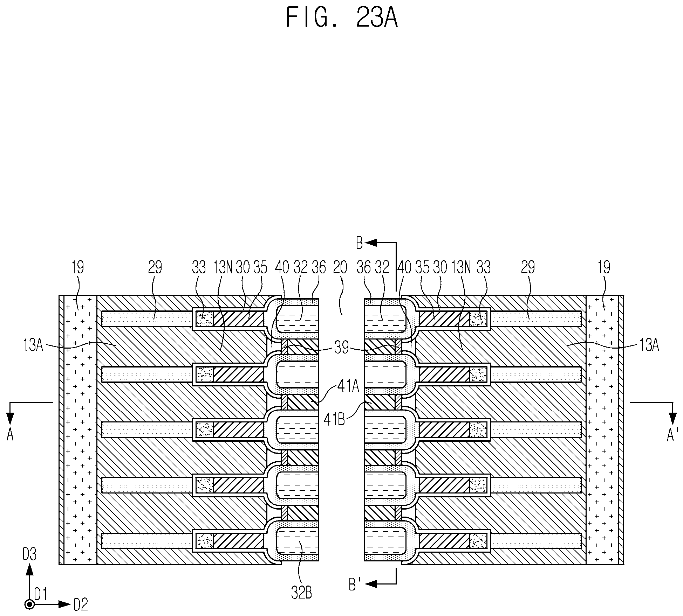

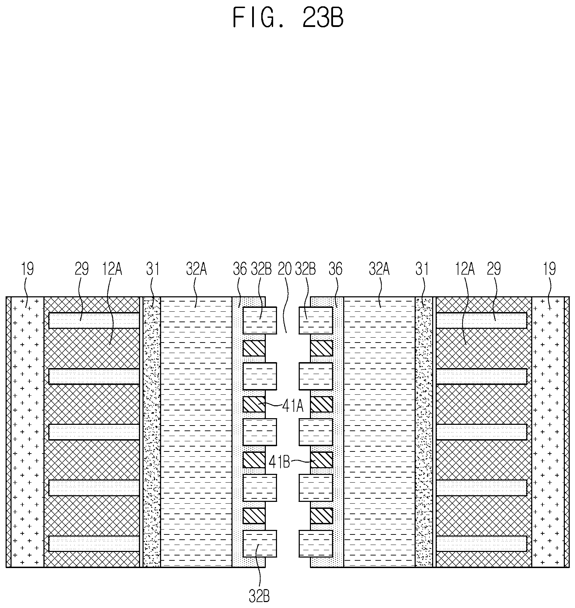

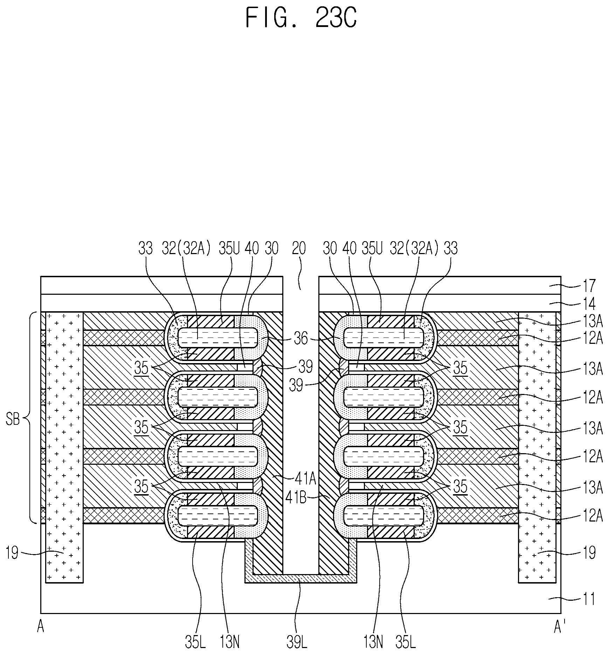

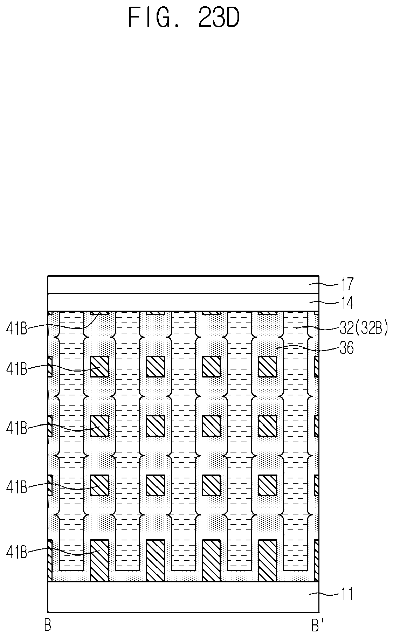

FIG. 23A is a plan view illustrating the structure at the horizontal sheet level for describing a method of forming second conductive lines 41A and 41B. FIG. 23B is a plan view illustrating the structure at the sacrificial mold layer level for describing the method of forming the second conductive lines 41A and 41B. FIG. 23C is a cross-sectional view of the structure taken along line A-A' illustrated in FIG. 23A. FIG. 23D is a cross-sectional view of the structure taken along line B-B' illustrated in FIG. 23A.

Referring to FIGS. 23A to 23D, the second conductive lines 41A and 41B may be formed on the first contact nodes 39. The second conductive lines may include a first vertical conductive line 41A and a second vertical conductive line 41B. The first vertical conductive line 41A and the second vertical conductive line 41B may be spaced apart from each other. The first vertical conductive line 41A may be coupled in common to the first contact nodes 39 disposed in the first direction D1. The second vertical conductive line 41B may be coupled in common to the first contact nodes 39 disposed in the first direction D1.

The first and second vertical conductive lines 41A and 41B may each consist of a metal-based material, specifically titanium nitride, tungsten, or a combination of both. These conductive lines 41A and 41B may cover the first contact nodes 39 and correspond to the first and second vertical conductive lines BLA and BLB depicted in FIGS. 3B and 4A. The first and second vertical conductive lines 41A and 41B may each include a metal-based material.

Forming the first and second vertical conductive lines 41A and 41B may include depositing a vertical conductive line material and performing an etch-back process on the vertical conductive line material. For example, the first and second vertical conductive lines 41A and 41B may be formed to be self-aligned with the second spacer 32 through a blanket etch-back process without a mask.

Bottom portions of the first vertical conductive lines 41A and bottom portions of the second vertical conductive lines 41B may be discontinuous to each other. The first and second vertical conductive lines 41A and 41B may be disposed in the vertical openings (reference numeral "41V" of FIG. 22A). The first and second vertical conductive lines 41A and 41B may vertically extend in the first direction D1. Inner surfaces of the first and second vertical conductive lines 41A and 41B may have non-linear profiles.

The first and second vertical conductive lines 41A and 41B may include protruding inner portions. The protruding inner portions of the first and second vertical conductive lines 41A and 41B may be electrically coupled to the first doped regions 40 through the first contact nodes 39.

The first and second vertical conductive lines 41A and 41B may be supported by the second spacer 36. The first and second vertical conductive lines 41A and 41B which are formed to be self-aligned with the second spacer 36 may be referred to as a "self-aligned bit line (SABL) structure".

As described above, the second spacer 36 may include the vertical openings 41V, and the first and second vertical conductive lines 41A and 41B may be formed in the vertical openings 41V of the second spacer 36.

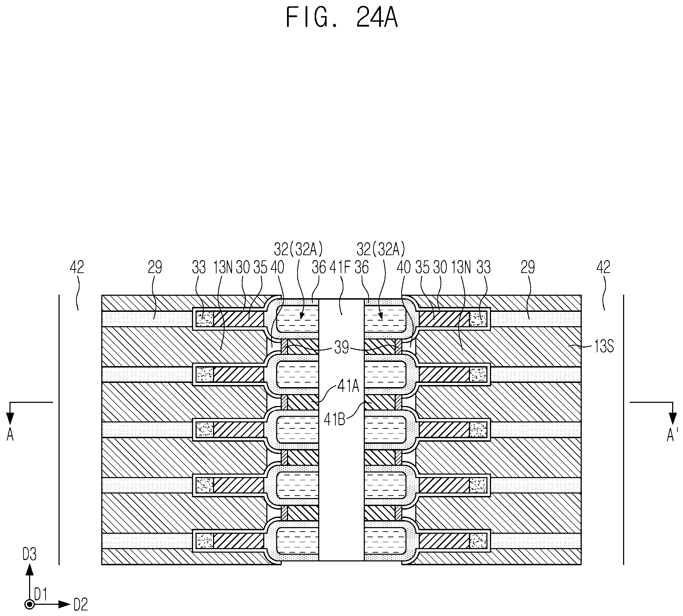

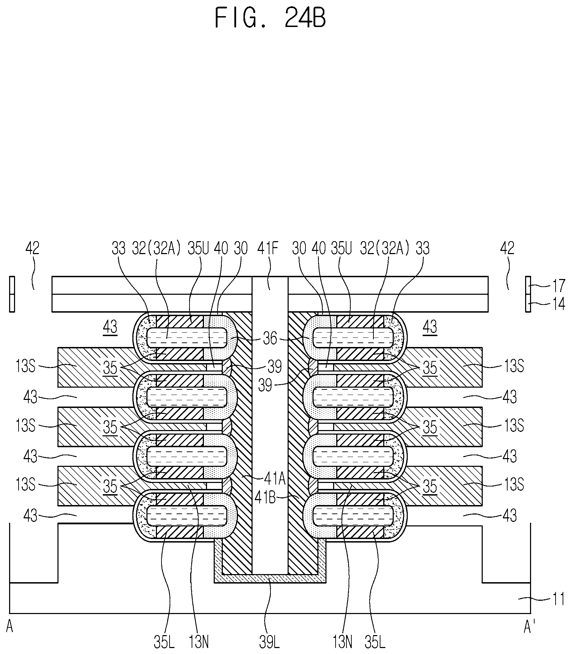

FIG. 24A is a plan view illustrating the structure at the horizontal sheet level for describing a method of forming second linear openings 42. FIG. 24B is a cross-sectional view of the structure taken along line A-A' illustrated in FIG. 24A.

Referring to FIGS. 24A and 24B, an array isolation layer 41F may be formed to fill the first linear opening 20 on the first and second vertical conductive lines 41A and 41B. The array isolation layer 41F may vertically extend in the first direction D1 and horizontally extend in the third direction D3. The first and second vertical conductive lines 41A and 41B adjacent to each other in the third direction D3 may be isolated from each other by the array isolation layer 41F. The array isolation layer 41F may include a dielectric material. The array isolation layer 41F may include silicon oxide, silicon nitride, an air gap, or a combination thereof.

Subsequently, the second linear sacrificial layer 19 may be removed. Accordingly, the second linear openings 42 may be formed.

After the second linear openings 42 are formed, the sacrificial mold layers 12A may be selectively recessed through the second linear openings 42. To selectively recess the sacrificial mold layers 12A, a difference in etch selectivity between the sacrificial mold layers 12A and the body sheets 13A may be used. The sacrificial mold layers 12A may be removed using a wet etch or dry etch process. For example, when the sacrificial mold layers 12A include a silicon germanium layer, the body sheets 13A include a monocrystalline silicon layer, and the silicon germanium layer may be etched by using an etchant or etch gas having a selectivity with respect to the monocrystalline silicon layer.

Subsequently, the body sheets 13A may be recessed. To recess the body sheets 13A, the wet etch or dry etch process may be used. Vertical thicknesses of the body sheets 13A may be reduced, as indicated by reference numeral "13S".

Each of inter-body recesses 43 may be formed between the body sheets 13A that are vertically disposed.

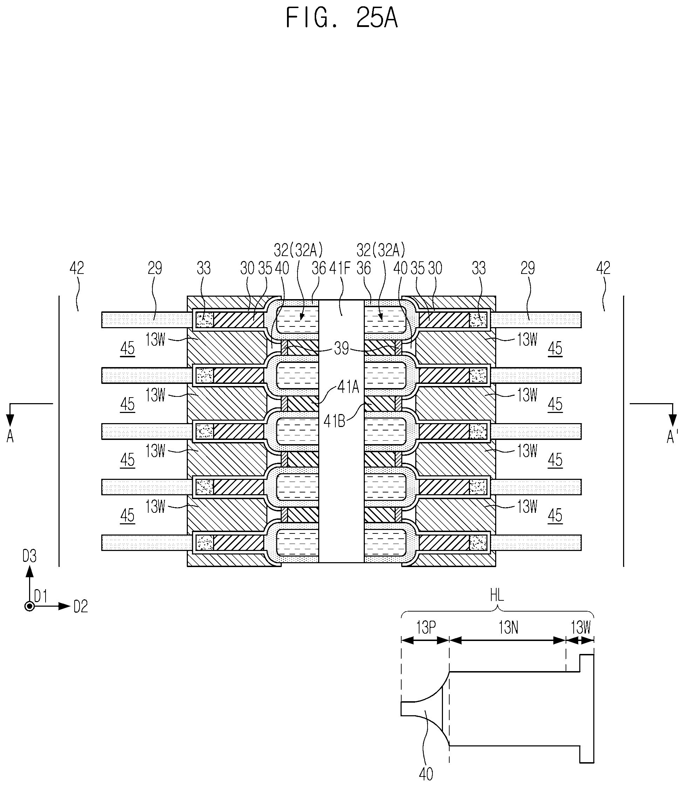

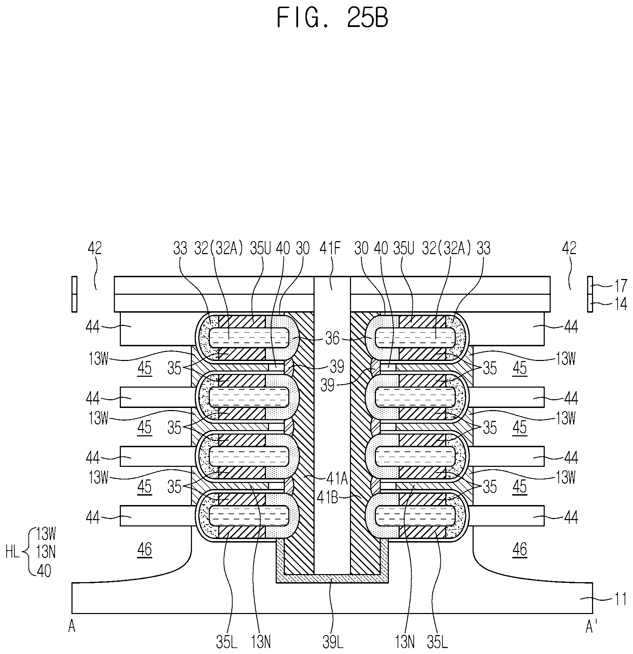

FIG. 25A is a plan view illustrating the structure at the horizontal sheet level for describing a method of forming nano sheets HL. FIG. 25B is a cross-sectional view of the structure taken along line A-A' illustrated in FIG. 25A.

Referring to FIGS. 25A and 25B, third inter-cell dielectric layers 44 may be formed to fill the inter-body recesses 43. The third inter-cell dielectric layers 44 may each include, for example, silicon oxide. The third inter-cell dielectric layers 44 may be referred to as "inter-data storage element dielectric layers".

The combinations of the third inter-cell dielectric layers 44 and the first inter-cell dielectric layers 29 may form inter-cell dielectric layers each having a lattice-shaped frame structure.

After the third inter-cell dielectric layers 44 are formed, storage slots 45 may be formed by the horizontal recessing (or trimming) of the body sheets 13S. The storage slots 45 may be referred to as "capacitor openings". The nano sheets HL may be formed by the horizontal recessing of the body sheets 13S. Each of the nano sheets HL may include the curved sheet 13P, the horizontal sheet 13N and a tapered sheet 13W, and the curved sheet 13P may include the first doped region 40. The tapered sheet 13W of the nano sheet HL may refer to the body sheet 13S remaining after the recessing. An average vertical height of the tapered sheet 13W of the nano sheet HL in the first direction D1 may be greater than an average vertical height of the horizontal sheet 13N. A thickness of the tapered sheet 13W of the nano sheet HL may gradually increase in the second direction D2. A horizontal length of the tapered sheet 13W in the second direction D2 may be less than a horizontal length of the horizontal sheet 13N. A cross section of the tapered sheet 13W of the nano sheet HL may have a fan-like shape. The tapered sheet 13W may be referred to as a "fan-shaped sheet", and the horizontal sheet 13N may be referred to as a "flat plate-shaped sheet".

To form the nano sheets HL each including the tapered sheet 13W, the body sheets 13S may be isotropically or anisotropically etched. One side of the tapered sheet 13W, i.e., the side exposed by each of the storage slots 45, may have a flat shape. The one side of the tapered sheet 13W may have various shapes.

Each of the nano sheets HL may include a first edge and a second edge. The first edge may refer to a side surface of the curved sheet 13P electrically coupled to the first and second vertical conductive lines 41A and 41B and the first contact node 39. The second edge may refer to a side surface of the tapered sheet 13W exposed by the storage slot 37.

Each of the storage slots 45 may be disposed in the lattice-shaped frame structure formed by the combination of the third inter-cell dielectric layer 44 and the first inter-cell dielectric layer 29.

In some embodiments, the horizontal recessing of the body sheets 13S for forming the tapered sheets 13W may stop at a boundary area between the horizontal sheet 13N and the tapered sheet 13W.

During the horizontal recessing of the body sheets 13S, the surface of the substrate 11 may be recessed to form a substrate recessed portion 46.

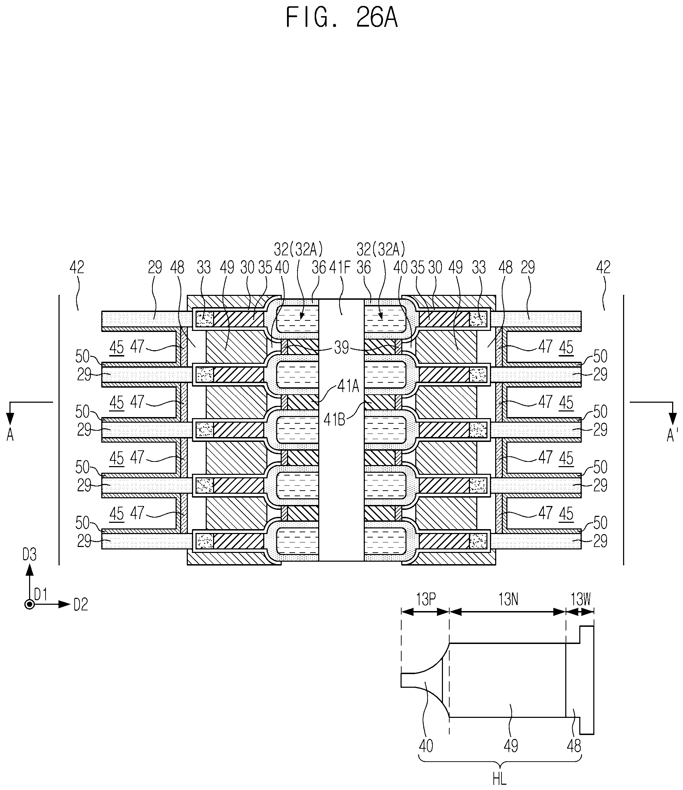

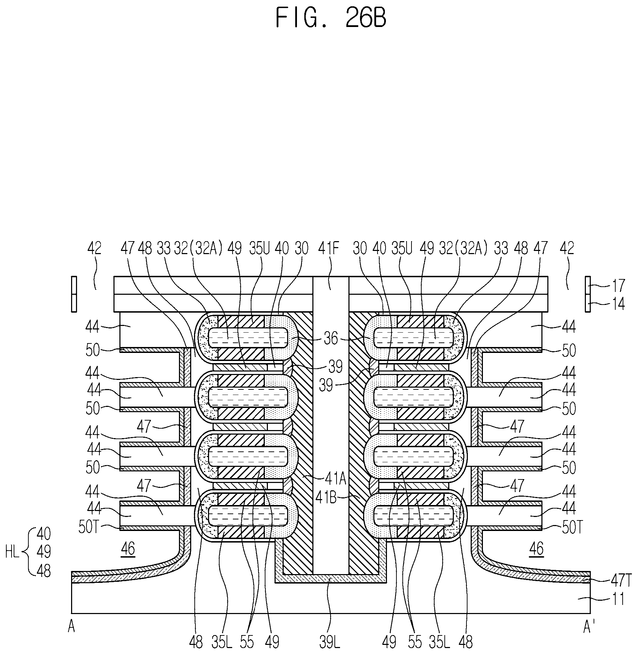

FIG. 26A is a plan view illustrating the structure at a nano sheet level for describing a method of forming second contact nodes 47 and first electrodes 50. FIG. 26B is a cross-sectional view illustrating the structure taken along line A-A' illustrated in FIG. 26A.

Referring to FIGS. 26A and 26B, a pre-cleaning process may be performed on one side of the nano sheets HL, i.e., surfaces of the tapered sheets 13W.

Subsequently, the second contact nodes 47 may be formed on one side of the nano sheets HL, i.e., the tapered sheets 13W. Forming the second contact nodes 47 may include selective epitaxial growth (SEG). For example, a semiconductive material may be grown from the side surfaces of the tapered sheets 13W through the SEG. The second contact nodes 47 may each include SEG Si. Because the tapered sheets 13W each include monocrystalline silicon, a silicon layer may be epitaxially grown along crystal surfaces of the side surfaces of the tapered sheets 13W.

The second contact nodes 47 may include dopants. When the silicon layer is grown using the SEG, the dopants may be doped in situ. Accordingly, the second contact nodes 47 may each be a doped epitaxial layer. The second contact nodes 47 may each include an N-type dopant as the dopant. The N-type dopant may include phosphorus, arsenic, antimony, or a combination thereof. The second contact nodes 47 may each include a phosphorus-doped silicon epitaxial layer formed by the SEG, i.e., doped SEG SiP.

Because the second contact nodes 47 are formed using the SEG, void-free or seam-free second contact nodes 47 may be formed. Because the second contact nodes 47 are formed using the SEG, a process for forming the second contact nodes 47 may be simplified.

Each of the second contact nodes 47 may be disposed between the third inter-cell dielectric layers 44 that are vertically stacked.

While the second contact nodes 47 are formed, dummy contact nodes 47T may be formed on a surface of the substrate recessed portion 46.

Second doped regions 48 may be formed in the tapered sheets 13W of the nano sheets HL. A heat treatment process may be performed to form the second doped regions 48, so that the dopants may be diffused from the second contact nodes 47.

Each of the nano sheets HL may include the first doped region 40, the second doped region 48, and a channel 49. The channel 49 may be defined between the first doped region 40 and the second doped region 48. The first doped region 40 may be formed in the curved sheet 13P, and the channel 49 may be formed in the horizontal sheet 13N. The second doped region 48 may be formed in the tapered sheet 13W. A portion of the second doped region 48 may extend into the horizontal sheet 13N. One side of each of the second doped regions 48 of the nano sheets HL may be coupled to the channel 49. The other side of each of the second doped regions 48 of the nano sheets HL may be coupled to the second contact nodes 47.

In some embodiments, an ohmic contact layer including metal silicide may be further formed after the second contact nodes 47 are formed.

Subsequently, the first electrodes 50 of a data storage element may be formed on the second contact nodes 47. The first electrodes 50 may each have a horizontally-oriented cylindrical shape. Each of the first electrodes 50 may be disposed in a different one of the storage slots 45. The first electrodes 50 adjacent to each other in the second direction D2 may be spaced apart from each other by the second linear openings 42. The first electrodes 50 adjacent to each other in the third direction D3 may be spaced apart from each other by the first inter-cell dielectric layers 29. The first electrodes 50 adjacent to each other in the first direction D1 may be spaced apart from each other by the third inter-cell dielectric layers 44. Forming the first electrodes 50 may include depositing a metal material, gap-filling a sacrificial material, and isolating the metal material in a vertical/horizontal direction. The sacrificial material may include oxide or polysilicon.

Each of the first electrodes 50 may include an inner space and a plurality of outer surfaces. The inner space of the first electrode 50 may include a plurality of inner surfaces. The outer surfaces of the first electrode 50 may include a vertical outer surface and a plurality of horizontal outer surfaces. The vertical outer surface of the first electrode 50 may vertically extend in the first direction D1. The horizontal outer surfaces of the first electrode 50 may horizontally extend in the second direction D2 or the third direction D3. The inner space of the first electrode 50 may be a three-dimensional space. The first electrode 50 may have a cylindrical shape.

The first electrode 50 may include metal, noble metal, metal nitride, conductive metal oxide, conductive noble metal oxide, metal carbide, metal silicide, or a combination thereof. For example, the first electrode 50 may include titanium (Ti), titanium nitride (TiN), titanium silicon nitride (TiSiN), tantalum (Ta), tantalum nitride (TaN), tungsten (W), tungsten nitride (WN), ruthenium (Ru), ruthenium oxide (RuO₂), iridium (Ir), iridium oxide (IrO₂), platinum (Pt), molybdenum (Mo), molybdenum oxide (MoO), a titanium nitride/tungsten (TiN/W) stack, a tungsten nitride/tungsten (WN/W) stack, a titanium silicon nitride/titanium nitride (TiSiN/TiN) stack, or a combination thereof.

While the first electrodes 50 are formed, dummy first electrodes 50T may be formed on the dummy contact nodes 47T.

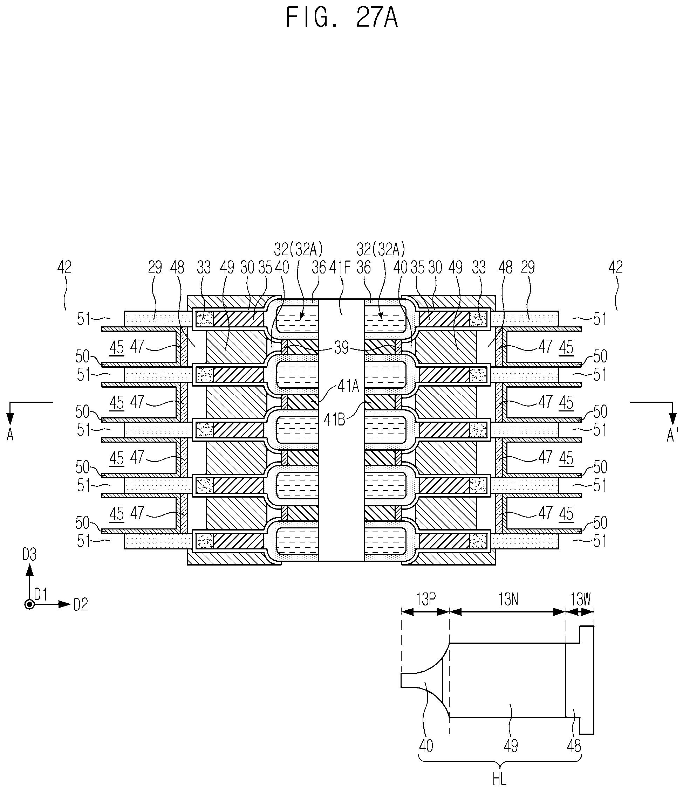

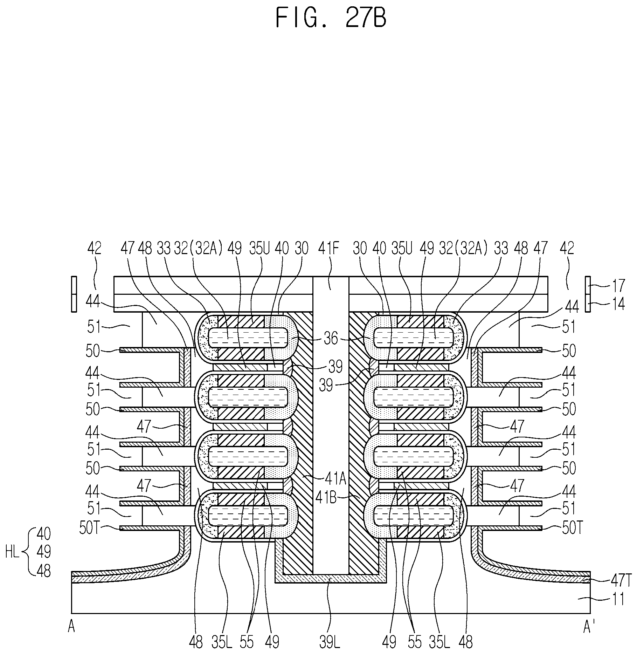

FIG. 27A is a plan view illustrating the structure at the nano sheet level for describing a method of recessing the first and third inter-cell dielectric layers 29 and 44. FIG. 27B is a cross-sectional view of the structure taken along line A-A' illustrated in FIG. 27A.

Referring to FIGS. 27A and 27B, portions of the first and third inter-cell dielectric layers 29 and 44 may be horizontally recessed (refer to reference numeral "51"). Accordingly, outer walls of the first electrodes 50 may be partially exposed. The first electrodes 50 may each have a semi-cylindrical shape. Horizontal recess depths of the first and third inter-cell dielectric layers 29 and 44 may be depths that do not expose the second contact nodes 47. The semi-cylindrical shape of each of the first electrodes 50 may include cylindrical inner surfaces and semi-cylindrical outer surfaces.

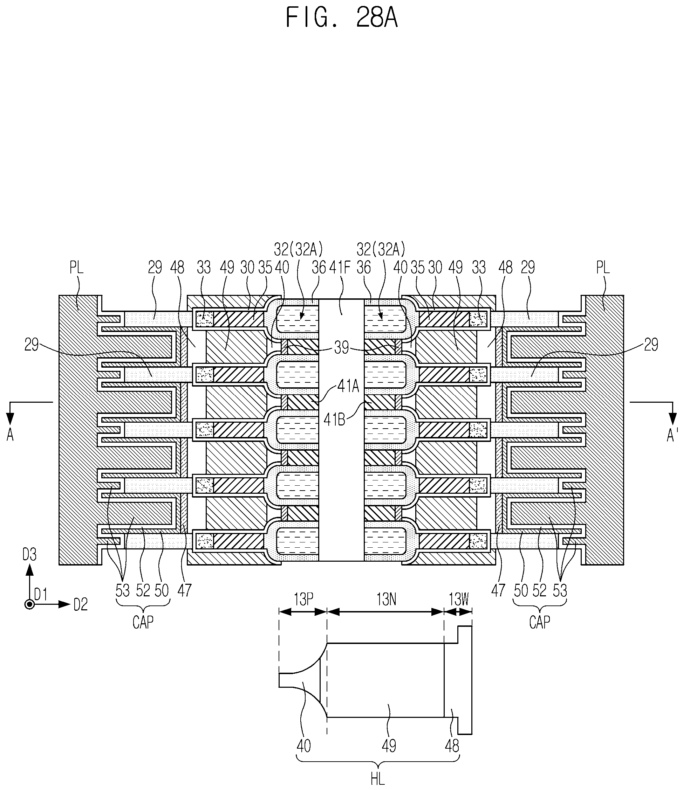

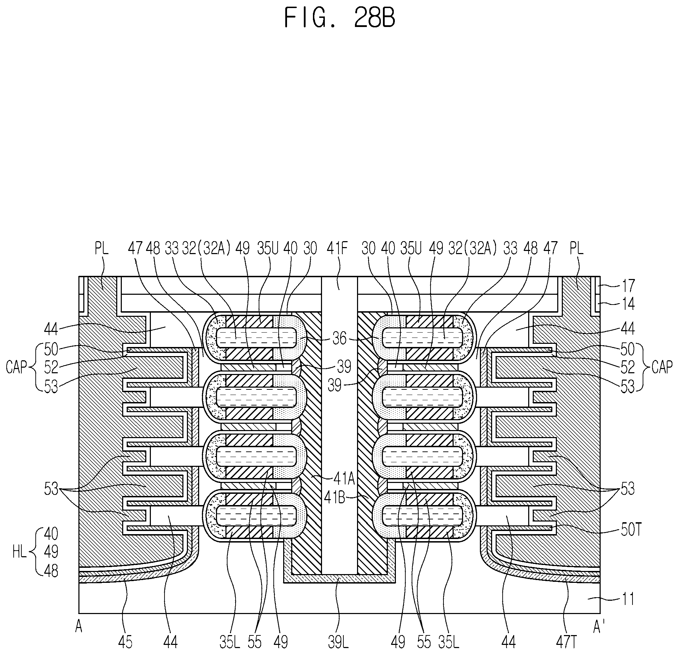

FIG. 28A is a plan view illustrating the structure at the nano sheet level for describing a method of forming a second electrode 53 of the data storage element. FIG. 28B is a cross-sectional view of the structure taken along line A-A' illustrated in FIG. 28A.

Referring to FIGS. 28A and 28B, a dielectric layer 52 and the second electrode 53 may be sequentially formed on the first electrodes 50. The first electrode 50, the dielectric layer 52 and the second electrode 53 may be a data storage element CAP. The second electrodes 53 of the data storage elements CAP may be merged with one another and form a common plate PL. The dielectric layer 52 and the second electrode 53 may correspond to the dielectric layer DE and the second electrode PN illustrated in FIGS. 3B and 4A.

The dielectric layer 52 and the second electrode 53 may be disposed on the cylindrical inner surfaces of the first electrode 50. A portion of the dielectric layer 52 and a portion of the second electrode 53 may extend to be disposed on the semi-cylindrical outer surfaces of the first electrode 50.

The dielectric layer 52 may be referred to as a "capacitor dielectric layer" or a "memory layer". The dielectric layer 52 may include silicon oxide, silicon nitride, a high-k material, a ferroelectric material, an antiferroelectric material, a perovskite material, or a combination thereof. The dielectric layer 52 may include hafnium oxide (HfO₂), zirconium oxide (ZrO₂), aluminum oxide (Al₂O₃), lanthanum oxide (La₂O₃), titanium oxide (TiO₂), tantalum oxide (Ta₂O₅), niobium oxide (Nb₂O₅), or strontium titanium oxide (SrTiO₃). The dielectric layer 52 may include a ZA (ZrO₂/Al₂O₃) stack, a ZAZ (ZrO₂/Al₂O₃/ZrO₂) stack, a ZAZA (ZrO₂/Al₂O₃/ZrO₂/Al₂O₃) stack, a ZAZAZ (ZrO₂/Al₂O₃/ZrO₂/Al₂O₃/ZrO₂) stack, an HA (HfO₂/Al₂O₃) stack, an HAH (HfO₂/Al₂O₃/HfO₂) stack, an HAHA (HfO₂/Al₂O₃/HfO₂/Al₂O₃) stack, an HAHAH (HfO₂/Al₂O₃/HfO₂/Al₂O₃/HfO₂) stack, an HZAZH (HfO₂/ZrO₂/Al₂O₃/ZrO₂/HfO₂) stack, a ZHZAZHZ (ZrO₂/HfO₂/ZrO₂/Al₂O₃/ZrO₂/HfO₂/ZrO₂) stack, an HZHZ (HfO₂/ZrO₂/HfO₂/ZrO₂) stack, or an AHZAZHA (Al₂O₃/HfO₂/ZrO₂/Al₂O₃/ZrO₂/HfO₂/Al₂O₃) stack.

The second electrode 53 may include metal, noble metal, metal nitride, conductive metal oxide, conductive noble metal oxide, metal carbide, metal silicide, or a combination thereof. For example, the second electrode 53 may include titanium (Ti), titanium nitride (TiN), titanium silicon nitride (TiSiN), tantalum (Ta), tantalum nitride (TaN), tungsten (W), tungsten nitride (WN), ruthenium (Ru), ruthenium oxide (RuO₂), iridium (Ir), iridium oxide (IrO₂), platinum (Pt), molybdenum (Mo), molybdenum oxide (MoO), a titanium nitride/tungsten (TiN/W) stack, a tungsten nitride/tungsten (WN/W) stack, a titanium silicon nitride/titanium nitride (TiSiN/TiN) stack, a titanium silicon nitride/titanium nitride/tungsten (TiSiN/TiN/W) stack, or a combination thereof. The second electrode 53 may also include a combination of a metal-based material and a silicon-based material. For example, a titanium nitride, tungsten and polysilicon may be sequentially stacked in the second electrode 53.

In some embodiments, a plurality of interface control layers may be further included between the first electrode 50 and the dielectric layer 52 and between the dielectric layer 52 and the second electrode 53 to alleviate leakage current. Each of the interface control layers may include titanium oxide (TiO₂), tantalum oxide (Ta₂O₅), niobium oxide (Nb₂O₅), niobium nitride (NbN), niobium oxynitride (NbON), or a combination thereof. The data storage element CAP may include a first interface control layer, a second interface control layer, or a combination thereof. The first interface control layer and the second interface control layer may be conductive or dielectric. The first interface control layer may be formed between the first electrode 50 and the dielectric layer 52, and the second interface control layer may be formed between the dielectric layer 52 and the second electrode 53. The first interface control layer and the second interface control layer may be made of the same material or different materials. For example, a structure in which the first interface control layer, dielectric layer 52 and second interface control layer of the data storage element CAP are sequentially stacked may include an NZHZAZHZATN (Nb₂O₅/ZrO₂/HfO₂/ZrO₂/Al₂O₃/ZrO₂/HfO₂/ZrO₂/Al₂O₃/TiO₂/Nb₂O₅) stack.

In some embodiments, the recessing of the first and third inter-cell dielectric layers 29 and 44 illustrated in FIGS. 27A and 27B may be omitted. Thereafter, as illustrated in FIGS. 28A and 28B, the dielectric layer 52 and the second electrode 53 may be formed. Accordingly, the data storage element CAP including the first electrode 50 having a concave shape may be formed.

The data storage elements CAP may be disposed in the storage slots 45 and may also be coupled to the tapered sheets 13W.

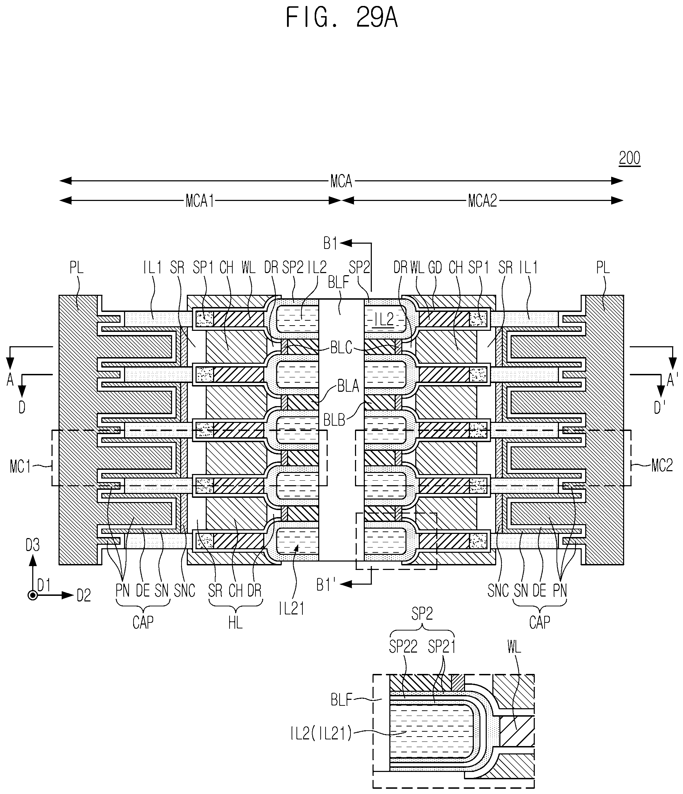

FIG. 29A is a schematic plan view illustrating a semiconductor device 200 in accordance with an embodiment of the present disclosure.

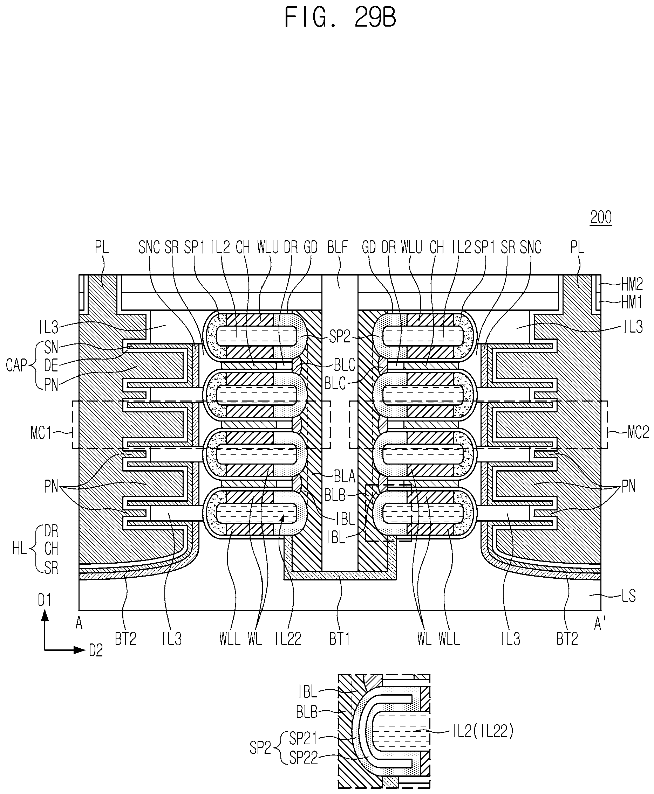

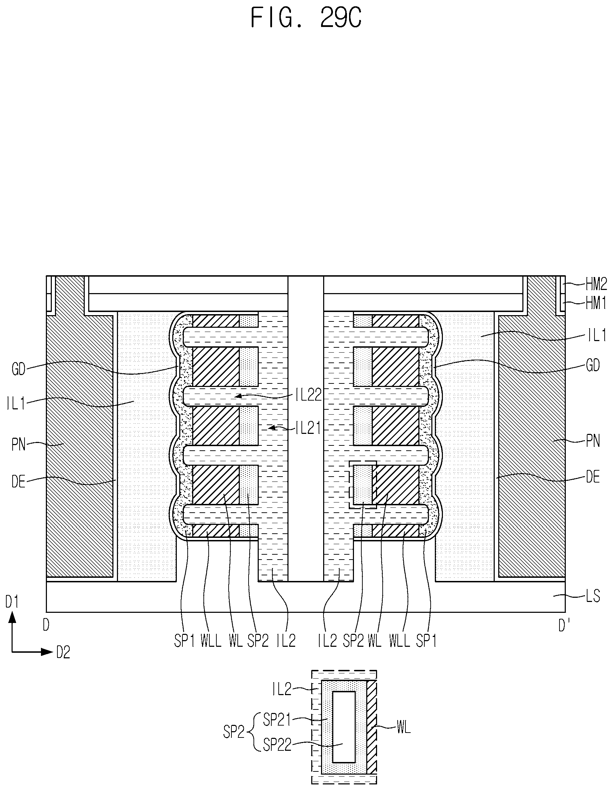

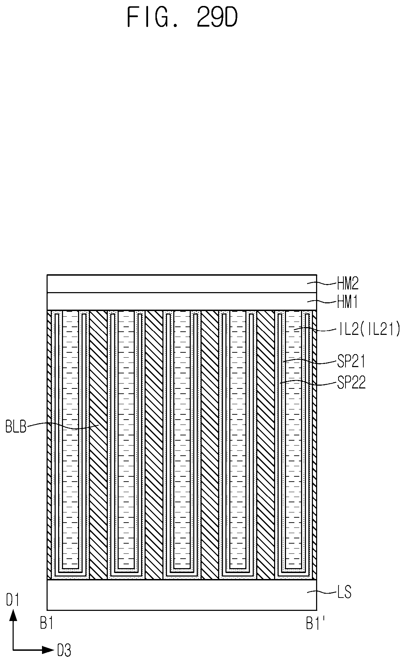

FIG. 29B is a cross-sectional view of the semiconductor device 200 taken along line A-A' illustrated in FIG. 29A. FIG. 29C is a cross-sectional view of the semiconductor device 200 taken along line B1-B1' illustrated in FIG. 29A. FIG. 29D is a cross-sectional view of the semiconductor device 200 taken along line D-D' illustrated in FIG. 29A. The semiconductor device 200 illustrated in FIGS. 29A to 29D may be similar to the semiconductor device 100 illustrated in FIGS. 3A to 4E. The semiconductor devices 100 and 200 may have the same configurations except for the second spacer SP2.

Referring to FIGS. 29A to 29D, the semiconductor device 200 may include a lower structure LS and a memory cell array MCA. The memory cell array MCA may include a first sub-cell array MCA1 and a second sub-cell array MCA2. The first sub-cell array MCA1 may include a three-dimensional array of first memory cells MC1. The second sub-cell array MCA2 may include a three-dimensional array of second memory cells MC2. Each of the first memory cells MC1 may include a first vertical conductive line BLA, a switching element TR, and a data storage element CAP, and the switching element TR may include a first conductive line WL, a nano sheet dielectric layer GD, and a nano sheet HL. Each of the second memory cells MC2 may include a second vertical conductive line BLB, a switching element TR, and a data storage element CAP, and the switching element TR may include a first conductive line WL, a nano sheet dielectric layer GD, and a nano sheet HL. The nano sheets HL of the first and second memory cells MC1 and MC2 may each include a first doped region DR, a second doped region SR, and a channel CH. First contact nodes BLC may be formed on the first doped regions DR of the first and second memory cells MC1 and MC2. Second contact nodes SNC may be formed on the second doped regions SR of the first and second memory cells MC1 and MC2.

The first memory cells MC1 of the first sub-cell array MCA1 may share the first vertical conductive line BLA, and the second memory cells MC2 of the second sub-cell array MCA2 may share the second vertical conductive line BLB.

Each of first inter-cell dielectric layers IL1 may be disposed between the data storage elements CAP adjacent to each other in a third direction D3. Each of second inter-cell dielectric layers IL2 may be disposed between the first conductive lines WL stacked vertically in a first direction D1. Each of third inter-cell dielectric layers IL3 may be disposed between first electrodes SN of the data storage elements CAP stacked vertically in the first direction D1.

Each of the first memory cells MC1 and each of the second memory cells MC2 may further include a first spacer SP1 and a second spacer SP2.

Each of the second inter-cell dielectric layers IL2 may include a horizontal segment IL22 and a vertical segment IL21. Each of the horizontal segment IL22 and the vertical segment IL21 of the second inter-cell dielectric layer IL2 may be a dielectric material having an integral structure. The horizontal segment IL22 and the vertical segment IL21 of the second inter-cell dielectric layer IL2 may intersect each other. The horizontal segment IL22 may extend in the third direction D3, and the vertical segment IL21 may extend in the first direction D1. One edge of the horizontal segment IL22 may include convex patterns and concave patterns between the convex patterns. The vertical segment IL21 may partially fill the concave patterns and also extend in the first direction D1. Both sides of the vertical segment IL21 may directly contact the convex patterns. A spacer gap may be defined by the vertical segment IL21, the convex patterns and the concave patterns, and a portion of the second spacer SP2 may fill the spacer gap and also surround the convex patterns.

The horizontal segment IL22 of the second inter-cell dielectric layer IL2 may be disposed between the first conductive lines WL in the first direction D1, and the vertical segment IL21 of the second inter-cell dielectric layer IL2 may be disposed between the first vertical conductive line BLA and the second vertical conductive line BLB in the third direction D3. The horizontal segment IL22 of the second inter-cell dielectric layer IL2 may be an isolation layer that isolates the first conductive lines WL adjacent to each other in the first direction D1, and the vertical segment IL21 of the second inter-cell dielectric layer IL2 may be an isolation layer that isolates the first and second vertical conductive lines BLA and BLB adjacent to each other in the third direction D3. As described, the second inter-cell dielectric layer IL2 may include the horizontal segment IL22 and the vertical segment IL21, and the first and second vertical conductive lines BLA and BLB may be formed to be self-aligned with the second spacer SP2.

The second spacer SP2 may have a double structure of an outer spacer SP21 and an inner spacer SP22. The inner spacer SP22 may be disposed in the outer spacer SP21. The outer spacer SP21 and the inner spacer SP22 may be different materials. The outer spacer SP21 may include, for example, silicon nitride, and the inner spacer SP22 may include silicon oxide. The outer spacer SP21 may contact the nano sheet dielectric layer GD and also contact the horizontal segment IL22 and vertical segment IL21 of the second inter-cell dielectric layer IL2.

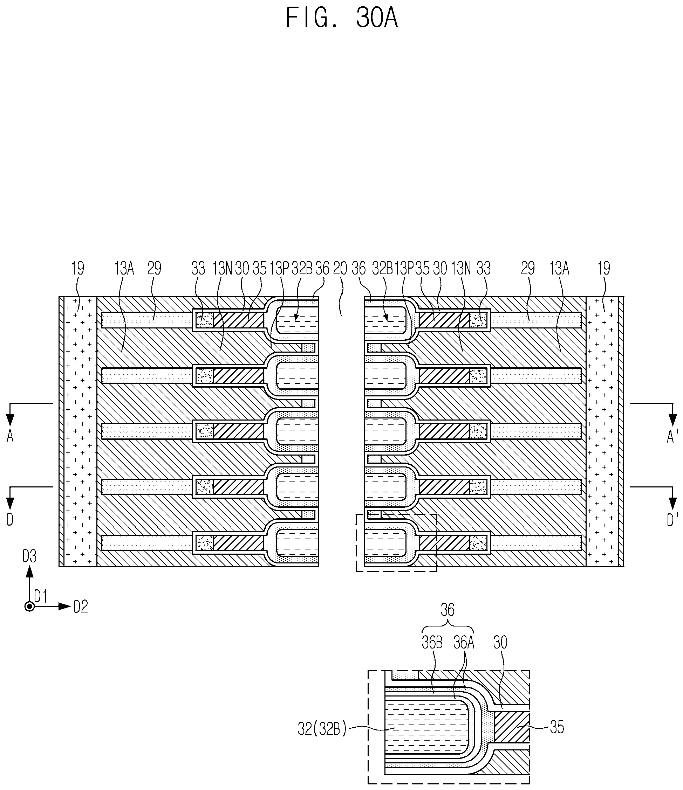

FIGS. 30A to 33B illustrate various views of a semiconductor device formed utilizing the method for fabricating the semiconductor device in accordance with an embodiment of the present disclosure. FIGS. 30A to 33B illustrate a method for fabricating the semiconductor device 200 illustrated in FIGS. 29A to 29D.

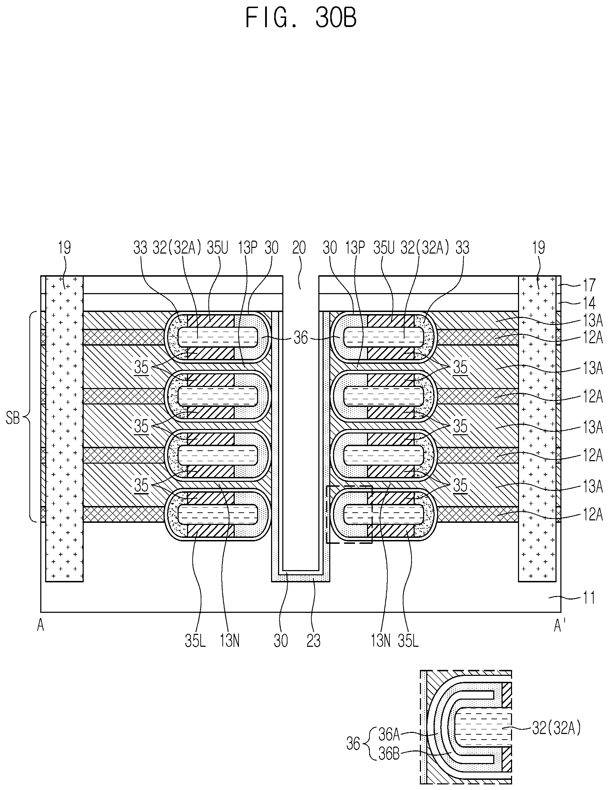

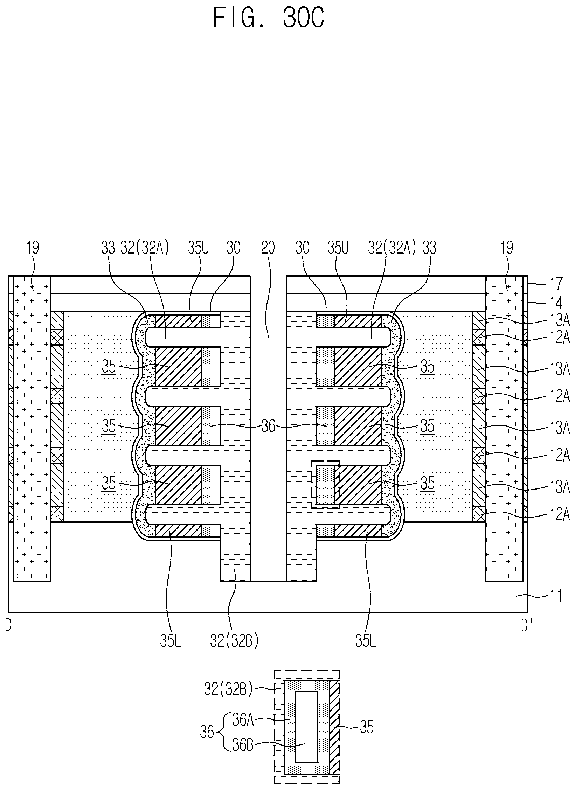

FIG. 30A is a plan view illustrating a structure at a horizontal sheet level for describing a method of forming a second spacer 36. FIG. 30B is a cross-sectional view of the structure taken along line A-A' illustrated in FIG. 30A. FIG. 30C is a cross-sectional view of the structure taken along line D-D' illustrated in FIG. 30A.

Curved sheets 13P, horizontal sheets 13N, first inter-cell dielectric layers 29, second inter-cell dielectric layers 32, nano sheet dielectric layers 30, a first spacer 33 and first conductive lines 35 may be formed by a series of processes as described above with reference to FIGS. 5A to 19D.

Subsequently, as illustrated in FIGS. 30A to 30C, a second spacer 36 may be formed. The second spacer 36 may have a double structure of an outer spacer 36A and an inner spacer 36B. The inner spacer 36B may be disposed in the outer spacer 36A. The outer spacer 36A and the inner spacer 36B may be different materials. The outer spacer 36A may include, for example, silicon nitride, and the inner spacer 36B may include silicon oxide. The outer spacer 36A may contact the nano sheet dielectric layers 30 and also contact a horizontal segment 32A and vertical segment 32B of the second inter-cell dielectric layer 32.

The second spacer 36 may be disposed on one side of each of the first conductive lines 35 and also extend in a third direction D3. The second spacer 36 may surround portions of the horizontal sheets 13N disposed at the same horizontal level in the third direction D3. The second spacer 36 may surround fan-shaped curved sheets 13P disposed at the same horizontal level in the third direction D3. The second spacer 36 may surround the fan-shaped curved sheets 13P disposed in a first direction D1. The second spacer 36 may cover side surfaces of the horizontal segments 32A of the second inter-cell dielectric layers 32. In addition, the second spacer 36 may extend to cover side surfaces of the vertical segments 32B of the second inter-cell dielectric layers 32.

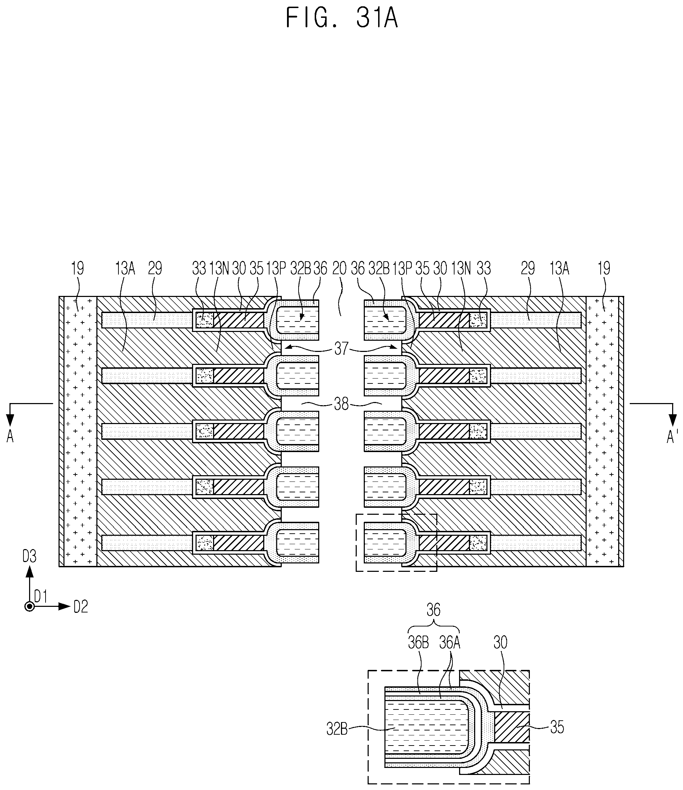

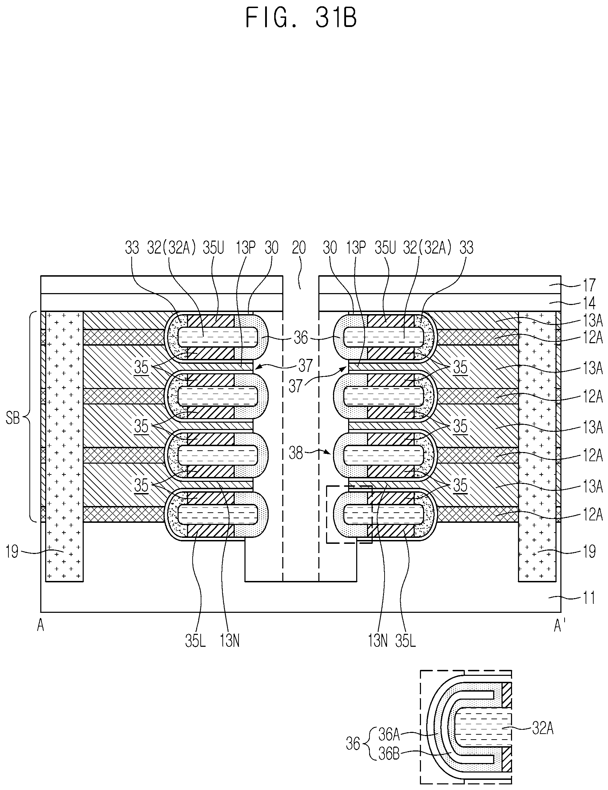

FIG. 31A is a plan view illustrating the structure at the horizontal sheet level for describing a method of forming contact level recesses 38. FIG. 31B is a cross-sectional view of the structure taken along line A-A' illustrated in FIG. 31A.

Referring to FIGS. 31A and 31B, one side of the curved sheets 13P may be recessed to form the contact level recesses 38. Forming the contact level recesses 38 may include cutting the nano sheet dielectric layer 30 from a first linear opening 20, removing sacrificial sheet layers 23, and recessing one side of the curved sheets 13P. A series of processes for forming the contact level recesses 38 may be performed using the second spacer 36 and the vertical segment 32B of the second inter-cell dielectric layer 32 as barriers.

As the contact level recesses 38 are formed, horizontal lengths of the curved sheets 13P may be shortened, each of the contact level recesses 38 may include an inner side 37, and the inner sides 37 of the contact level recesses 38 may expose edge portions of the curved sheets 13P. The contact level recesses 38 may be formed to be self-aligned with the second spacer 36.

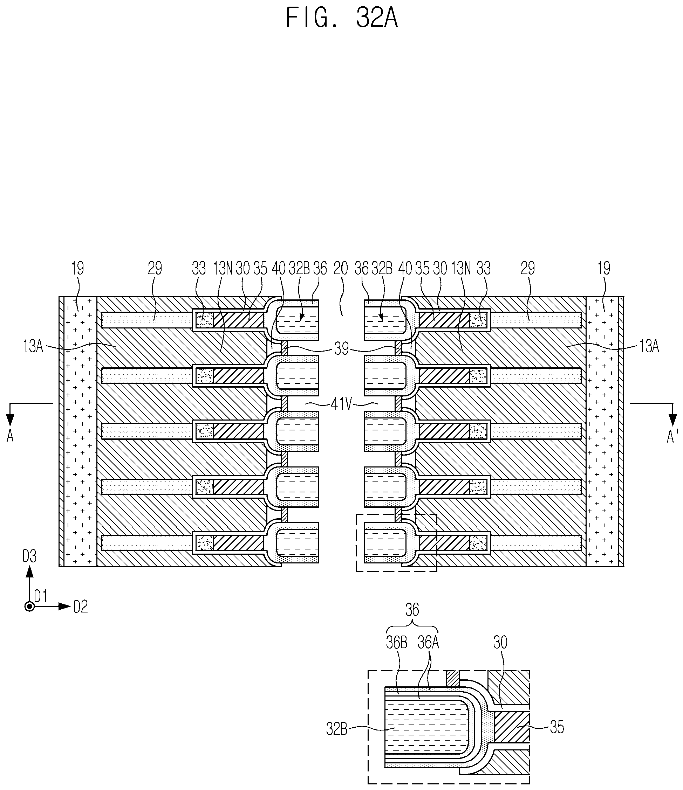

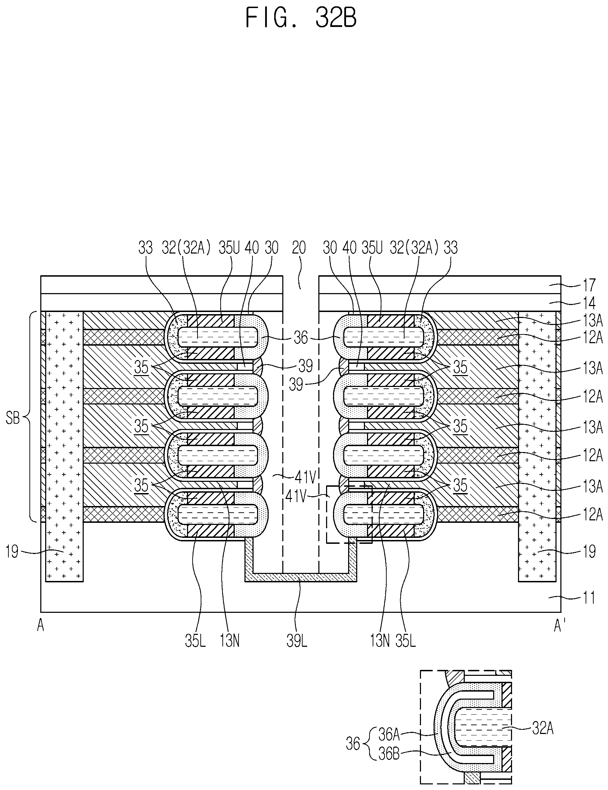

FIG. 32A is a plan view illustrating the structure at the horizontal sheet level for describing a method of forming first contact nodes 39. FIG. 32B is a cross-sectional view of the structure taken along line A-A' illustrated in FIG. 32A.

Referring to FIGS. 32A and 32B, first contact nodes 39 may be formed on the inner sides 37 of the contact level recesses 38. Forming the first contact nodes 39 may include selective epitaxial growth (SEG). For example, a semiconductive material may be grown from exposed surfaces of the curved sheets 13P through the SEG. The first contact nodes 39 may include SEG Si. Because the curved sheets 13P include monocrystalline silicon, a silicon layer may be epitaxially grown along crystal surfaces of the exposed surfaces of the curved sheets 13P.

The first contact nodes 39 may include dopants. When a silicon layer is grown using the SEG, the dopants may be doped in situ. Accordingly, the first contact nodes 39 may be doped epitaxial layers. The first contact nodes 39 may each include an N-type dopant. The N-type dopant may include phosphorus, arsenic, antimony, or a combination thereof. The first contact nodes 39 may each include a phosphorus-doped silicon epitaxial layer formed by the SEG, i.e., doped SEG SiP.

First doped regions 40 may be formed in the curved sheets 13P. A heat treatment process may be performed to form the first doped regions 40 for diffusing the dopants from the first contact nodes 39. In another method of forming the first doped regions 40, a gas phase doping method may be applied.

While the first contact nodes 39 are formed, dummy contact nodes 39L may be formed on a surface of a substrate 11. The first contact nodes 39 and the dummy contact nodes 39L may be made of the same material. For example, the dummy contact nodes 39L may each include a doped epitaxial layer formed by the SEG. While the first doped regions 40 are formed, a dummy doped region (not illustrated) may be formed in the substrate 11, and the dummy doped region may include impurities diffused from the dummy contact nodes 39L.

After the first contact nodes 39 are formed, vertical openings 41V exposing portions of the second spacer 36 and the first contact nodes 39 may be defined.

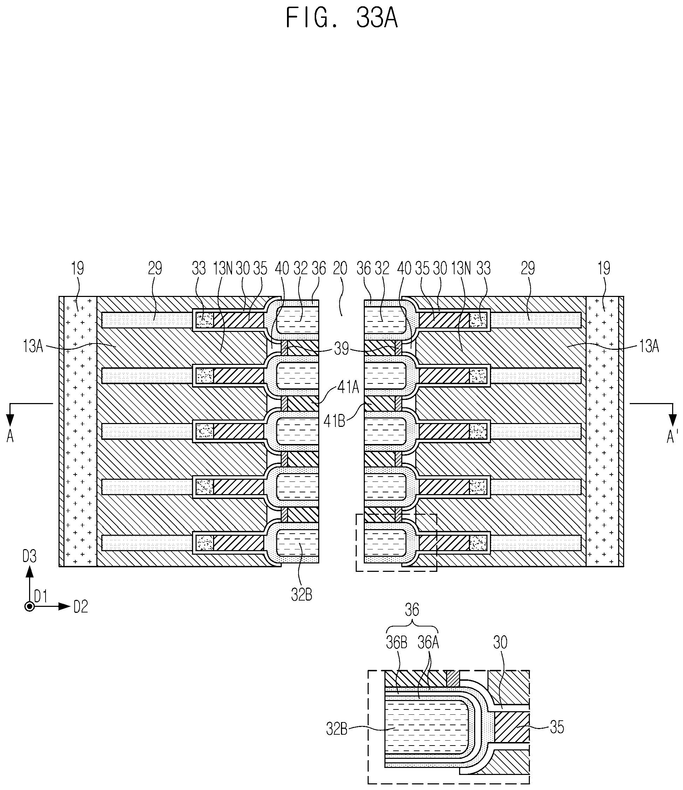

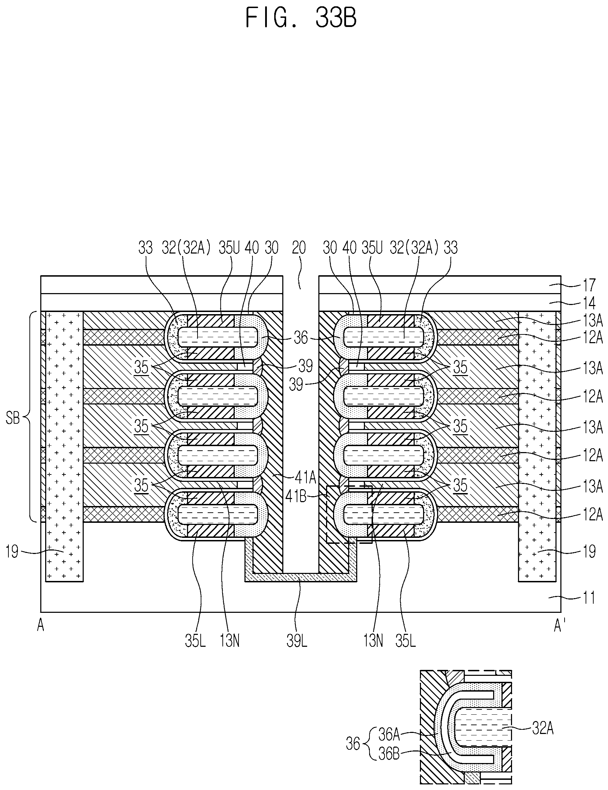

FIG. 33A is a plan view illustrating the structure at the horizontal sheet level for describing a method of forming second conductive lines 41A and 41B. FIG. 33B is a cross-sectional view of the structure taken along line A-A' illustrated in FIG. 33A.

Referring to FIGS. 33A and 33B, the second conductive lines 41A and 41B may be formed on the first contact nodes 39. The second conductive lines may include a first vertical conductive line 41A and a second vertical conductive line 41B. The first vertical conductive line 41A and the second vertical conductive line 41B may be spaced apart from each other. The first vertical conductive line 41A may be coupled in common to the first contact nodes 39 disposed in the first direction D1. The second vertical conductive line 41B may be coupled in common to the first contact nodes 39 disposed in the first direction D1.

The first and second vertical conductive lines 41A and 41B may each include a metal-based material. The first and second vertical conductive lines 41A and 41B may each include titanium nitride, tungsten, or a combination thereof. The first and second vertical conductive lines 41A and 41B may cover the first contact nodes 39. The first and second vertical conductive lines 41A and 41B may correspond to the first and second vertical conductive lines BLA and BLB illustrated in FIGS. 3B and 4A.

Forming the first and second vertical conductive lines 41A and 41B may include depositing a vertical conductive line material and performing an etch-back process on the vertical conductive line material. For example, the first and second vertical conductive lines 41A and 41B may be formed to be self-aligned with the second spacer 32 through a blanket etch-back process without a mask.

Bottom portions of the first vertical conductive lines 41A and bottom portions of the second vertical conductive lines 41B may be discontinuous to each other. The first and second vertical conductive lines 41A and 41B may be disposed in the vertical openings (reference numeral "41V" of FIG. 32A). The first and second vertical conductive lines 41A and 41B may vertically extend in the first direction D1. Inner surfaces of the first and second vertical conductive lines 41A and 41B may have non-linear profiles.

The first and second vertical conductive lines 41A and 41B may include protruding inner portions. The protruding inner portions of the first and second vertical conductive lines 41A and 41B may be electrically coupled to the first doped regions 40 through the first contact nodes 39.

The first and second vertical conductive lines 41A and 41B may be supported by the second spacer 36. The first and second vertical conductive lines 41A and 41B which are formed to be self-aligned with the second spacer 36 may be referred to as a "self-aligned bit line (SABL) structure".

As described above, the second spacer 36 may include the vertical openings 41V, and the first and second vertical conductive lines 41A and 41B may be formed in the vertical openings 41V of the second spacer 36.

Subsequently, a series of processes described above with reference to FIGS. 24A to 28B may be performed.

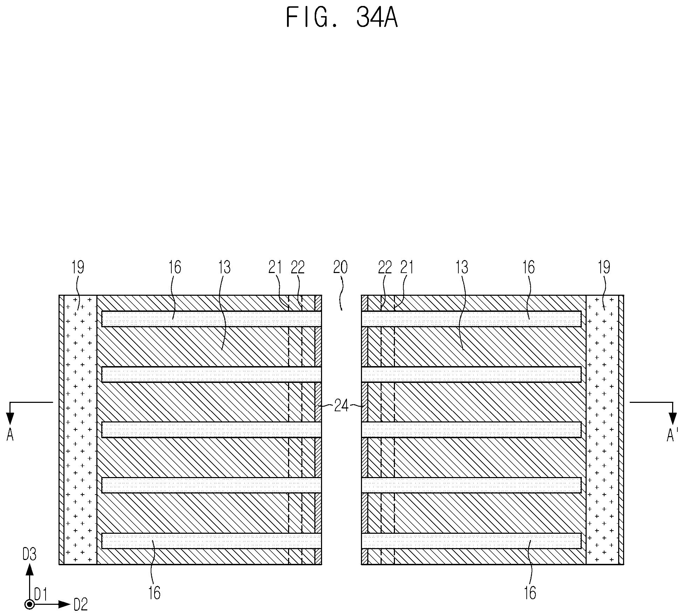

FIGS. 34A to 44B illustrate various plan views of a semiconductor device formed utilizing a method for fabricating the semiconductor device in accordance with an embodiment of the present disclosure.

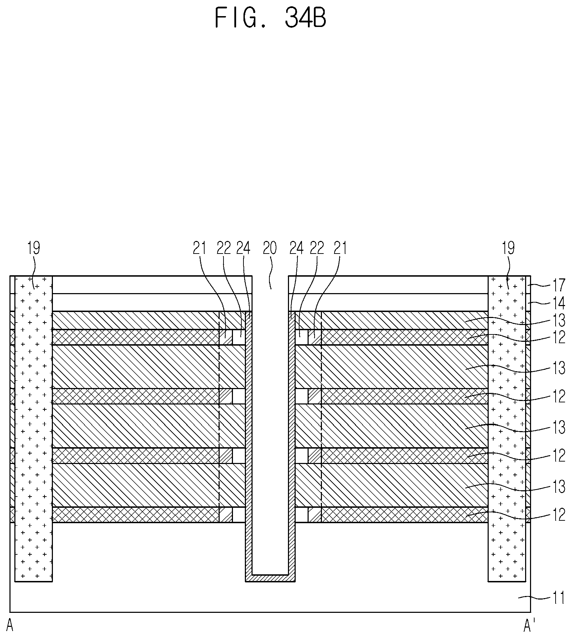

FIG. 34A is a plan view illustrating the structure at a mold layer level for describing additional sacrificial sheet layers 24. FIG. 34B is a cross-sectional view of the structure taken along line A-A' illustrated in FIG. 34A.

Referring to FIGS. 34A and 34B, the additional sacrificial sheet layers 24 may be formed on second side fillers 22. The additional sacrificial sheet layers 24 may be selectively grown from mold layers 13. Selective growth of a conductive material may be performed to form the additional sacrificial sheet layers 24. The additional sacrificial sheet layers 24 may each include a silicon germanium layer formed by epitaxial growth. The additional sacrificial sheet layers 24 may each include a monocrystalline silicon germanium layer, i.e., an epitaxial silicon germanium layer. The additional sacrificial sheet layers 24 and the sacrificial mold layers 12 may be the same material. The additional sacrificial sheet layers 24 may be silicon germanium layers having a high germanium concentration. For example, the additional sacrificial sheet layers 24 may be germanium-rich silicon germanium layers.

As described above, in an embodiment, the additional sacrificial sheet layers 24 may be formed by omitting sacrificial sheet layers.

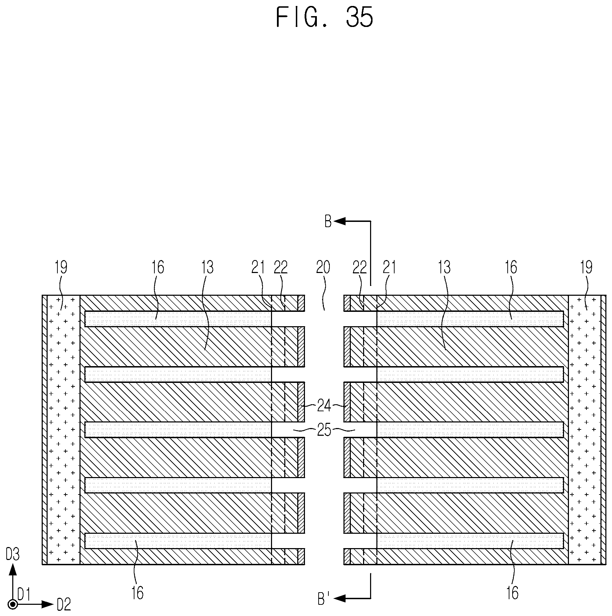

FIG. 35 is a plan view illustrating the structure at the mold layer level for describing the partial recessing of sacrificial isolation layers 16. A cross-sectional view of the structure taken along line B-B' illustrated in FIG. 35 is referred to FIG. 11C.

Referring to FIGS. 35 and 11C, the sacrificial isolation layers 16 may be selectively recessed horizontally to form vertical recesses 25 extending vertically in a first direction D1 between the first side fillers 21. The vertical recesses 25 may be disposed between the sacrificial mold layers 12 and between mold layers 13. In some embodiments, after recessing the sacrificial isolation layers 16, deposition and recessing of oxide (or nitride) may be additionally performed to gap-fill voids which are present in the sacrificial isolation layers 16.

Side surfaces of the mold layers 13 may be partially exposed by the vertical recesses 25. In addition, side surfaces of the first side fillers 21 may all be exposed.

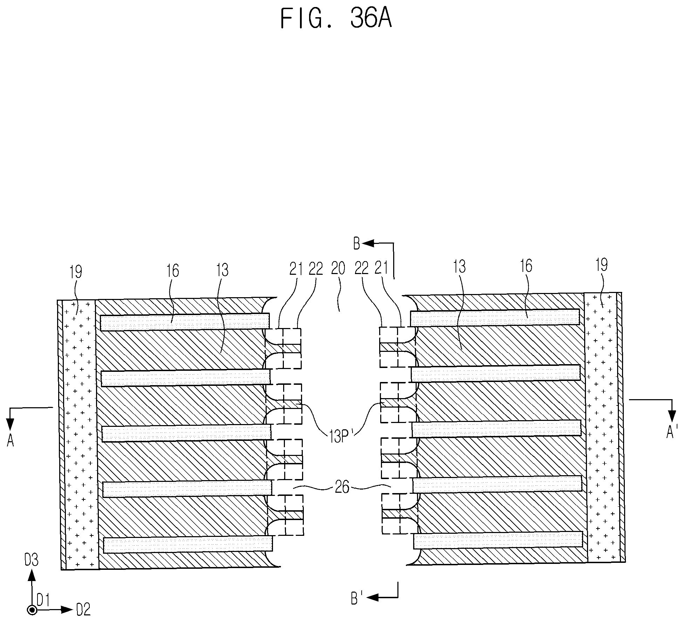

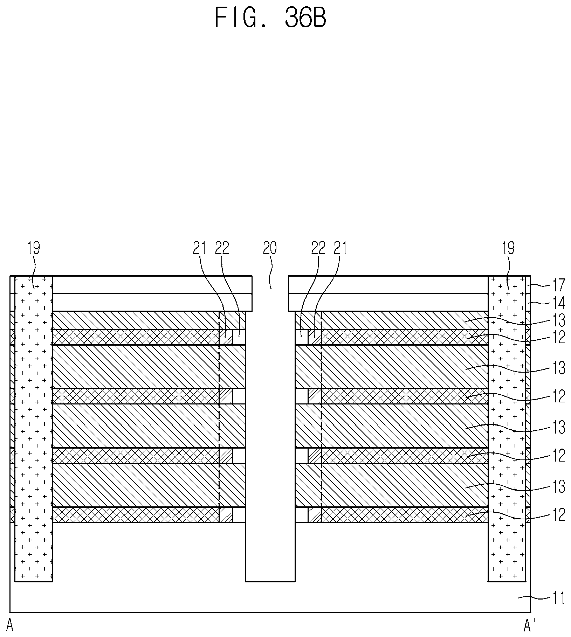

FIG. 36A is a plan view illustrating the structure at the mold layer level for describing the side recessing of the mold layers 13. FIG. 36B is a cross-sectional view of the structure taken along line A-A' illustrated in FIG. 36A. A cross-sectional view of the structure taken along line B-B' illustrated in FIG. 36A is referred to FIG. 12C.

Referring to FIGS. 36A and 36B, side recessing may be performed on the mold layers 13 in a third direction D3 through the vertical recesses 25 to form curved target sheets 13P' and extending vertical recesses 26. Each of the extending vertical recesses 26 may be disposed between the curved target sheets 13P' in the third direction D3. The curved target sheets 13P' may include sides RS that are horizontally recessed. A process for forming the curved target sheets 13P' may be referred to as a "first side recessing process". The first side recessing process may be performed in the third direction D3. The first side recessing process may include a wet or dry etch process for silicon layers. Side fillers 21 and 22 may remain on upper and lower portions of the curved target sheets 13P', respectively.

Subsequently, the additional sacrificial sheet layers 24 may be removed, and thus one side of the curved target sheets 13P' may be exposed.

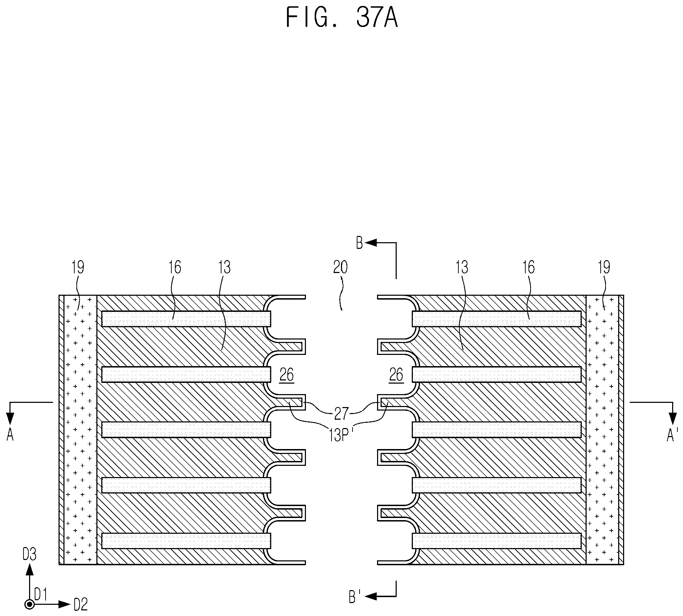

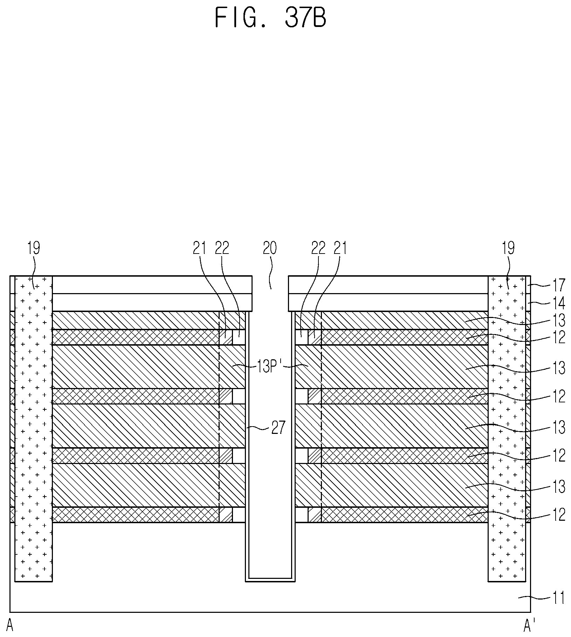

FIG. 37A is a plan view illustrating the structure at the mold layer level for describing a method of forming sacrificial sheet dielectric layers 27. FIG. 37B is a cross-sectional view of the structure taken along line A-A' illustrated in FIG. 37A.

Referring to FIGS. 37A and 37B, the sacrificial sheet dielectric layers 27 may be formed on side surfaces of the curved target sheets 13P', for example, by oxidizing the side surfaces of the curved target sheets 13P'. In some embodiments, the sacrificial sheet dielectric layers 27 may be formed by deposition and oxidation processes for silicon oxide. The sacrificial sheet dielectric layers 27 may each include, for example, silicon oxide. The sacrificial sheet dielectric layers 27 may directly contact second side fillers 22.

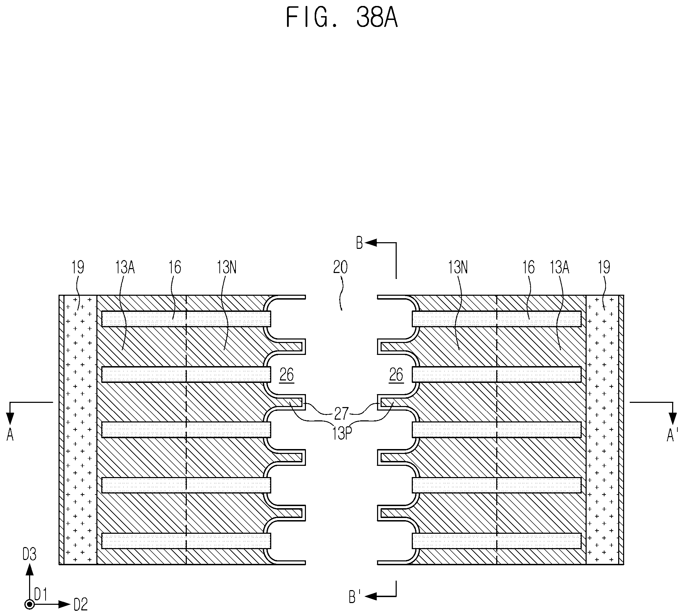

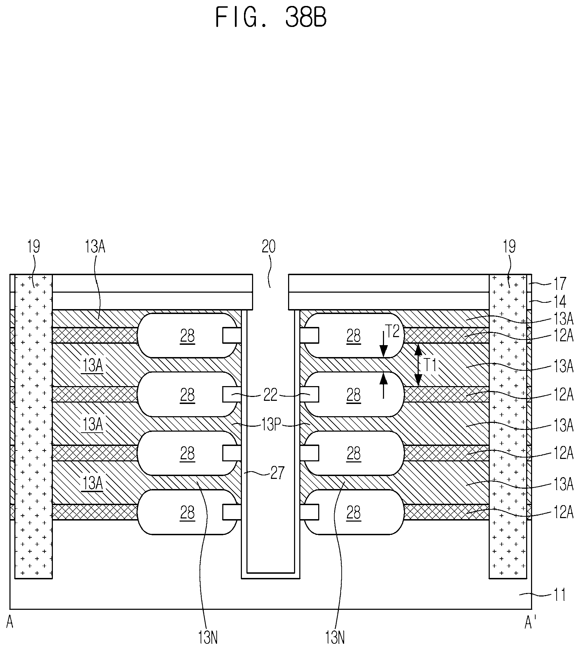

FIG. 38A is a plan view illustrating the structure at the mold layer level for describing a method of forming horizontal sheets 13N. FIG. 38B is a cross-sectional view of the structure taken along line A-A' illustrated in FIG. 38A. A cross-sectional view of the structure taken along line B-B' illustrated in FIG. 38A is referred to FIG. 14D.

Referring to FIGS. 38A and 38B, the first side fillers 21 may be removed through the extending vertical recesses 26, and then the upper and lower surfaces of the curved target sheets 13P' may be exposed.

Subsequently, a second side recessing process may be performed on the curved target sheets 13P', the sacrificial mold layers 12 and the mold layers 13. The second side recessing process may be performed in the first direction D1 and a second direction D2. The second side recessing process may include a wet or dry etch process for silicon layers and silicon germanium layers.

Body sheets 13A and the horizontal sheets 13N may be formed by the second side recessing process for the mold layers 13. Curved sheets 13P having fan-like shapes may be formed by the second side recessing process for the curved target sheets 13P'. The curved sheets 13P may be disposed on one side of the horizontal sheets 13N. The body sheets 13A, the horizontal sheets 13N and the curved sheets 13P may be integral.

The second side recessing process for the sacrificial mold layers 12 may be carried out in the second direction D2. The second side recessing process for the mold layers 13 may also be performed in the first direction D1. The second side recessing process for the curved target sheets 13P' may be performed in both the first direction D1 and the second direction D2.

The second side recessing process for the mold layers 13 may use the wet etch process or the dry etch process. Each of the body sheets 13A may maintain an original thickness T1, and each of the horizontal sheets 13N may have a thickness T2 thinner than the original thickness T1. Horizontal lengths of the body sheets 13A in the second direction D2 may be the same as or different from horizontal lengths of the horizontal sheets 13N in the second direction D2. The horizontal sheets 13N may be referred to as "flat plate-shaped sheets".

The second side recessing process may be referred to as a "thinning process" or a "trimming process" for the mold layers 13. To form the horizontal sheets 13N, upper and lower surfaces of the mold layers 13 may be recessed. The horizontal sheets 13N may each include a monocrystalline silicon layer.

The horizontal sheets 13N may be formed by the trimming process (or a partial recessing process) for the mold layers 13 as described above, and each of inter-nano sheet recesses 28 may be formed between the horizontal sheets 13N disposed vertically. Each of the upper and lower surfaces of the horizontal sheets 13N may include a flat surface. Boundary portions of the body sheets 13A and the horizontal sheets 13N may be vertical or have a curvature. Each of sacrificial mold layers 12A may remain between the body sheets 13A stacked vertically.

During the second side recessing process, the second side fillers 22 and the sacrificial sheet dielectric layers 27 may not be removed.

As described above, a three-dimensional array of the horizontal sheets 13N and a three-dimensional array of the curved sheets 13P may be formed by the second side recessing process.

The three-dimensional array of the horizontal sheets 13N may include vertical and horizontal arrays of the horizontal sheets 13N. The vertical array of the horizontal sheets 13N may include the horizontal sheets 13N disposed vertically in the first direction D1. The horizontal array of the horizontal sheets 13N may include the horizontal sheets 13N disposed horizontally in the third direction D3.

The vertical and horizontal arrays of the horizontal sheets 13N may be formed by the second side recessing process. The vertical and horizontal arrays of the curved sheets 13P may be formed by the second side recessing process. Additionally, inter-nano sheet recesses 28 may be formed to expose all of the horizontal sheets 13N in the horizontal array by the second side recessing process.

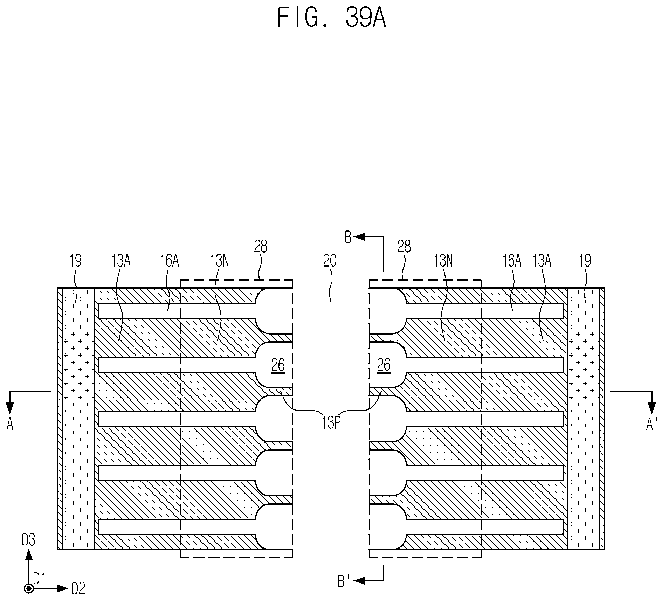

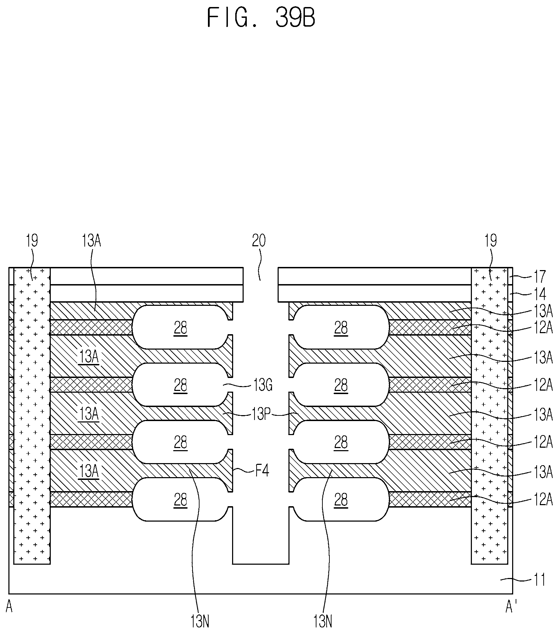

FIG. 39A is a plan view illustrating the structure at a horizontal sheet level for describing a method of forming sacrificial isolation layer-level openings 16A. FIG. 39B is a cross-sectional view of the structure taken along line A-A' illustrated in FIG. 39A. A cross-sectional view of the structure taken along line B-B' illustrated in FIG. 39A is referred to FIG. 15D.

Referring to FIGS. 39A and 39B, the sacrificial isolation layers 16 may be selectively stripped through the extending vertical recesses 26 and the inter-nano sheet recesses 28. Accordingly, each of the sacrificial isolation layer-level openings 16A may be formed between the body sheets 13A in the third direction D3.

Side surfaces of the sacrificial mold layers 12A, side surfaces of the body sheets 13A and side surfaces of the horizontal sheets 13N may be exposed in the third direction D3 by the sacrificial isolation layer-level openings 16A.

While the sacrificial isolation layers 16 are removed, the second side fillers 22 and the sacrificial nano sheet dielectric layers 27 may be removed and, accordingly, each of the sheet gaps 13G may be formed between the curved sheets 13P which are disposed vertically. The sheet gaps 13G and the inter-nano sheet recesses 28 may be continuous to each other. The curved sheets 13P may include wide side surfaces F4.

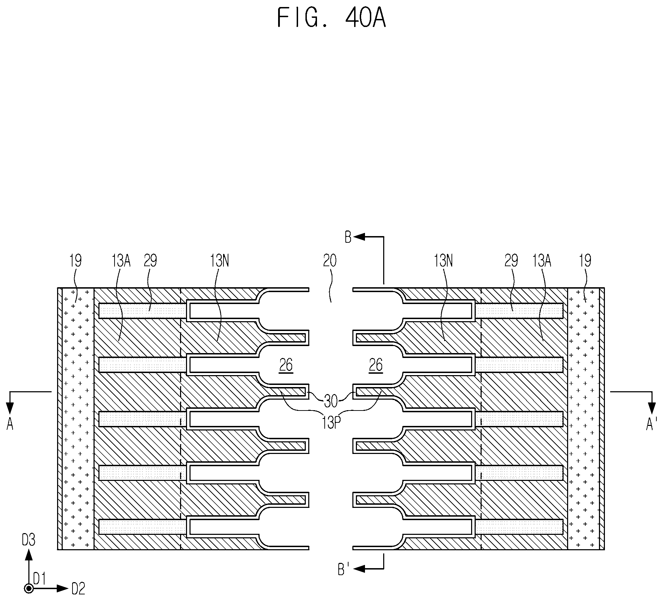

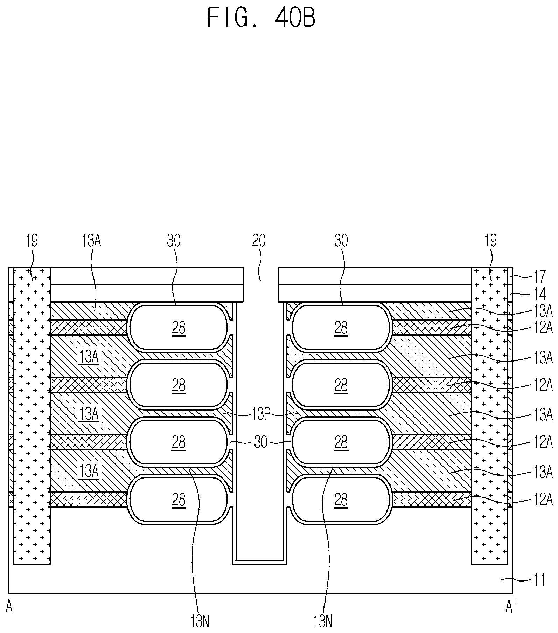

FIG. 40A is a plan view illustrating the structure at the horizontal sheet level for describing a method of forming a nano sheet dielectric layer 30. FIG. 40B is a cross-sectional view of the structure taken along line A-A' illustrated in FIG. 40A. A cross-sectional view of the structure taken along line B-B' illustrated in FIG. 40A is referred to FIG. 16C.

Referring to FIGS. 40A and 40B, first inter-cell dielectric layers 29 may be formed in the sacrificial isolation layer-level openings 16A. These first inter-cell dielectric layers 29 may each include a dielectric material, such as, for example, silicon oxide, silicon nitride, silicon carbon oxide, or a combination thereof. The forming process of the first inter-cell dielectric layers 29 may include forming (e.g., by deposition) a dielectric material that fills the sacrificial isolation layer-level openings 16A and performing an etch-back process on the dielectric material to refine the structure.

The first inter-cell dielectric layers 29 may fill portions of the sacrificial isolation layer-level openings 16A. The side surfaces of the sacrificial mold layers 12A and the side surfaces of the body sheets 13A may be covered by the first inter-cell dielectric layers 29 in the third direction D3. The first inter-cell dielectric layers 29 may expose the side surfaces of the horizontal sheets 13N.

Subsequently, the nano sheet dielectric layer 30 may be formed on exposed portions of the horizontal sheets 13N.

While the nano sheet dielectric layer 30 is formed, portions of the curved sheets 13P may be oxidized. The nano sheet dielectric layer 30 may fill the sheet gaps 13G.

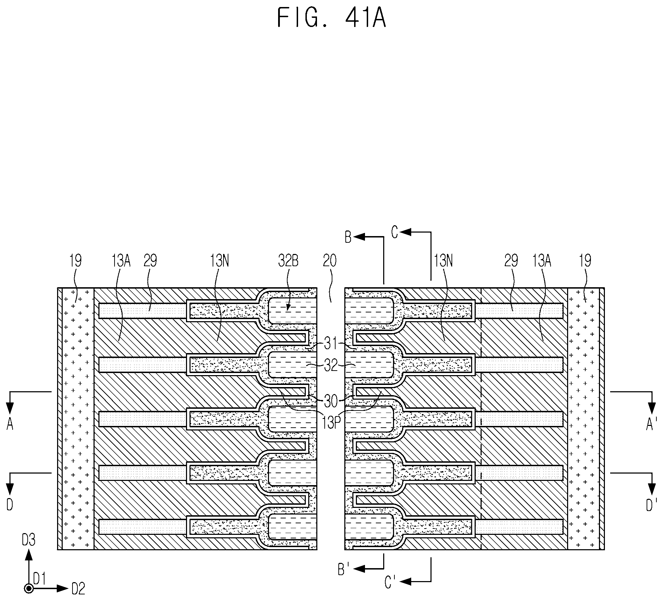

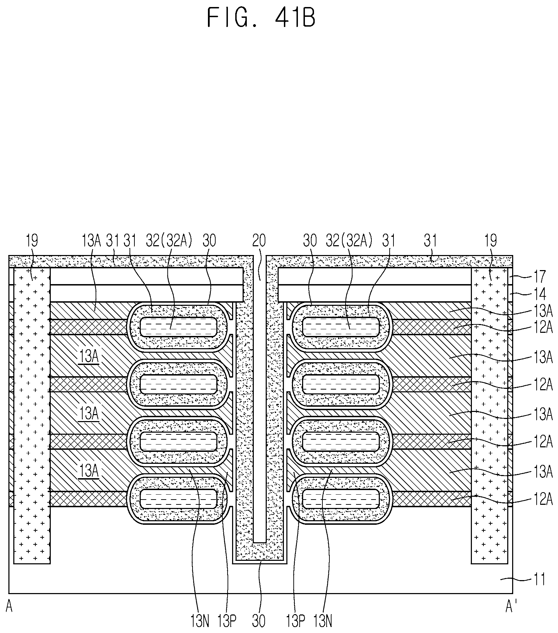

FIG. 41A is a plan view illustrating the structure at the horizontal sheet level for describing a method of forming a first spacer layer 31. FIG. 41B is a cross-sectional view of the structure taken along line A-A' illustrated in FIG. 41A. Cross-sectional views of the structure taken along lines B-B', C-C' and D-D' illustrated in FIG. 41A are referred to FIGS. 17D, 17E and 17F.

Referring to FIGS. 41A and 41B, the first spacer layer 31 may be formed on the nano sheet dielectric layer 30. The first spacer layer 31 may include, for example, silicon nitride. The first spacer layer 31 may surround and cover the horizontal sheets 13N on the nano sheet dielectric layer 30. The first spacer layer 31 may be thicker than the nano sheet dielectric layer 30. The nano sheet dielectric layer 30 and the first spacer layer 31 may also be formed on the surface of the substrate 11.

Second inter-cell dielectric layers 32 may be formed on the first spacer layer 31. The second inter-cell dielectric layers 32 may each include, for example, silicon oxide. Each of the second inter-cell dielectric layers 32 may be disposed between the horizontal sheets 13N in the first direction D1. Each of the second inter-cell dielectric layers 32 may be disposed between the curved sheets 13P in the third direction D3. The process of forming the second inter-cell dielectric layers 32 may include deposition and cutting of a dielectric material. Each of the second inter-cell dielectric layers 32 may be formed to include a horizontal segment 32A and a vertical segment 32B. The horizontal segment 32A and the vertical segment 32B may be dielectric materials having an integral structure. The horizontal segment 32A and the vertical segment 32B may include the same dielectric material. The horizontal segment 32A of the second inter-cell dielectric layer 32 may horizontally extend in the third direction D3. The vertical segment 32B of the second inter-cell dielectric layer 32 may vertically extend in the first direction D1. The horizontal segment 32A of the second inter-cell dielectric layer 32 may be disposed between the horizontal sheets 13N in the first direction D1, and the vertical segment 32B of the second inter-cell dielectric layer 32 may be disposed between the curved sheets 13P in the third direction D3.

As described above, the horizontal segment 32A of the second inter-cell dielectric layer 32 may be disposed between the horizontal sheets 13N in the first direction D1, and the vertical segment 32B of the second inter-cell dielectric layer 32 may be disposed between the curved sheets 13P.

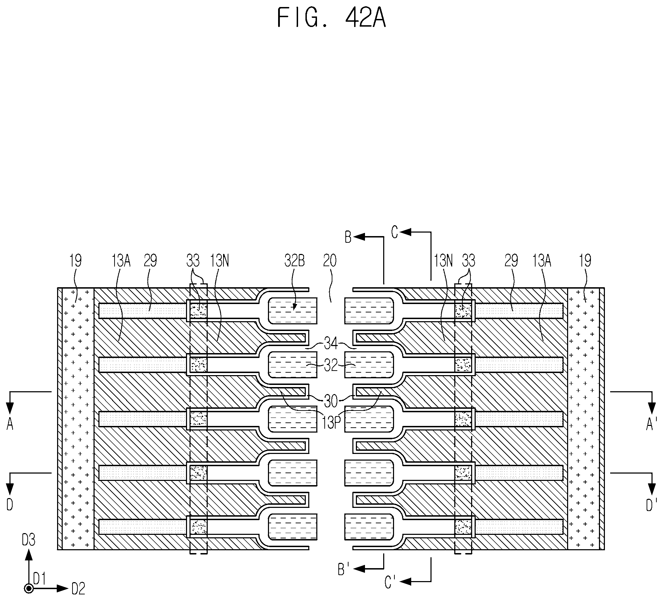

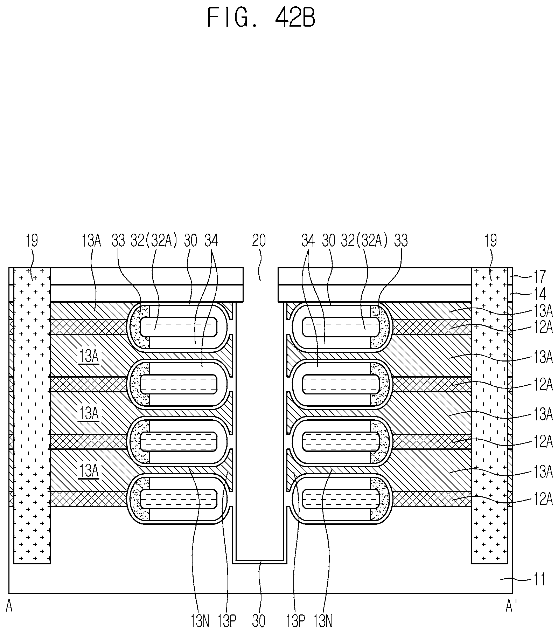

FIG. 42A is a plan view illustrating the structure at the horizontal sheet level for describing a method of forming a first spacer 33. FIG. 42B is a cross-sectional view of the structure taken along line A-A' illustrated in FIG. 42A. Cross-sectional views of the structure taken along lines B-B', C-C' and D-D' illustrated in FIG. 42A are referred to FIGS. 18D, 18E and 18F.

Referring to FIGS. 42A and 42B, the first spacer layers 31 may be recessed through the first linear opening 20 and the remaining first spacer layers may become the first spacer 33. The first spacer 33 may correspond to the first spacer SP1 as described above with reference to FIGS. 3B and 4A.

As the first spacer 33 is formed, linear recesses 34 surrounding the horizontal sheets 13N may be formed on the nano sheet dielectric layer 30. The linear recesses 34 may be referred to as linear surrounding recesses 34. Each of the second inter-cell dielectric layers 32 may be disposed between the linear surrounding recesses 34 that are vertically disposed. The linear surrounding recesses 34 may extend in the third direction D3. A portion of the nano sheet dielectric layer 30 may be exposed by the linear surrounding recesses 34. All side surfaces of the vertical segments 32B of the second inter-cell dielectric layers 32 may be exposed by the linear surrounding recesses 34. Three side surfaces of the horizontal segments 32A of the second inter-cell dielectric layers 32 may be exposed by the linear surrounding recesses 34.

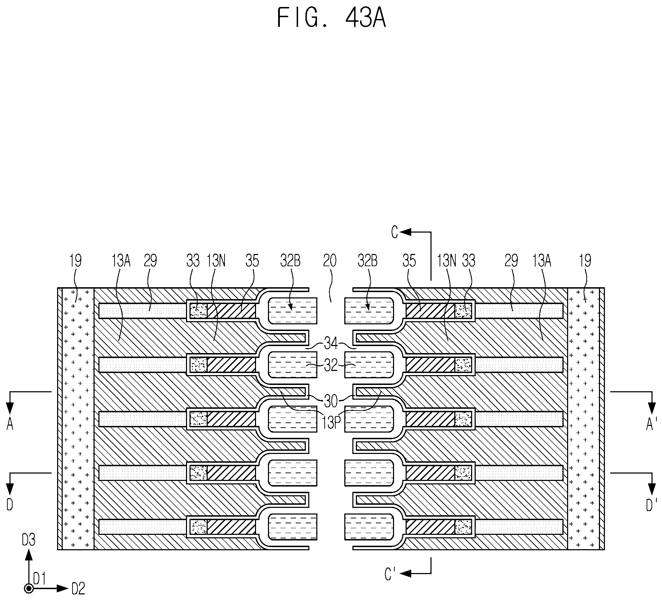

FIG. 43A is a plan view illustrating the structure at the horizontal sheet level for describing a method of forming first conductive lines 35.

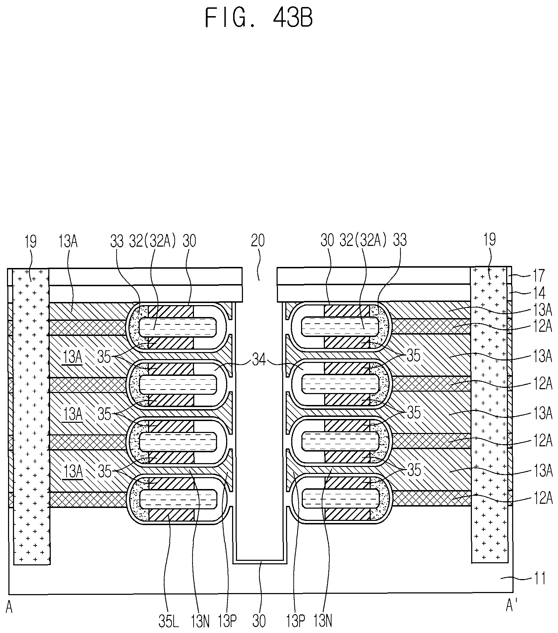

FIG. 43B is a cross-sectional view of the structure taken along line A-A' illustrated in FIG. 43A. Cross-sectional views of the structure taken along lines C-C' and D-D' illustrated in FIG. 43A are referred to FIGS. 19C and 19D.

Referring to FIGS. 43A and 43B, the first conductive lines 35 may be formed to horizontally and partially fill the linear surrounding recesses 34. The first conductive lines 35 may horizontally extend in the third direction D3. The first conductive lines 35 may correspond to the first conductive lines WL as described above with reference to FIGS. 3A, 3B, 4A, 4C and 4D.

Forming the first conductive lines 35 may include depositing a conductive material that fills the linear surrounding recesses 34 on the nano sheet dielectric layer 30 followed by a horizontal etch-back process applied on the conductive material. Each of the first conductive lines 35 may simultaneously surround the horizontal sheets 13N at the same horizontal level in the third direction D3.

A lower-level dummy conductive line 35L may be formed on the surface of the substrate 11, and an upper-level dummy conductive line 35U may be formed above an uppermost first conductive line 35. Each of the lower-level and upper-level dummy conductive lines 35L and 35U may have a non-surrounding shape.

As described above, the first conductive lines 35 may be formed to surround the horizontal sheets 13N in the vertical arrangement and be horizontally oriented. The horizontal segments 32A of the second inter-cell dielectric layers 32 may be disposed between the first conductive lines 35 in the first direction D1.

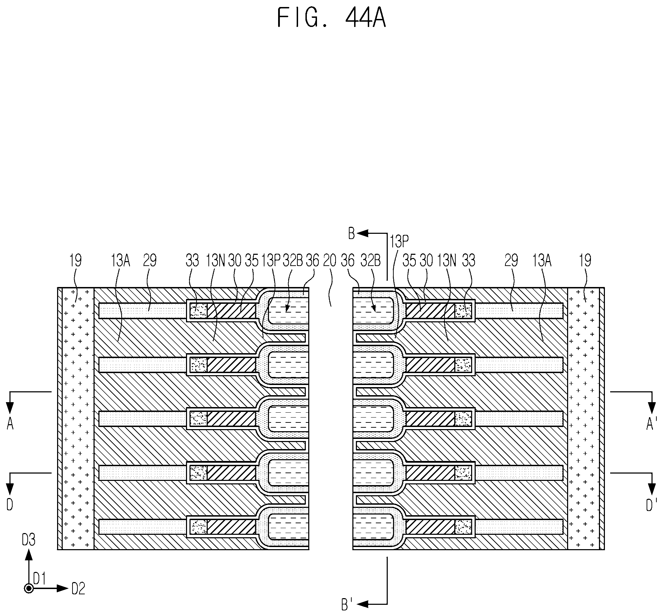

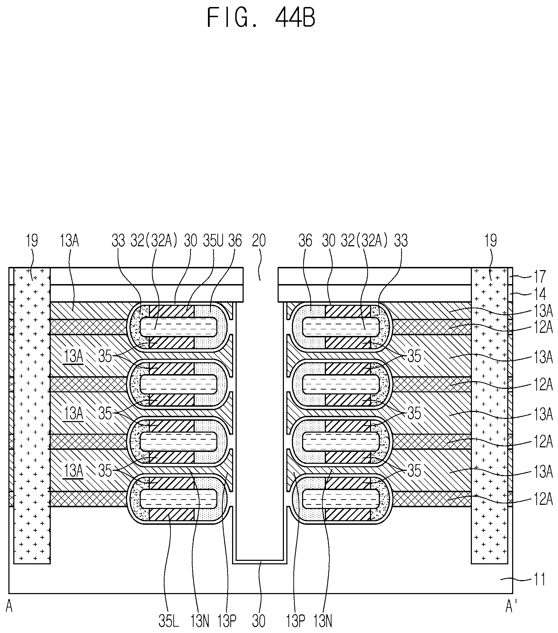

FIG. 44A is a plan view illustrating the structure at the horizontal sheet level for describing a method of forming a second spacer 36. FIG. 44B is a cross-sectional view of the structure taken along line A-A' illustrated in FIG. 44A. Cross-sectional views of the structure taken along lines B-B' and D-D' illustrated in FIG. 44A are referred to FIGS. 20D and 20E.

Referring to FIGS. 44A and 44B, the second spacer 36 may be formed on one side of each of the first conductive lines 35. The second spacer 36 may include silicon oxide, silicon nitride, silicon carbon oxide, an embedded air gap, or a combination thereof. A process for forming the second spacer 36 may include depositing a spacer material followed by an etch-back process applied on the spacer material. The second spacer 36 may include a stack of a silicon oxide liner and a silicon nitride liner. A portion of the silicon nitride liner may protrude.

The second spacer 36 may be disposed on one side of each of the first conductive lines 35 and also extend in the third direction D3. The second spacer 36 may surround portions of the horizontal sheets 13N disposed at the same horizontal level in the third direction D3. The second spacer 36 may surround the curved sheets 13P disposed at the same horizontal level in the third direction D3. The second spacer 36 may surround the curved sheets 13P disposed in the first direction D1. The second spacer 36 may cover side surfaces of the horizontal segments 32A of the second inter-cell dielectric layers 32. In addition, the second spacer 36 may extend to cover side surfaces of the vertical segments 32B of the second inter-cell dielectric layers 32.

In some embodiments, the second spacer 36 may have a double structure of an outer spacer 36A and an inner spacer 36B as described above with reference to FIGS. 30A to 30D.

Subsequently, as described above with reference to FIGS. 21A to 21C, contact level recesses 38 may be formed. Forming the contact level recesses 38 may include cutting the nano sheet dielectric layer 30 from the first linear opening 20, removing the sacrificial sheet layers 23, and recessing one side of the curved sheets 13P. A series of processes for forming the contact level recesses 38 may be performed using the second spacer 36 and the vertical segment 32B of the second inter-cell dielectric layer 32 as barriers.

As the contact level recesses 38 are formed, horizontal lengths of the curved sheets 13P may be shortened, and the contact level recesses 38 may each include an inner side 37. The inner sides 37 of the contact level recesses 38 may expose edge portions of the curved sheets 13P. The contact level recesses 38 may be formed to be self-aligned with the second spacer 36.

Subsequently, a series of processes described above with reference to FIGS. 22A to 28B may be performed.

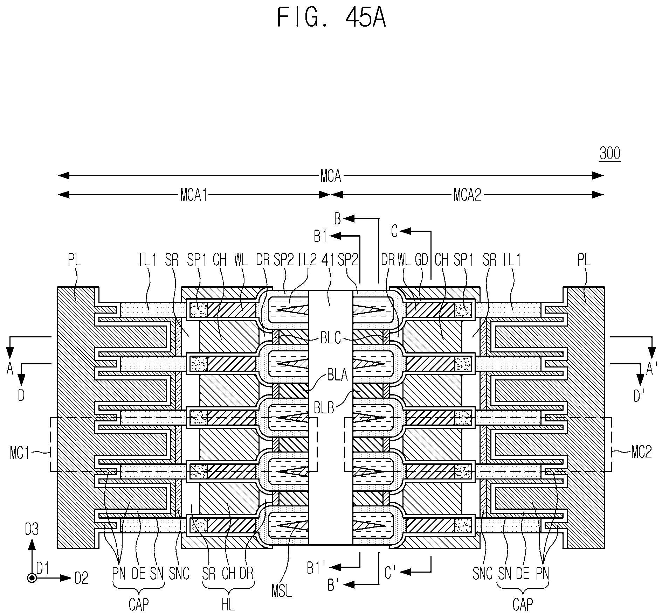

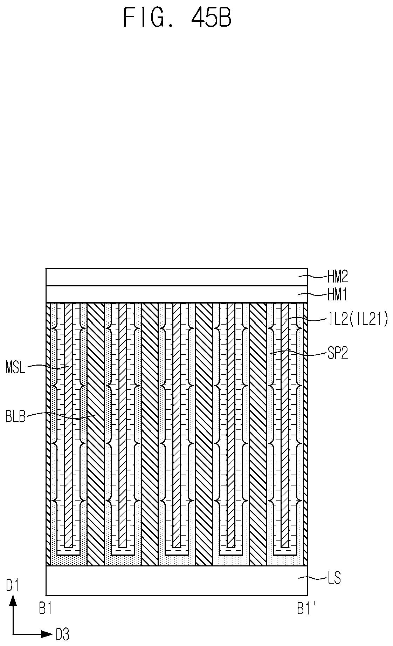

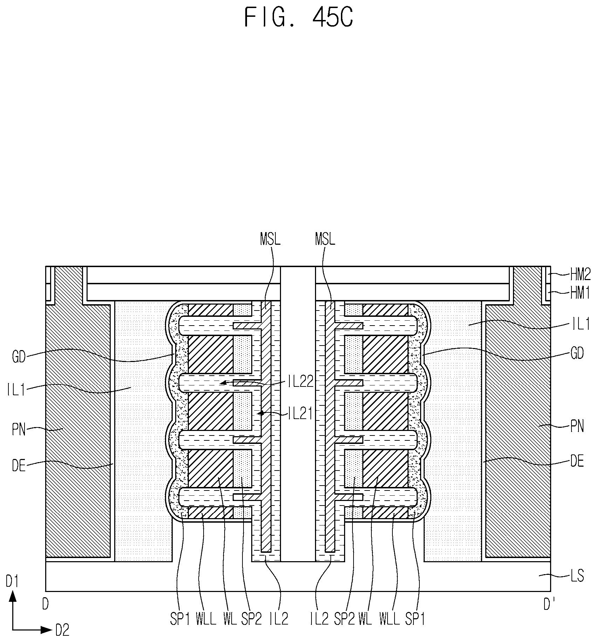

FIG. 45A is a schematic plan view illustrating a semiconductor device 300 in accordance with an embodiment of the present disclosure. FIG. 45B is a cross-sectional view of the semiconductor device 300 taken along line B1-B1' illustrated in FIG. 45A. FIG. 45C is a cross-sectional view of the semiconductor device 300 taken along line D-D' illustrated in FIG. 45A. The semiconductor devices 300 illustrated in FIGS. 45A to 45C may be similar to the semiconductor devices 100 illustrated in FIGS. 3A to 4E. The semiconductor devices 100 and 300 may have the same configurations except for a shield line MSL. Cross-sectional views of the semiconductor devices 300 taken along lines A-A', B-B' and C-C' illustrated in FIG. 45A are referred to FIGS. 4A, 4B and 4C.

Referring to FIG. 45A to 45C, the semiconductor device 300 may include a lower structure LS and a memory cell array MCA. The memory cell array MCA may include a first sub-cell array MCA1 and a second sub-cell array MCA2. The first sub-cell array MCA1 may include a three-dimensional array of first memory cells MC1. The second sub-cell array MCA2 may include a three-dimensional array of second memory cells MC2. Each of the first memory cells MC1 may include a first vertical conductive line BLA, a switching element TR, and a data storage element CAP, and the switching element TR may include a first conductive line WL, a nano sheet dielectric layer GD, and a nano sheet HL. Each of the second memory cells MC2 may include a second vertical conductive line BLB, a switching element TR, and a data storage element CAP, and the switching element TR may include a first conductive line WL, a nano sheet dielectric layer GD, and a nano sheet HL. The nano sheets HL of the first and second memory cells MC1 and MC2 may each include a first doped region DR, a second doped region SR, and a channel CH. First contact nodes BLC may be formed on the first doped regions DR of the first and second memory cells MC1 and MC2. Second contact nodes SNC may be formed on the second doped regions SR of the first and second memory cells MC1 and MC2.

The first memory cells MC1 of the first sub-cell array MCA1 may share the first vertical conductive line BLA, and the second memory cells MC2 of the second sub-cell array MCA2 may share the second vertical conductive line BLB.

Each of first inter-cell dielectric layers IL1 may be disposed between the data storage elements CAP adjacent to each other in a third direction D3. Each of second inter-cell dielectric layers IL2 may be disposed between the first conductive lines WL stacked vertically in a first direction D1. Each of third inter-cell dielectric layers IL3 may be disposed between first electrodes SN of the data storage elements CAP stacked vertically in the first direction D1.

Each of the first memory cells MC1 and each of the second memory cells MC2 may further include a first spacer SP1 and a second spacer SP2.

Each of the second inter-cell dielectric layers IL2 may include a horizontal segment IL22 and a vertical segment IL21. Each of the horizontal segment IL22 and vertical segment IL21 of the second inter-cell dielectric layer IL2 may be a dielectric material having an integral structure. The horizontal segment IL22 and vertical segment IL21 of the second inter-cell dielectric layer IL2 may intersect each other. The horizontal segment IL22 may extend in the third direction D3, and the vertical segment IL21 may extend in the first direction D1. One edge of the horizontal segment IL22 may include convex patterns and concave patterns between the convex patterns. The vertical segment IL21 may partially fill the concave patterns and also extend in the first direction D1. Both sides of the vertical segment IL21 may directly contact the convex patterns. A spacer gap may be defined by the vertical segment IL21, the convex patterns and the concave patterns, and a portion of the second spacer SP2 may fill the spacer gap and also surround the convex patterns.

The horizontal segment IL22 of the second inter-cell dielectric layer IL2 may be disposed between the first conductive lines WL in the first direction D1, and the vertical segment IL21 of the second inter-cell dielectric layer IL2 may be disposed between second conductive lines BLA and BLB in the third direction D3. The horizontal segment IL22 of the second inter-cell dielectric layer IL2 may be an isolation layer that isolates the first conductive lines WL adjacent to each other in the first direction D1, and the vertical segment IL21 of the second inter-cell dielectric layer IL2 may be an isolation layer that isolates the second conductive lines BLA and BLB adjacent to each other in the third direction D3. As described, the second inter-cell dielectric layer IL2 may include the horizontal segment IL22 and the vertical segment IL21, and the second conductive lines BLA and BLB may be formed to be self-aligned with the second spacer SP2.

Each of the shield lines MSL may be formed between the second conductive lines BLA and BLB in the third direction D3. As illustrated in FIG. 45C, the shield lines MSL may be disposed inside the vertical segments IL21 of the second inter-cell dielectric layers IL2. For example, the shield lines MSL may be embedded in the vertical segments IL21 of the second inter-cell dielectric layers IL2.

The shield lines MSL may block interference between the first vertical conductive lines BLA disposed in the third direction D3. The shield lines MSL may block interference between the second vertical conductive lines BLB disposed in the third direction D3.

The second conductive lines BLA and BLB and the shield lines MSL may be formed simultaneously. The second conductive lines BLA and BLB and the shield lines MSL may include the same material. Each of the shield lines MSL may include a metal-based material, such as, for example, titanium nitride, tungsten, or a combination thereof.

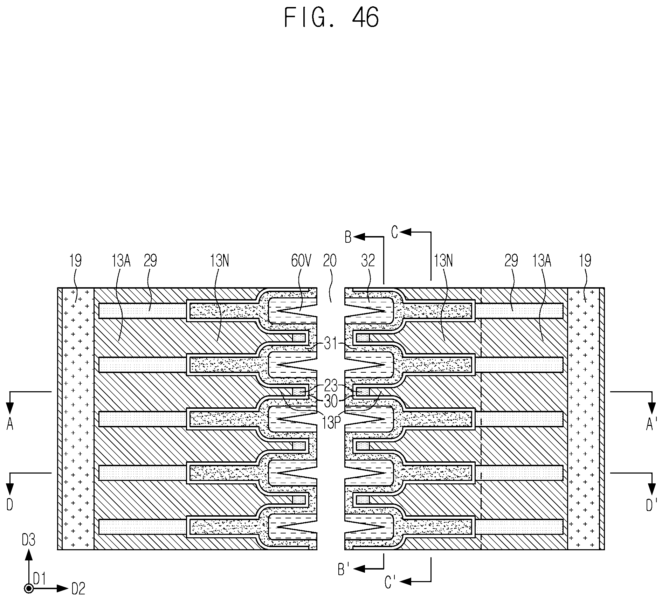

FIGS. 46 to 53 illustrate various plan views of a semiconductor device formed utilizing a method for fabricating the semiconductor device in accordance with an embodiment of the present disclosure.

Curved sheets 13P, horizontal sheets 13N, first inter-cell dielectric layers 29, second inter-cell dielectric layers 32 and nano sheet dielectric layers 30 may be formed by a series of processes as described above with reference to FIGS. 5A to 18D.

FIG. 46 is a plan view illustrating a structure at a horizontal sheet level for describing a method of forming a first spacer layer 31. Cross-sectional views of the structure taken along lines A-A', B-B', C-C' and D-D' illustrated in FIG. 46 are referred to FIGS. 17C, 17D, 17E and 17F.

Referring to FIGS. 46, 17C, 17D, 17E and 17F, the first spacer layer 31 may be formed on the nano sheet dielectric layer 30. The first spacer layer 31 may include, for example, silicon nitride. The first spacer layer 31 may surround and cover the horizontal sheets 13N on the nano sheet dielectric layer 30. The first spacer layer 31 may be thicker than the nano sheet dielectric layer 30. The nano sheet dielectric layer 30 and the first spacer layer 31 may also be formed on a surface of a substrate 11.

The first spacer layer 31 may surround the horizontal sheets 13N in the first direction D1 and also surround portions of the curved sheets 13P and portions of the sacrificial sheet layers 13 in the second direction D2.

The second inter-cell dielectric layers 32 may be formed on the first spacer layer 31. The second inter-cell dielectric layers 32 may each include, for example, silicon oxide. Each of the second inter-cell dielectric layers 32 may be disposed between the horizontal sheets 13N in the first direction D1. Each of the second inter-cell dielectric layers 32 may be disposed between the curved sheets 13P in the third direction D3. Each of the second inter-cell dielectric layers 32 may be disposed between sacrificial sheet layers 23 in the third direction D3. Deposition and cutting of a dielectric material may be performed to form the second inter-cell dielectric layers 32. Each of the second inter-cell dielectric layers 32 may include a horizontal segment 32A and a vertical segment 32B, and the horizontal segment 32A and the vertical segment 32B may be dielectric materials having an integral structure. The horizontal segment 32A of the second inter-cell dielectric layer 32 may horizontally extend in the third direction D3, and the vertical segment 32B of the second inter-cell dielectric layer 32 may vertically extend in the first direction D1. The horizontal segment 32A of the second inter-cell dielectric layer 32 may be disposed between the horizontal sheets 13N in the first direction D1, and the vertical segment 32B of the second inter-cell dielectric layer 32 may be disposed between the curved sheets 13P and between the sacrificial sheet layers 23 in the third direction D3.

As described above, the horizontal segment 32A of the second inter-cell dielectric layer 32 may be disposed between the horizontal sheets 13N in the first direction D1, and the vertical segment 32B of the second inter-cell dielectric layer 32 may be disposed between the curved sheets 13P and between the sacrificial sheet layers 23.

The vertical segment 32B of the second inter-cell dielectric layer 32 may include a vertical recess portion 60V extending in the first direction D1, and the vertical recess portion 60V may be disposed between the sacrificial sheet layers 23 in the third direction D3.

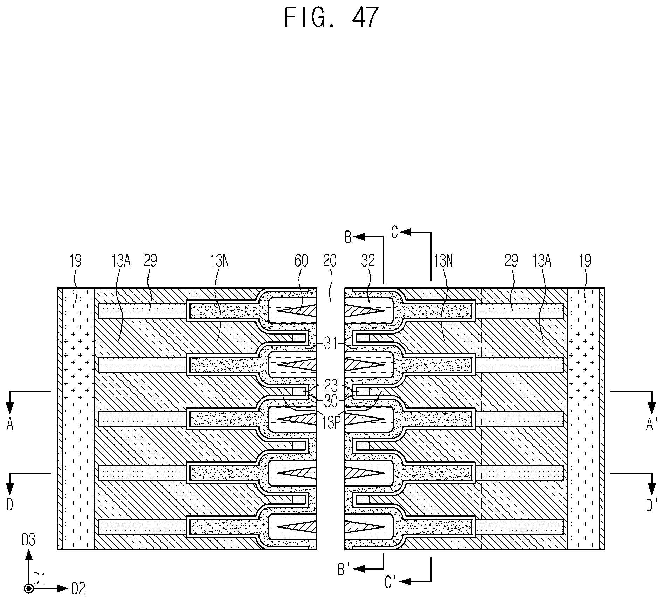

Referring to FIG. 47, a sacrificial shield line 60 may be formed to fill the vertical recess portion 60V of the vertical segment 32B of the second inter-cell dielectric layer 32. The sacrificial shield line 60 may include a conductive material. The sacrificial shield line 60 may include polysilicon. Some side surfaces of the sacrificial shield line 60 may be covered by the vertical segment 32B of the second inter-cell dielectric layer 32.

Forming the sacrificial shield line 60 may include depositing a sacrificial shield material and performing a side cutting process on the sacrificial shield material. For example, the sacrificial shield line 60 may be formed to be self-aligned with respect to the second spacer 32 through the side cutting process without a mask.

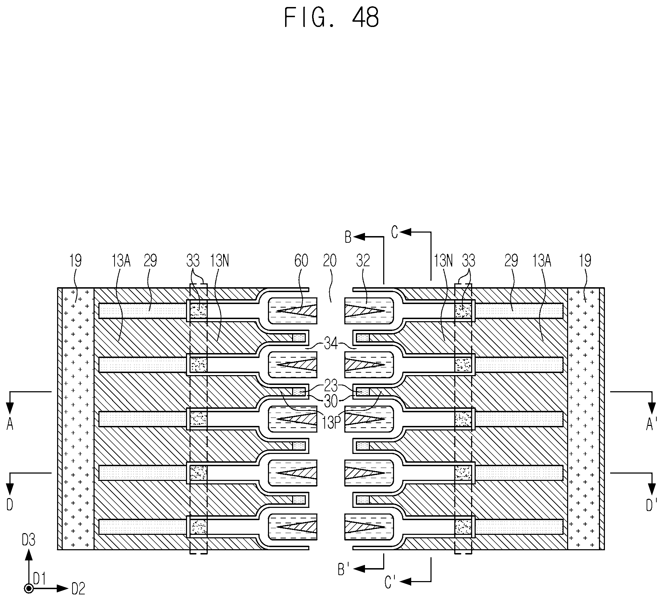

FIG. 48 is a plan view illustrating the structure at the horizontal sheet level for describing a method of forming a first spacer 33. Cross-sectional views of the structure taken along lines A-A', B-B', C-C' and D-D' illustrated in FIG. 48 are referred to FIGS. 18C, 18D, 18E and 18F.

Referring to FIGS. 48, 18C, 18D, 18E and 18F, the first spacer layers 31 may be recessed through a first linear opening 20. The remaining first spacer layers may become the first spacer 33.

As the first spacer 33 is formed, linear surrounding recesses 34 surrounding the horizontal sheets 13N may be formed on the nano sheet dielectric layer 30. Each of the second inter-cell dielectric layers 32 may be disposed between the linear surrounding recesses 34 that are vertically disposed. The linear surrounding recesses 34 may extend in the third direction D3. A portion of the nano sheet dielectric layer 30 may be exposed by the linear surrounding recesses 34. All side surfaces of the vertical segments 32B of the second inter-cell dielectric layers 32 may be exposed by the linear surrounding recesses 34 (refer to FIG. 18B). Three side surfaces of the horizontal segments 32A of the second inter-cell dielectric layers 32 may be exposed by the linear surrounding recesses 34 (refer to FIG. 18C).

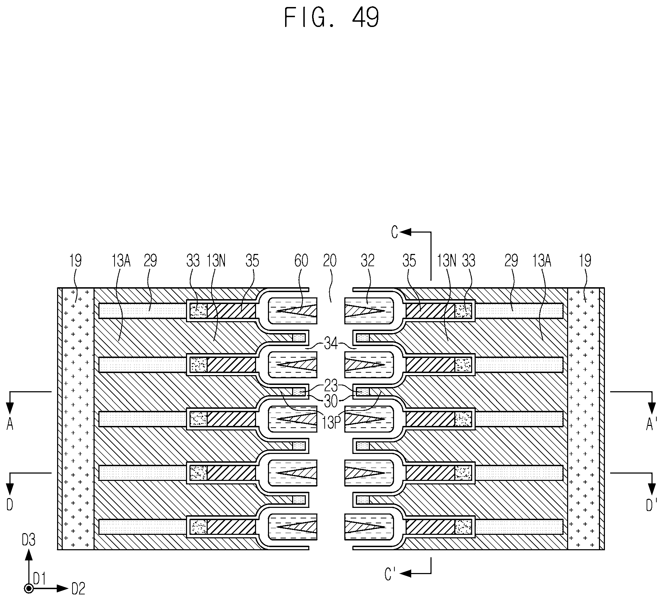

FIG. 49 is a plan view illustrating the structure at the horizontal sheet level for describing a method of forming first conductive lines 35. Cross-sectional views of the structure taken along lines A-A', C-C' and D-D' illustrated in FIG. 49 are referred to FIGS. 19B, 19C and 19D.

Referring to FIGS. 49, 19B, 19C and 19D, the first conductive lines 35 may be formed to horizontally and partially fill the linear surrounding recesses 34. The first conductive lines 35 may horizontally extend in the third direction D3.

Forming the first conductive lines 35 may include depositing a conductive material that fills the linear surrounding recesses 34 on the nano sheet dielectric layer 30, followed by a horizontal etch-back process applied to the conductive material. Each of the first conductive lines 35 may simultaneously surround the horizontal sheets 13N at the same horizontal level along the third direction D3.

As described above, the first conductive lines 35 may be formed to surround the horizontal sheets 13N in a vertical arrangement and be horizontally oriented. The horizontal segments 32A of the second inter-cell dielectric layers 32 may be disposed between the first conductive lines 35 in the first direction D1.

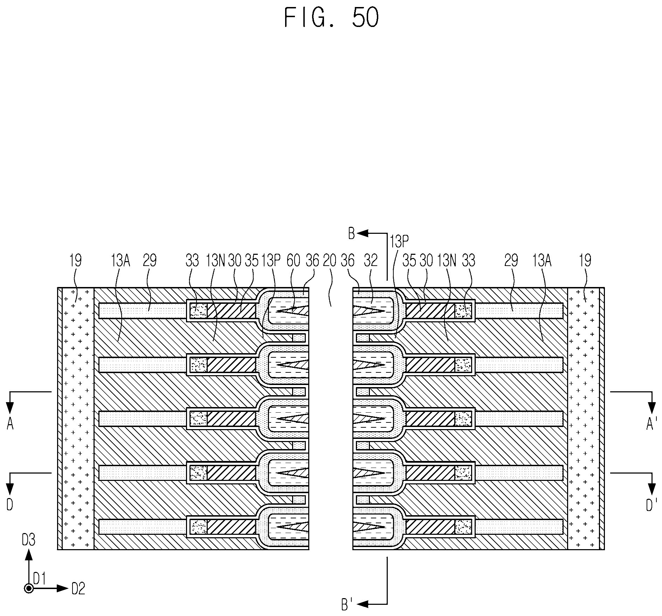

FIG. 50 is a plan view illustrating the structure at the horizontal sheet level for describing a method of forming a second spacer 36. Cross-sectional views of the structure taken along lines A-A', B-B' and D-D' illustrated in FIG. 50 are referred to FIGS. 20C, 20D and 20E.

Referring to FIGS. 50, 20C, 20D and 20E, the second spacer 36 may be formed on one side of each of the first conductive lines 35. The second spacer 36 may include silicon oxide, silicon nitride, silicon carbon oxide, an embedded air gap, or a combination thereof. A process for forming the second spacer 36 may include depositing a spacer material followed by an etch-back process applied on the spacer material. The second spacer 36 may include a stack of a silicon oxide liner and a silicon nitride liner, and a portion of the silicon nitride liner may protrude, i.e., a portion of the silicon nitride liner may extend outward, creating a protrusion.

The second spacer 36 may be disposed on one side of each of the first conductive lines 35 and also extend in the third direction D3. The second spacer 36 may surround portions of the horizontal sheets 13N disposed at the same horizontal level in the third direction D3. The second spacer 36 may surround the fan-like curved sheets 13P disposed at the same horizontal level in the third direction D3. The second spacer 36 may surround the curved sheets 13P disposed in the first direction D1. The second spacer 36 may cover side surfaces of the horizontal segments 32A of the second inter-cell dielectric layers 32. In addition, the second spacer 36 may extend to cover side surfaces of the vertical segments 32B of the second inter-cell dielectric layers 32.

In some embodiments, the second spacer 36 may have a double structure of an outer spacer 36A and an inner spacer 36B as described above with reference to FIGS. 30A to 30D.

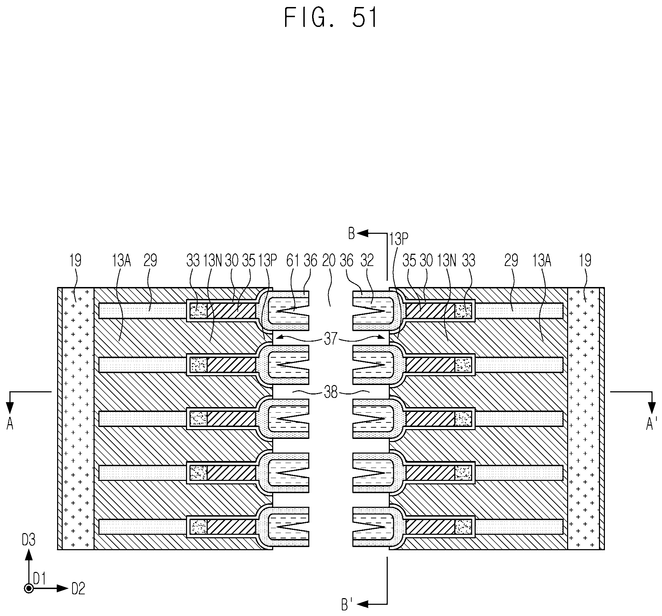

FIG. 51 is a plan view illustrating the structure at the horizontal sheet level for describing a method of forming contact level recesses 38. Cross-sectional views of the structure taken along lines A-A' and B-B' illustrated in FIG. 51 are referred to FIGS. 21B and 21C.

Referring to FIGS. 51, 21B and 21C, one side of the curved sheets 13P may be recessed to form the contact level recesses 38. Forming the contact level recesses 38 may include cutting the nano sheet dielectric layer 30 from the first linear opening 20, removing the sacrificial sheet layers 23, and recessing one side of the curved sheets 13P. A series of processes for forming the contact level recesses 38 may be performed using the second spacer 36 and the vertical segment 32B of the second inter-cell dielectric layer 32 as barriers.

As the contact level recesses 38 are formed, the horizontal lengths of the curved sheets 13P may be shortened, and the contact level recesses 38 may each include an inner side 37. The inner sides 37 of the contact level recesses 38 may expose edge portions of the curved sheets 13P. Additionally, the contact level recesses 38 may be formed to be self-aligned with the second spacer 36.

While the contact level recesses 38 are formed by removing the sacrificial sheet layers 23, sacrificial shield lines 60 may be removed. Accordingly, the vertical segments 32B of the second inter-cell dielectric layers 32 may include vertical shield recess portions 61 extending in the first direction D1, and each of the vertical shield recess portions 61 may be disposed between the contact level recesses 38 in the third direction D3.

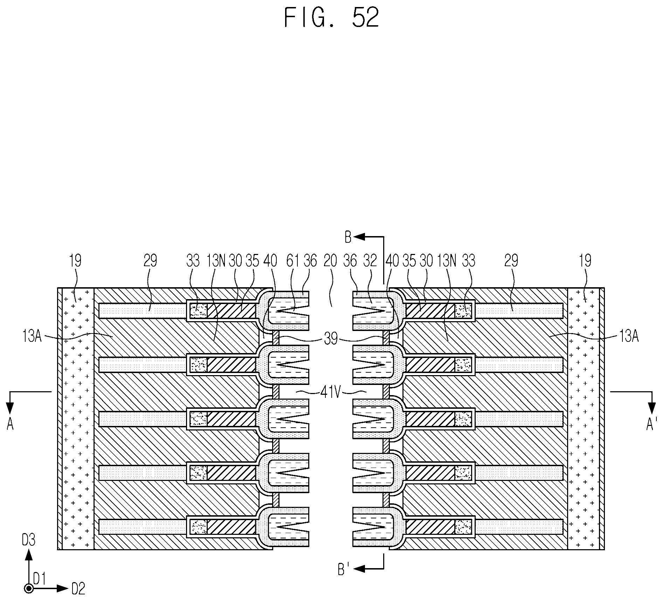

FIG. 52 is a plan view illustrating the structure at the horizontal sheet level for describing a method of forming first contact nodes 39. Cross-sectional views of the structure taken along lines A-A' and B-B' illustrated in FIG. 52 are referred to FIGS. 22B and 22C.

Referring to FIGS. 52, 22B and 22C, the first contact nodes 39 may be formed on the inner sides 37 of the contact level recesses 38. Forming the first contact nodes 39 may include selective epitaxial growth (SEG). For example, a semiconductive material may be grown from exposed surfaces of the curved sheets 13P through the SEG. The first contact nodes 39 may include SEG Si. Because the curved sheets 13P include monocrystalline silicon, a silicon layer may be epitaxially grown along crystal surfaces of the exposed surfaces of the curved sheets 13P.

The first contact nodes 39 may include dopants. When a silicon layer is grown using the SEG, the dopants may be doped in situ. Accordingly, the first contact nodes 39 may be doped epitaxial layers. The first contact nodes 39 may each include an N-type dopant. The N-type dopant may include phosphorus, arsenic, antimony, or a combination thereof. The first contact nodes 39 may each include a phosphorus-doped silicon epitaxial layer formed by the SEG, i.e., doped SEG SiP.

First doped regions 40 may be formed in the curved sheets 13P. A heat treatment process may be performed to form the first doped regions 40 for diffusing the dopants from the first contact nodes 39. In another method of forming the first doped regions 40, a gas phase doping method may be applied.

While the first contact nodes 39 are formed, dummy contact nodes 39L may be formed on the surface of the substrate 11. The first contact nodes 39 and the dummy contact nodes 39L may be made of the same material. For example, the dummy contact nodes 39L may each include a doped epitaxial layer formed by the SEG. While the first doped regions 40 are formed, a dummy doped region (not illustrated) may be formed in the substrate 11, and the dummy doped region may include impurities diffused from the dummy contact nodes 39L.

After the first contact nodes 39 are formed, vertical openings 41V exposing portions of the second spacer 36 and the first contact nodes 39 may be defined.

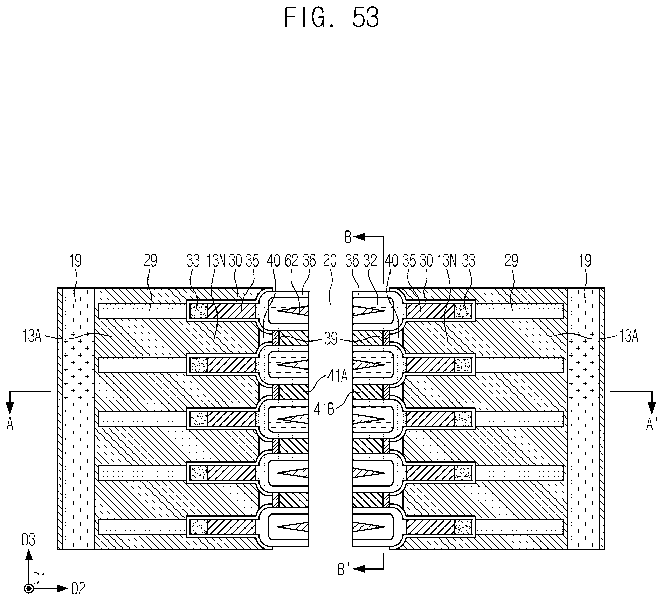

FIG. 53 is a plan view illustrating the structure at the horizontal sheet level for describing a method of forming second conductive lines 41A and 41B. Cross-sectional views of the structure taken along lines A-A' and B-B' illustrated in FIG. 53 are referred to FIGS. 23C and 23D.

Referring to FIGS. 53, 23C and 23D, the second conductive lines 41A and 41B may be formed on the first contact nodes 39. The second conductive lines may include a first vertical conductive line 41A and a second vertical conductive line 41B. The first vertical conductive line 41A and the second vertical conductive line 41B may be spaced apart from each other. The first vertical conductive line 41A may be coupled in common to the first contact nodes 39 disposed in the first direction D1. The second vertical conductive line 41B may be coupled in common to the first contact nodes 39 disposed in the first direction D1.

The first and second vertical conductive lines 41A and 41B may each include a metal-based material. The first and second vertical conductive lines 41A and 41B may each include titanium nitride, tungsten, or a combination thereof. The first and second vertical conductive lines 41A and 41B may cover the first contact nodes 39. The first and second vertical conductive lines 41A and 41B may correspond to the first and second vertical conductive lines BLA and BLB illustrated in FIGS. 3B and 4A.

Forming the first and second vertical conductive lines 41A and 41B may include depositing a vertical conductive line material and performing an etch-back process on the vertical conductive line material. For example, the first and second vertical conductive lines 41A and 41B may be formed to be self-aligned with the second spacer 32 through a blanket etch-back process without a mask.

Bottom portions of the first vertical conductive lines 41A and bottom portions of the second vertical conductive lines 41B may be discontinuous to each other. The first and second vertical conductive lines 41A and 41B may be disposed in vertical openings (reference numeral "41V" of FIG. 52). The first and second vertical conductive lines 41A and 41B may vertically extend in the first direction D1. Inner surfaces of the first and second vertical conductive lines 41A and 41B may have non-linear profiles.

The first and second vertical conductive lines 41A and 41B may include protruding inner portions (refer to reference symbol "IBL" of FIG. 4A). The protruding inner portions of the first and second vertical conductive lines 41A and 41B may be electrically coupled to the first doped regions 40 through the first contact nodes 39.

The first and second vertical conductive lines 41A and 41B may be supported by the second spacer 36. The first and second vertical conductive lines 41A and 41B which are formed to be self-aligned with the second spacer 36 may be referred to as a "self-aligned bit line (SABL) structure".

Shield lines 62 may be formed while the second conductive lines 41A and 41B are formed. The shield lines 62 may fill the vertical shield recesses (reference numeral "61" of FIG. 52). The second conductive lines 41A and 41B and the shield lines 62 may be formed simultaneously. The second conductive lines 41A and 41B and the shield lines 62 may include the same material. The shield lines 62 may each include a metal-based material. The shield lines 62 may each include titanium nitride, tungsten, or a combination thereof.

As described above, the second spacer 36 may include the vertical openings 41V, and the first and second vertical conductive lines 41A and 41B may be formed in the vertical openings 41V of the second spacer 36. The vertical segments 32B of the second inter-cell dielectric layers 32 may be disposed between the second conductive lines 41A and 41B in the third direction D3. The shield lines 62 may be disposed between the second conductive lines 41A and 41B in the third direction D3. The shield lines 62 may be disposed in the vertical segments 32B of the second inter-cell dielectric layers 32. Some side surfaces (i.e., three of four side surfaces) of the vertical segments 32B of the second inter-cell dielectric layers 32 may be covered by the second spacer 36.

The shield lines 62 may block interference between the second conductive lines 41A and 41B disposed in the third direction D3.

In some embodiments, as illustrated in FIGS. 29A to 29D, the semiconductor device 200 may further include the shield lines MSL illustrated in FIGS. 45A to 45C.

In some embodiments, the semiconductor device illustrated in FIGS. 39A to 49B may further include the shield lines MSL illustrated in FIGS. 50A to 50C.

In some embodiments, the sacrificial sheet layers 23 and the additional sacrificial sheet layers 24 according to embodiments may be omitted.

In some embodiments, the first conductive lines WL may extend to surround a portion or all of surfaces of curved sheets.

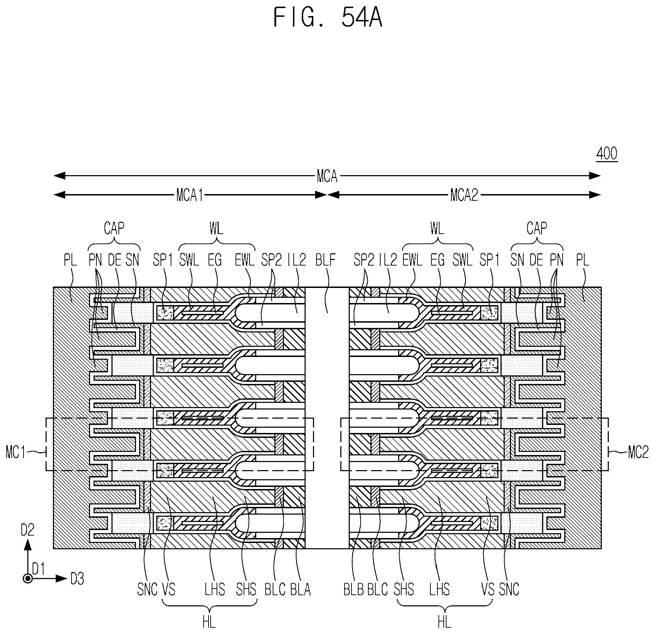

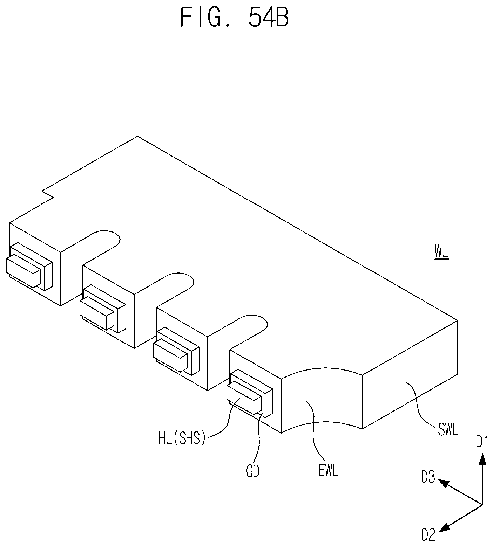

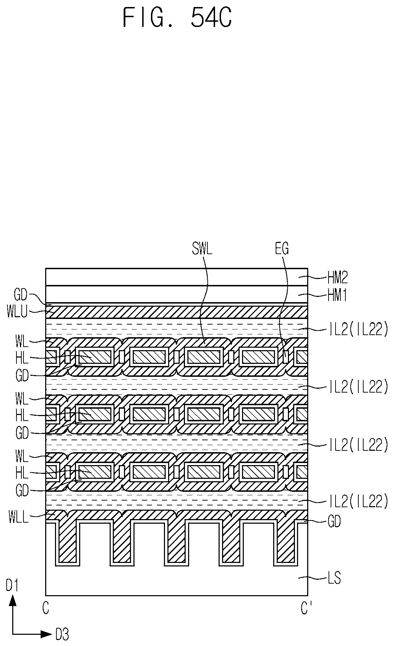

FIG. 54A is a schematic plan view illustrating a semiconductor device 400 in accordance with an embodiment of the present disclosure. FIG. 54B is a perspective view illustrating a first conductive line WL illustrated in FIG. 54A. FIG. 54C is a cross-sectional view of a stack of first conductive lines WL illustrated in FIG. 54A. The semiconductor device 400 illustrated in FIGS. 54A to 54C may be similar to the semiconductor device 100 illustrated in FIGS. 3A to 4E. The semiconductor devices 100 and 400 may have the same configurations except for the first conductive line WL.

Referring to FIGS. 3A, 3B, 4A, 4B, 4C, 4D, 4E, 54A, 54B and 54C, the semiconductor device 400 may include a lower structure LS and a memory cell array MCA. The memory cell array MCA may include a first sub-cell array MCA1 and a second sub-cell array MCA2. The first sub-cell array MCA1 may include a three-dimensional array of first memory cells MC1. The second sub-cell array MCA2 may include a three-dimensional array of second memory cells MC2. Each of the first memory cells MC1 may include a first vertical conductive line BLA, a switching element TR, and a data storage element CAP, and the switching element TR may include a first conductive line WL, a nano sheet dielectric layer GD, and a nano sheet HL. Each of the second memory cells MC2 may include a second vertical conductive line BLB, a switching element TR, and a data storage element CAP, and the switching element TR may include a first conductive line WL, a nano sheet dielectric layer GD, and a nano sheet HL. The nano sheets HL of the first and second memory cells MC1 and MC2 may each include a first doped region DR, a second doped region SR, and a channel CH. First contact nodes BLC may be formed on the first doped regions DR of the first and second memory cells MC1 and MC2. Second contact nodes SNC may be formed on the second doped regions SR of the first and second memory cells MC1 and MC2.

The first memory cells MC1 of the first sub-cell array MCA1 may share the first vertical conductive line BLA, and the second memory cells MC2 of the second sub-cell array MCA2 may share the second vertical conductive line BLB.

Each of first inter-cell dielectric layers IL1 may be disposed between the data storage elements CAP adjacent to each other in a third direction D3. Each of second inter-cell dielectric layers IL2 may be disposed between the first conductive lines WL stacked vertically in a first direction D1. Each of third inter-cell dielectric layers IL3 may be disposed between first electrodes SN of the data storage elements CAP stacked vertically in the first direction D1.

Each of the first memory cells MC1 and each of the second memory cells MC2 may further include a first spacer SP1 and a second spacer SP2.

Each of the second inter-cell dielectric layers IL2 may include a horizontal segment IL22 and a vertical segment IL21. Each of the horizontal segment IL22 and vertical segment IL21 of the second inter-cell dielectric layer IL2 may be a dielectric material having an integral structure. The horizontal segment IL22 and vertical segment IL21 of the second inter-cell dielectric layer IL2 may intersect each other. The horizontal segment IL22 may extend in the third direction D3, and the vertical segment IL21 may extend in the first direction D1. One edge of the horizontal segment IL22 may include convex patterns and concave patterns between the convex patterns. The vertical segment IL21 may partially fill the concave patterns and also extend in the first direction D1. Both sides of the vertical segment IL21 may directly contact the convex patterns. A spacer gap may be defined by the vertical segment IL21, the convex patterns and the concave patterns, and a portion of the second spacer SP2 may fill the spacer gap and also surround the convex patterns.

The horizontal segment IL22 of the second inter-cell dielectric layer IL2 may be disposed between the first conductive lines WL in the first direction D1, and the vertical segment IL21 of the second inter-cell dielectric layer IL2 may be disposed between first and second vertical conductive lines BLA and BLB in the third direction D3. The horizontal segment IL22 of the second inter-cell dielectric layer IL2 may be an isolation layer that isolates the first conductive lines WL adjacent to each other in the first direction D1, and the vertical segment IL21 of the second inter-cell dielectric layer IL2 may be an isolation layer that isolates the first and second vertical conductive lines BLA and BLB adjacent to each other in the third direction D3. As described, the second inter-cell dielectric layer IL2 may include the horizontal segment IL22 and the vertical segment IL21, and the first and second vertical conductive lines BLA and BLB may be formed to be self-aligned with the second spacer SP2.

Referring back to FIGS. 54A to 54C, each of the first conductive lines WL may include a surrounding electrode SWL, an extension electrode EWL, and an embedded void EG. The surrounding electrode SWL may surround the channel CH of the nano sheet HL. The extension electrode EWL may extend from the surrounding electrode SWL in a second direction D2 and may partially surround a curved sheet SHS on the nano sheet dielectric layer GD. The embedded void EG may be formed in the surrounding electrode SWL, e.g., centrally with the surrounding electrode SWL. The embedded void EG may be disposed between the channels CH at the same horizontal level as the channels..

In some embodiments, the extension electrode EWL may fully surround the curved sheet SHS on the nano sheet dielectric layer GD. The surrounding electrodes SWL may be merged in the third direction D3 and have a linear shape. The extension electrodes EWL may be spaced apart from each other in the third direction D3. A portion of the second spacer SP2 may be disposed between the extension electrodes EWL.

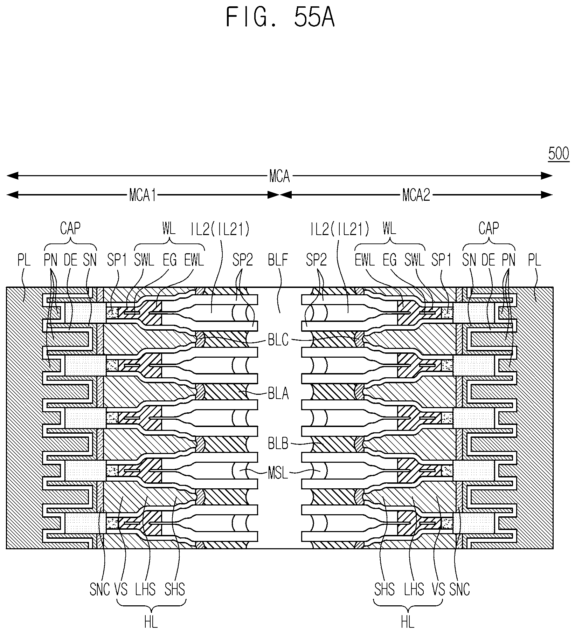

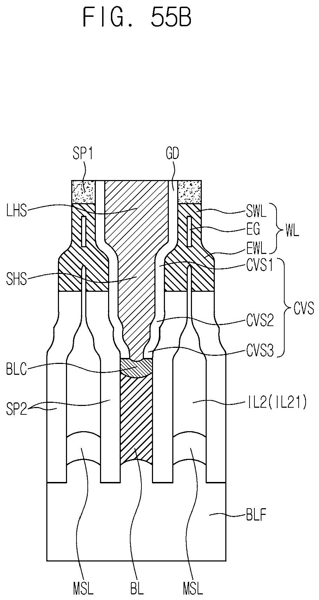

FIG. 55A is a schematic plan view illustrating a semiconductor device 500 in accordance with an embodiment of the present disclosure. FIG. 55B is a detailed cross-sectional view of a curved sheet SHS illustrated in FIG. 55A. The semiconductor device 500 illustrated in FIGS. 55A and 55B may be similar to the semiconductor device 400 illustrated in FIGS. 54A to 54C. The semiconductor devices 400 and 500 may have the same configurations except for the curved sheet SHS.

Referring to FIGS. 3A, 3B, 4A, 4B, 4C, 4D, 4E, 54A, 54B, 54C, 55A and 55B, the semiconductor device 500 may include a lower structure LS and a memory cell array MCA. The memory cell array MCA may include a first sub-cell array MCA1 and a second sub-cell array MCA2. The first sub-cell array MCA1 may include a three-dimensional array of first memory cells MC1. The second sub-cell array MCA2 may include a three-dimensional array of second memory cells MC2. Each of the first memory cells MC1 may include a first vertical conductive line BLA, a switching element TR, and a data storage element CAP, and the switching element TR may include a first conductive line WL, a nano sheet dielectric layer GD, and a nano sheet HL. Each of the second memory cells MC2 may include a second vertical conductive line BLB, a switching element TR, and a data storage element CAP, and the switching element TR may include a first conductive line WL, a nano sheet dielectric layer GD, and a nano sheet HL. The nano sheets HL of the first and second memory cells MC1 and MC2 may each include a first doped region DR, a second doped region SR, and a channel CH. First contact nodes BLC may be formed on the first doped regions DR of the first and second memory cells MC1 and MC2. Second contact nodes SNC may be formed on the second doped regions SR of the first and second memory cells MC1 and MC2.

The first memory cells MC1 of the first sub-cell array MCA1 may share the first vertical conductive line BLA, and the second memory cells MC2 of the second sub-cell array MCA2 may share the second vertical conductive line BLB.

Each of first inter-cell dielectric layers IL1 may be disposed between the data storage elements CAP adjacent to each other in a third direction D3. Each of second inter-cell dielectric layers IL2 may be disposed between the first conductive lines WL stacked vertically in a first direction D1. Each of third inter-cell dielectric layers IL3 may be disposed between first electrodes SN of the data storage elements CAP stacked vertically in the first direction D1.

Each of the first memory cells MC1 and each of the second memory cells MC2 may further include a first spacer SP1 and a second spacer SP2.

Each of the second inter-cell dielectric layers IL2 may include a horizontal segment IL22 and a vertical segment IL21. Each of the horizontal segment IL22 and vertical segment IL21 of the second inter-cell dielectric layer IL2 may be a dielectric material having an integral structure. The horizontal segment IL22 and vertical segment IL21 of the second inter-cell dielectric layer IL2 may intersect each other. The horizontal segment IL22 may extend in the third direction D3, and the vertical segment IL21 may extend in the first direction D1. One edge of the horizontal segment IL22 may include convex patterns and concave patterns between the convex patterns. The vertical segment IL21 may partially fill the concave patterns and also extend in the first direction D1. Both sides of the vertical segment IL21 may directly contact the convex patterns. A spacer gap may be defined by the vertical segment IL21, the convex patterns and the concave patterns, and a portion of the second spacer SP2 may fill the spacer gap and also surround the convex patterns.

The horizontal segment IL22 of the second inter-cell dielectric layer IL2 may be disposed between the first conductive lines WL in the first direction D1, and the vertical segment IL21 of the second inter-cell dielectric layer IL2 may be disposed between first and second vertical conductive lines BLA and BLB in the third direction D3. The horizontal segment IL22 of the second inter-cell dielectric layer IL2 may be an isolation layer that isolates the first conductive lines WL adjacent to each other in the first direction D1, and the vertical segment IL21 of the second inter-cell dielectric layer IL2 may be an isolation layer that isolates the first and second vertical conductive lines BLA and BLB adjacent to each other in the third direction D3. As described, the second inter-cell dielectric layer IL2 may include the horizontal segment IL22 and the vertical segment IL21, and the first and second vertical conductive lines BLA and BLB may be formed to be self-aligned with the second spacer SP2.

Referring back to FIGS. 54A to 54C, 55A and 55B, each of the first conductive lines WL may include a surrounding electrode SWL, an extension electrode EWL, and an embedded void EG. The surrounding electrode SWL may surround the channel CH of the nano sheet HL. The extension electrode EWL may extend from the surrounding electrode SWL in a second direction D2. The embedded void EG may be formed in the surrounding electrode SWL and be disposed between the channels CH at the same horizontal level. The extension electrode EWL may partially surround the curved sheet SHS on the nano sheet dielectric layer GD.

In some embodiments, the extension electrode EWL may fully surround the curved sheet SHS on the nano sheet dielectric layer GD. The surrounding electrodes SWL may be merged in the third direction D3 and have a linear shape. The extension electrodes EWL may be spaced apart from each other in the third direction D3. A portion of the second spacer SP2 may be disposed between the extension electrodes EWL.

Referring back to FIGS. 55A and 55B, each of the nano sheets HL may include the curved sheet SHS, a horizontal sheet LHS, and a tapered sheet VS. The curved sheet SHS may include a curved side surface CVS. The curved side surface CVS of the curved sheet SHS may include at least one curvature, i.e., a multi-curved profile CVS1, CVS2 and CVS3. The multi-curved profile may include a first curved profile CVS1, a second curved profile CVS2, and a third curved profile CVS3. The extension electrode EWL of the first conductive line WL may surround the first curved profile CVS1 of the curved sheet SHS.

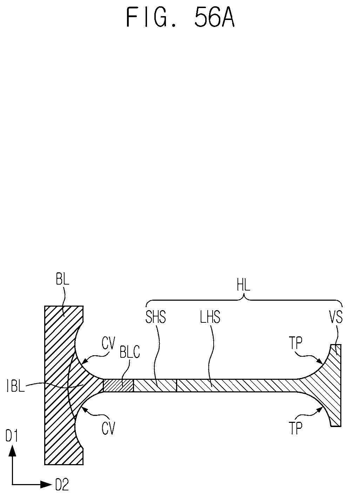

FIGS. 56A to 56C are various views illustrating a nano sheet HL in accordance with embodiments of the present disclosure.

Referring to FIG. 56A, the nano sheet HL may include a curved sheet SHS, a horizontal sheet LHS, and a tapered sheet VS. Upper and lower surfaces of the tapered sheet VS may each have a tapered profile TP. The curved sheet SHS may be coupled to a first contact node BLC, and a second conductive line BL may include an inner portion IBL coupled to the first contact node BLC. Upper and lower surfaces of the inner portion IBL may each have a curved profile CV. The upper curved profile CV for the upper surfaces and the lower curved profile CV for the lower surfaces may each have a downward curved slope that reduces a vertical length of the inner portion IBL in a first direction D1 toward the first contact node BLC.

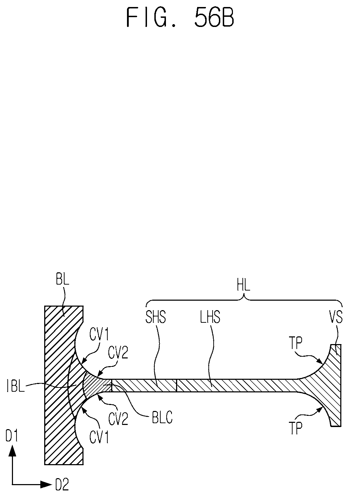

Referring to FIG. 56B, the nano sheet HL may include a curved sheet SHS, a horizontal sheet LHS, and a tapered sheet VS. Upper and lower surfaces of the tapered sheet VS may each have a tapered profile TP. The curved sheet SHS may be coupled to a first contact node BLC, and a second conductive line BL may include an inner portion IBL coupled to the first contact node BLC. Upper and lower surfaces of the inner portion IBL may each have a first curved profile CV1. The first curved profile CV1 may have a downward curved slope that reduces a vertical length of the inner portion IBL in a first direction D1 toward the first contact node BLC. Upper and lower surfaces of the first contact node BLC may each have a second curved profile CV2. The second curved profile CV2 may have a downward curved slope that reduces a vertical length of the first contact node BLC in the first direction D1 toward the curved sheet SHS. The first curved profile CV1 and the second curved profile CV2 may be continuous.

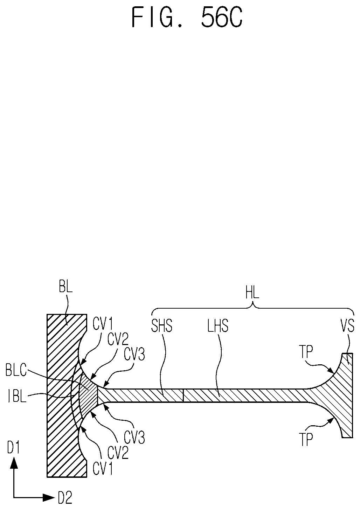

Referring to FIG. 56C, the nano sheet HL may include a curved sheet SHS, a horizontal sheet LHS, and a tapered sheet VS. Upper and lower surfaces of the tapered sheet VS may each have a tapered profile TP. The curved sheet SHS may be coupled to a first contact node BLC, and a second conductive line BL may include an inner portion IBL coupled to the first contact node BLC. Upper and lower surfaces of the inner portion IBL may each have a first curved profile CV1. The first curved profile CV1 may have a downward curved slope that reduces a vertical length of the inner portion IBL in a first direction D1 toward the first contact node BLC. Upper and lower surfaces of the first contact node BLC may each have a second curved profile CV2. The second curved profile CV2 may have a downward curved slope that reduces a vertical length of the first contact node BLC in the first direction D1 toward the curved sheet SHS. Upper and lower surfaces of the curved sheet SHS may each have a third curved profile CV3. The curved profile CV3 may have an upward curved slope that increases a vertical length of the curved sheet SHS in the first direction D1 toward the first contact node BLC. The first curved profile CV1, the second curved profile CV2 and the third curved profile CV3 may be continuous. Curvatures of the first curved profile CV1, the second curved profile CV2 and the third curved profile CV3 may be the same as or different from one another. The first curved profile CV1, the second curved profile CV2 and the third curved profile CV3 may be referred to as "tapered profiles".

According to various embodiments of the present disclosure, vertical conductive lines may be formed in a self-aligned manner, which makes it possible to increase a stack number (or quantity) of memory cells. Accordingly, it is possible to perform a high-integration process for three-dimensional memory cells with a small cell pitch.

According to various embodiments of the present disclosure, an inter-cell horizontal dielectric layer may be prevented from bending because the inter-cell horizontal dielectric layer has a frame structure in which a horizontal segment and a vertical segment intersects and are merged.

According to various embodiments of the present disclosure, nano sheets may be prevented from bending by a sacrificial sheet layer during a subsequent process, which makes it possible to improve reliability of a semiconductor device.

While the embodiments of the present disclosure have been illustrated and described with respect to specific embodiments and drawings, the disclosed embodiments are not intended to be restrictive. Further, it is noted that the embodiments may be achieved in various ways through substitution, change, and modification, as those skilled in the art will recognize in light of the present disclosure, without departing from the spirit and/or scope of the present disclosure and the following claims. Furthermore, the embodiments may be combined to form additional embodiments.

## Claims

1. A semiconductor device comprising:
a nano sheet including a first sheet region, a third sheet region, and a second sheet region extending horizontally between the first and third sheet regions, the first region having a curved profile;
a first conductive line surrounding the second sheet region of the nano sheet;
a second conductive line coupled to the first sheet region of the nano sheet; and
a data storage element coupled to the third sheet region of the nano sheet.

2. The semiconductor device of claim 1, wherein the first sheet region, the second sheet region and the third sheet region are continuous in a first horizontal direction, the first conductive line extends in a second horizontal direction intersecting the first horizontal direction, and the second conductive line extends in a vertical direction intersecting the first and second horizontal directions.

3. The semiconductor device of claim 2, wherein the first sheet region having the curved profile includes:
upper and lower surfaces facing each other in the vertical direction and each extending in the first horizontal direction;
a narrow side surface disposed between the upper surface and the lower surface and coupled to the second conductive line; and
a pair of curved side surfaces extending from the upper surface, the lower surface and the narrow side surface and facing each other in the second horizontal direction.

4. The semiconductor device of claim 3, wherein the curved side surfaces each have an upward curved slope that increases a horizontal length of the first sheet region in the second horizontal direction from the narrow side surface toward the second sheet region.

5. The semiconductor device of claim 3, wherein each of the upper and lower surfaces of the first sheet region has a flat surface.

6. The semiconductor device of claim 3, wherein the curved side surfaces have a multi-curved profile.

7. The semiconductor device of claim 2, wherein each of upper and lower surfaces of the third sheet region has a tapered profile with a vertical thickness of the third sheet region measured in the vertical direction that increases in a direction from the second sheet region toward the data storage element.

8. The semiconductor device of claim 1, wherein the second conductive line includes an inner portion coupled to the first sheet region, and upper and lower surfaces of the inner portion each having a curved profile.

9. The semiconductor device of claim 1, wherein the first conductive line includes:
a surrounding electrode surrounding the second sheet region of the nano sheet;
an embedded void disposed outside side surfaces of the second sheet region and positioned inside the surrounding electrode; and
an extension electrode extending from the surrounding electrode to surround the first sheet region.

10. The semiconductor device of claim 1, wherein the first conductive line includes a word line, the second conductive line includes a bit line, and the data storage element includes a capacitor.

11. The semiconductor device of claim 1, wherein the first conductive line includes an extension electrode extending horizontally to surround a portion of the first sheet region of the nano sheet or an entire surface of the first sheet region.

12. The semiconductor device of claim 1, further comprising:
an inter-cell horizontal dielectric layer formed on each of upper and lower surfaces of the first conductive line;
a first spacer surrounding a portion of the third sheet region; and
a second spacer surrounding the first sheet region.

13. The semiconductor device of claim 12, wherein the inter-cell horizontal dielectric layer includes:
horizontal segments contacting the upper and lower surfaces of the first conductive line; and
vertical segments extending from the horizontal segments and extending vertically in an outer wall of the second conductive line.

14. The semiconductor device of claim 13, wherein horizontal segments and vertical segments of the inter-cell horizontal dielectric layer have an integral structure made of a dielectric material.

15. The semiconductor device of claim 12, wherein the inter-cell horizontal dielectric layer includes a low-k material, silicon oxide, silicon carbon oxide, silicon nitride, an air gap, or a combination thereof.
